# EUROPEAN PATENT APPLICATION

(11) **EP 4 840 866 A1**
(43) Date of publication of application: **18.11.2026**
(21) Application number: 26158150.8
(22) Date of filing: 12.02.2026
(51) Int. Cl.: C07F 5/02, C07F 7/08, C09K 11/06, H10K 85/00

(54) **HETEROCYCLIC COMPOUND, ORGANIC LIGHT-EMITTING DEVICE INCLUDING THE HETEROCYCLIC COMPOUND, AND ELECTRONIC APPARATUS**

(30) Priority: 16.05.2025 KR 20250064044; 03.02.2026 KR 20260021948
(71) Applicant: Samsung Display Co., Ltd., Yongin-si, Gyeonggi-do 17113 (KR)
(72) Inventor: LEE, Minhan, 16678 Suwon-si (KR); KWON, Ohyun, 16678 Suwon-si (KR); PARK, Sangho, 16678 Suwon-si (KR); SIM, Myungsun, 16678 Suwon-si (KR); LEE, Sunghun, 16678 Suwon-si (KR); LEE, Hongsoo, 16678 Suwon-si (KR); JEON, Soonok, 16678 Suwon-si (KR)
(74) Representative: Elkington and Fife LLP

(57) **Abstract**

Provided are a heterocyclic compound represented by Formula 1, an organic light-emitting device including the same, and an electronic apparatus: 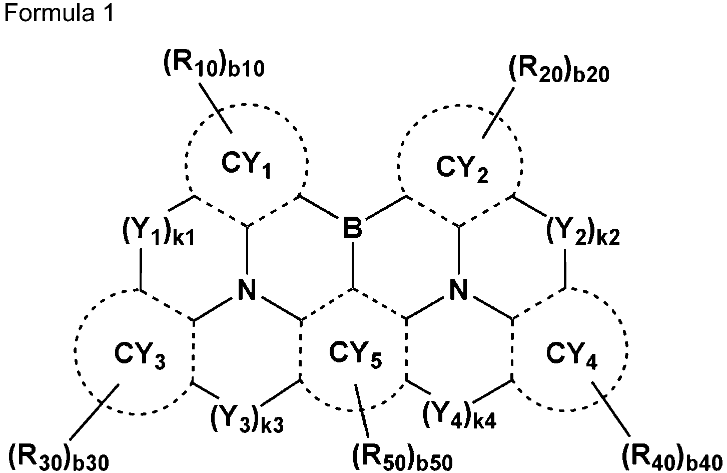 wherein the substituents in Formula 1 are as provided herein.

## Description

### FIELD OF THE INVENTION

The disclosure relates to a heterocyclic compound, an organic light-emitting device including the heterocyclic compound, and an electronic apparatus.

### BACKGROUND OF THE INVENTION

Organic light-emitting devices (OLEDs) are self-emissive devices that have excellent characteristics in terms of viewing angles, response time, brightness, driving voltage, response speed, and the like. In addition, OLEDs can produce full-color images.

For example, an organic light-emitting device includes an anode, a cathode, and an organic layer that is arranged between the anode and the cathode and includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. When the excitons transition from an excited state to a ground state, light is emitted.

### SUMMARY OF THE INVENTION

Provided are a heterocyclic compound, an organic light-emitting device including the heterocyclic compound, and an electronic apparatus.

Additional aspects will be set forth in part in the detailed description that follows and, in part, will be apparent from the detailed description, or may be learned by practice of the presented exemplary embodiments.

According to an aspect, a heterocyclic compound represented by Formula 1 is provided: 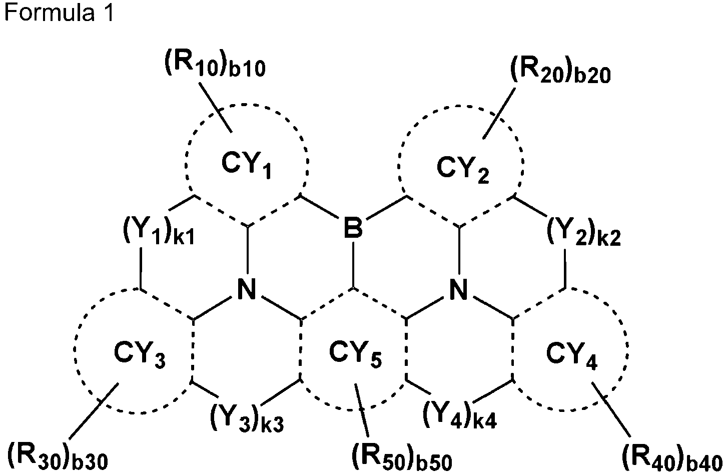
wherein, in Formula 1,
   Y₁ is a single bond, *-O-*', *-S-*', *-Se-*', *-N(Z₁)-*', *-C(Z₁)(Z₂)-*', *-C(Z₁)=C(Z₂)-*', *-Si(Z₁)(Z₂)-*', *-Ge(Z₁)(Z₂)-*', or a group represented by Formula 2,
   Y₂ is *-O-*', *-S-*', *-Se-*', *-N(Z₃)-*', *-C(Z₃)(Z₄)-*', *-C(Z₃)=C(Z₄)-*', *-Si(Z₃)(Z₄)-*', *-Ge(Z₃)(Z₄)-*', or a group represented by Formula 2,
   Y₃ is a single bond, *-O-*', *-S-*', *-Se-*', *-N(Z₅)-*', *-C(Z₅)(Z₆)-*', *-C(Z₅)=C(Z₆)-*', *-Si(Z₅)(Z₆)-*', *-Ge(Z₅)(Z₆)-*', or a group represented by Formula 2, and
   Y₄ is a single bond, *-O-*', *-S-*', *-Se-*', *-N(Z₇)-*', *-C(Z₇)(Z₈)-*', *-C(Z₇)=C(Z₈)-*', *-Si(Z₇)(Z₈)-*', *-Ge(Z₇)(Z₈)-, or a group represented by Formula 2, 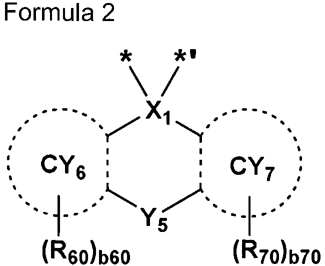
wherein, in Formula 2,
   X₁ is C, Si, or Ge,
   Y₅ is a single bond, *-O-*', *-S-*', *-Se-*', *-N(R₁)-*', *-C(R₁)(R₂)-*', *-C(R₁)=C(R₂)-*', *-Si(R₁)(R₂)-*', *-Ge(R₁)(R₂)-*', *-S(=O)₂-*', or *-C(=O)-*', wherein, in Formulae 1 and 2,
   k1 to k4 are each independently 1, 2, 3, 4, or 5,
   ring CY₁ to ring CY₇ are each independently a C₅-C₃₀ carbocyclic group or a C₁-C₃₀ heterocyclic group,
   Z₁ to Z₃, R₁, R₂, R₁₀, R₂₀, R₃₀, R₄₀, R₅₀, R₆₀ and R₇₀ are each independently hydrogen, deuterium, -F, -Cl, -Br, -I, -SF₅, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic heterocondensed polycyclic group, -N(Q₁)(Q₂), -Si(Q₁)(Q₂)(Q₃), - Ge(Q₁)(Q₂)(Q₃), -C(=O)(Q₁), -S(=O)(Q₁), -S(=O)₂(Q₁), -B(Q₁)(Q₂), -P(Q₁)(Q₂), - P(=O)(Q₁)(Q₂), or -P(=S)(Q₁)(Q₂),
   b10, b20, b30, b40, b50, b60, and b70 are each independently 1, 2, 3, 4, 5, 6, 7, 8, 9, 10, 11, 12, 13, or 14,
   two or more of a plurality of R₁₀ are optionally bonded to each other to form a substituted or unsubstituted C₅-C₃₀ carbocyclic group or a substituted or unsubstituted C₁-C₃₀ heterocyclic group,
   two or more of a plurality of R₂₀ are optionally bonded to each other to form a substituted or unsubstituted C₅-C₃₀ carbocyclic group or a substituted or unsubstituted C₁-C₃₀ heterocyclic group,
   two or more of a plurality of R₃₀ are optionally bonded to each other to form a substituted or unsubstituted C₅-C₃₀ carbocyclic group or a substituted or unsubstituted C₁-C₃₀ heterocyclic group,
   two or more of a plurality of R₄₀ are optionally bonded to each other to form a substituted or unsubstituted C₅-C₃₀ carbocyclic group or a substituted or unsubstituted C₁-C₃₀ heterocyclic group,
   two or more of a plurality of R₅₀ are optionally bonded to each other to form a substituted or unsubstituted C₅-C₃₀ carbocyclic group or a substituted or unsubstituted C₁-C₃₀ heterocyclic group,
   two or more of a plurality of R₆₀ are optionally bonded to each other to form a substituted or unsubstituted C₅-C₃₀ carbocyclic group or a substituted or unsubstituted C₁-C₃₀ heterocyclic group,
   two or more of a plurality of R₇₀ are optionally bonded to each other to form a substituted or unsubstituted C₅-C₃₀ carbocyclic group or a substituted or unsubstituted C₁-C₃₀ heterocyclic group,
   two or more of adjacent Z₁ to Z₈, R₁, R₂, R₁₀, R₂₀, R₃₀, R₄₀, R₅₀, R₆₀, and R₇₀ are optionally bonded to each other to form a substituted or unsubstituted C₅-C₃₀ carbocyclic group or a substituted or unsubstituted C₁-C₃₀ heterocyclic group,
   * and *' each indicate a binding site to a neighboring atom,
   at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, the substituted monovalent non-aromatic heterocondensed polycyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, and the substituted divalent non-aromatic heterocondensed polycyclic group is each independently:
      deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
      a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₁)(Q₁₂)(Q₁₃), -Ge(Q₁₁)(Q₁₂)(Q₁₃), -C(=O)(Q₁₁), - S(=O)(Q₁₁), -S(=O)₂(Q₁₁), -B(Q₁₁)(Q₁₂), -P(Q₁₁)(Q₁₂), -P(=O)(Q₁₁)(Q₁₂), - P(=S)(Q₁₁)(Q₁₂), or a combination thereof;
      a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₁)(Q₂₂)(Q₂₃), -Ge(Q₂₁)(Q₂₂)(Q₂₃), -C(=O)(Q₂₁), - S(=O)(Q₂₁), -S(=O)₂(Q₂₁), -B(Q₂₁)(Q₂₂), -P(Q₂₁)(Q₂₂), -P(=O)(Q₂₁)(Q₂₂), - P(=S)(Q₂₁)(Q₂₂), or a combination thereof;
      -N(Q₃₁)(Q₃₂), -Si(Q₃₁)(Q₃₂)(Q₃₃), -Ge(Q₃₁)(Q₃₂)(Q₃₃), -C(=O)(Q₃₁), - S(=O)(Q₃₁), -S(=O)₂(Q₃₁), -B(Q₃₁)(Q₃₂), -P(Q₃₁)(Q₃₂), -P(=O)(Q₃₁)(Q₃₂), or - P(=S)(Q₃₁)(Q₃₂); or
      a combination thereof, and
      Q₁ to Q₃, Q₁₁ to Q₁₃, Q₂₁ to Q₂₃, and Q₃₁ to Q₃₃ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, or
      a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, - F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof.

According to another aspect, an organic light-emitting device includes at least one of the heterocyclic compounds represented by Formula 1.

According to another aspect, an electronic apparatus includes the organic light-emitting device.

### BRIEF DESCRIPTION OF THE DRAWINGS

These and/or other aspects will become apparent and more readily appreciated from the following description of the embodiments, taken in conjunction with
FIG. 1 is a cross-sectional view schematically illustrating an organic light-emitting device according to one or more embodiments; and
FIGS. 2 to 7 are each a schematic diagram showing energy transfer of an organic light-emitting device according to one or more embodiments.

### DETAILED DESCRIPTION OF THE EMBODIMENTS

Reference will now be made in further detail to exemplary embodiments, examples of which are illustrated in the accompanying drawings, wherein like reference numerals refer to like elements throughout. In this regard, the embodiments may have different forms and should not be construed as being limited to the detailed descriptions set forth herein. Accordingly, the embodiments are merely described below, and by referring to the figures, to explain certain aspects and features. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

A heterocyclic compound according to an aspect is represented by Formula 1: 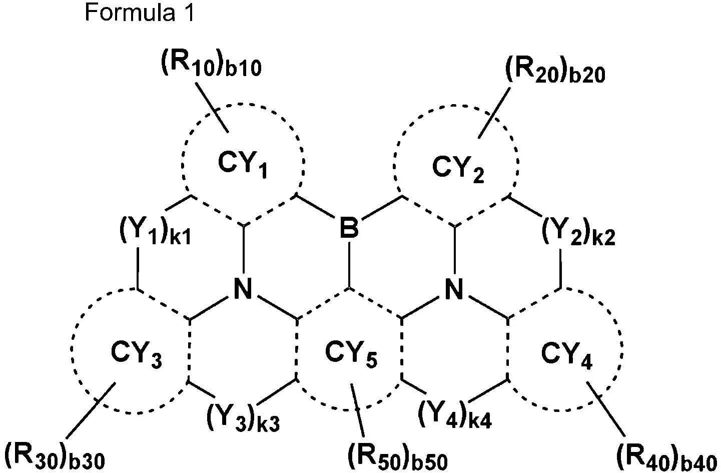 Y₁ in Formula 1 is a single bond, *-O-*', *-S-*', *-Se-*', *-N(Z₁)-*', *-C(Z₁)(Z₂)-*', *-C(Z₁)=C(Z₂)-*', *-Si(Z₁)(Z₂)-*', *-Ge(Z₁)(Z₂)-*', or a group represented by Formula 2.

According to one or more embodiments, Y₁ may be a single bond, *-O-*', *-S-*', *-C(Z₁)(Z₂)-*', or a group represented by Formula 2.

Y₂ in Formula 1 is *-O-*', *-S-*', *-Se-*', *-N(Z₃)-*', *-C(Z₃)(Z₄)-*', *-C(Z₃)=C(Z₄)-*', *-Si(Z₃)(Z₄)-*', *-Ge(Z₃)(Z₄)-*', or a group represented by Formula 2.

According to one or more embodiments, Y₂ may be *-O-*', *-S-*', *-Se-*', *-N(Z₃)-*', *-C(Z₃)(Z₄)-*', *-C(Z₃)=C(Z₄)-*', *-Si(Z₃)(Z₄)-*', *-Ge(Z₃)(Z₄)-*', or a group represented by Formula 2.

Y₃ in Formula 1 is a single bond, *-O-*', *-S-*', *-Se-*', *-N(Z₅)-*', *-C(Z₅)(Z₆)-*', *-C(Z₅)=C(Z₆)-*', *-Si(Z₅)(Z₆)-*', *-Ge(Z₅)(Z₆)-*', or a group represented by Formula 2.

According to one or more embodiments, Y₃ may be a single bond, *-C(Z₅)(Z₆)-*', *-Si(Z₅)(Z₆)-*', or a group represented by Formula 2.

Y₄ in Formula 1 is a single bond, *-O-*', *-S-*', *-Se-*', *-N(Z₇)-*', *-C(Z₇)(Z₈)-*', *-C(Z₇)=C(Z₈)-*', *-Si(Z₇)(Z₈)-*', *-Ge(Z₇)(Z₈)-, or a group represented by Formula 2.

According to one or more embodiments, Y₄ may be a single bond, *-C(Z₇)(Z₈)-*', *-Si(Z₇)(Z₈)-*', or a group represented by Formula 2.

According to one or more embodiments, Y₁ and Y₂ may be different from each other.

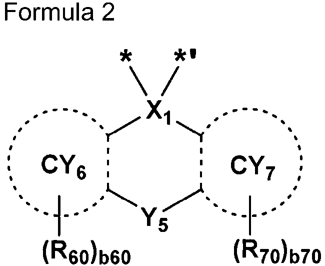

X₁ in Formula 2 is C, Si, or Ge.

Y₅ in Formula 2 is a single bond, *-O-*', *-S-*', *-Se-*', *-N(R₁)-*', *-C(R₁)(R₂)-*', *-C(R₁)=C(R₂)-*', *-Si(R₁)(R₂)-*', *-Ge(R₁)(R₂)-*', *-S(=O)₂-*', or *-C(=O)-*'.

According to one or more embodiments, Y₅ may be a single bond, *-O-*', *-S-*', *-Se-*', *-N(R₁)-*', *-C(R₁)(R₂)-*', *-C(R₁)=C(R₂)-*', *-Si(R₁)(R₂)-*', or *-Ge(R₁)(R₂)-*'. k1 to k4 in Formula 1 are each independently 1, 2, 3, 4, or 5.

According to one or more embodiments, k1 to k4 may each independently be 1 or 2.

Ring CY₁ to ring CY₇ in Formulae 1 and 2 are each independently a C₅-C₃₀ carbocyclic group or a C₁-C₃₀ heterocyclic group.

According to one or more embodiments, ring CY₁ to ring CY₇ may each independently be i) a first ring, ii) a second ring, iii) a condensed ring group in which two or more first rings are condensed with each other, iv) a condensed ring group in which two or more second rings are condensed with each other, or v) a condensed ring group in which one or more first rings are condensed with one or more second rings,
the first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and
the second ring may be an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclohexane group, a cyclohexene group, a benzene group, a pyridine group, a pyrimidine group, a pyrazine group, a pyridazine group, or a triazine group.

According to one or more embodiments, ring CY₁ to ring CY₇ may each independently be a C₆-C₃₀ aromatic carbocyclic group or a C₁-C₃₀ aromatic heterocyclic group.

According to one or more embodiments, ring CY₁ to ring CY₇ may each independently be a benzene group, a naphthalene group, an anthracene group, a phenanthrene group, a triphenylene group, a pyrene group, a chrysene group, a 1,2,3,4-tetrahydronaphthalene group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a fluorene group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a 5,6,7,8-tetrahydroisoquinoline group, a 5,6,7,8-tetrahydroquinoline group, an adamantane group, a norbornane group, or a norbornene group.

According to one or more embodiments, ring CY₁ to ring CY₇ may each independently be a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, a dibenzosilole group, a dibenzoborole group, a dibenzophosphole group, a dibenzoselenophene group, a dibenzogermole group, a dibenzothiophene 5-oxide group, a 9H-fluoren-9-one group, or a dibenzothiophene 5,5-dioxide group.

According to one or more embodiments, ring CY₁ to ring CY₅ may each independently be a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, or a dibenzosilole group.

According to one or more embodiments, ring CY₆ and ring CY₇ may each independently be a benzene group, a naphthalene group, a phenanthrene group, a pyridine group, a pyrimidine group, a quinoline group, an isoquinoline group, a phthalazine group, a naphthyridine group, a quinoxaline group, or a quinazoline group.

According to one or more embodiments, the group represented by Formula 2 may be a group represented by any one of Formulae 2A to 2C: 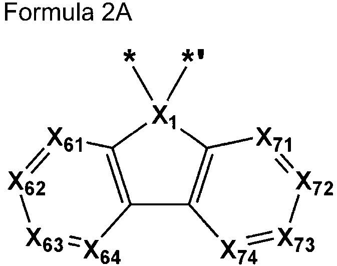 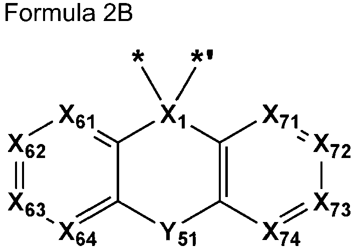 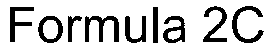 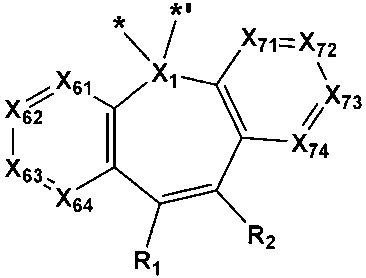 , wherein, in Formulae 2A to 2C,
a description of X₁, R₁, and R₂ is as provided herein,
Y₅₁ may be *-O-*', *-S-*', *-Se-*', *-N(R₁)-*', *-C(R₁)(R₂)-*', *-Si(R₁)(R₂)-*', *-Ge(R₁)(R₂)-*', *-S(=O)₂-*', or *-C(=O)-*',
X₆₁ may be C(R₆₁) or N, X₆₂ may be C(R₆₂) or N, X₆₃ may be C(R₆₃) or N, X₆₄ may be C(R₆₄) or N,
X₇₁ may be C(R₇₁) or N, X₇₂ may be C(R₇₂) or N, X₇₃ may be C(R₇₃) or N, X₇₄ may be C(R₇₄) or N,
descriptions for R₆₁ to R₆₄ are each independently as provided in connection with R₆₀,
descriptions for R₇₁ to R₇₄ are each independently as provided in connection with R₇₀, and
* indicates a binding site to a neighboring atom.

Z₁ to Z₃, R₁, R₂, R₁₀, R₂₀, R₃₀, R₄₀, R₅₀, R₆₀ and R₇₀ in Formulae 1 and 2 are each independently hydrogen, deuterium, -F, -Cl, -Br, -I, -SF₅, a hydroxyl group, a cyano group, a nitro group, an amino group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic heterocondensed polycyclic group, -N(Q₁)(Q₂), -Si(Q₁)(Q₂)(Q₃), -Ge(Q₁)(Q₂)(Q₃), -C(=O)(Q₁), -S(=O)(Q₁), - S(=O)₂(Q₁), -B(Q₁)(Q₂), -P(Q₁)(Q₂), -P(=O)(Q₁)(Q₂), or -P(=S)(Q₁)(Q₂).

According to one or more embodiments, Z₁ to Z₈, R₁, R₂, R₁₀, R₂₀, R₃₀, R₄₀, R₅₀, R₆₀, and R₇₀ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -SF₅, -CD₃, -CD₂H, -CDH₂, - CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (norbornanyl group), a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or a combination thereof;
a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorine-containing C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Si(Q₁)(Q₂)(Q₃), -Ge(Q₁)(Q₂)(Q₃), -C(=O)(Q₁), -S(=O)(Q₁), -S(=O)₂(Q₁), -B(Q₁)(Q₂), -P(Q₁)(Q₂), -P(=O)(Q₁)(Q₂), or -P(=S)(Q₁)(Q₂).

According to one or more embodiments, Z₁ to Z₃, R₁, R₂, R₁₀, R₂₀, R₃₀, R₄₀, R₅₀, R₆₀, and R₇₀ may each independently be:
hydrogen, deuterium, -F, -Cl, -Br, -I, -SF₅, -CD₃, -CD₂H, -CDH₂, -CF₃, - CF₂H, -CFH₂, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
   a group represented by any one of Formulae 9-1 to 9-61, 9-201 to 9-244, 10-1 to 10-154, or 10-201 to 10-350; or
-Si(Q₁)(Q₂)(Q₃) or -Ge(Q₁)(Q₂)(Q₃):

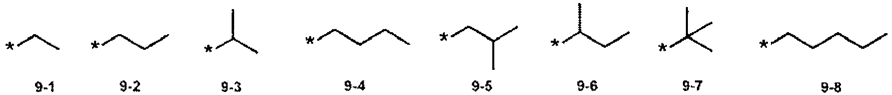

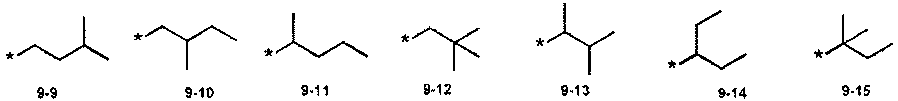

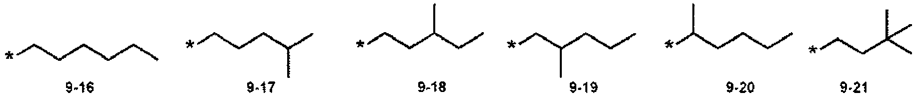

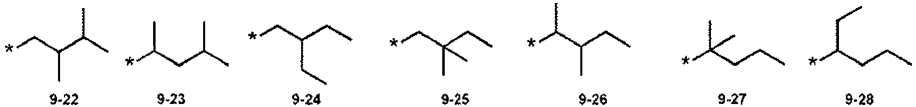

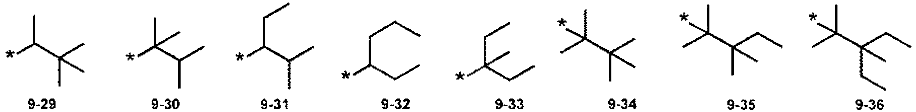

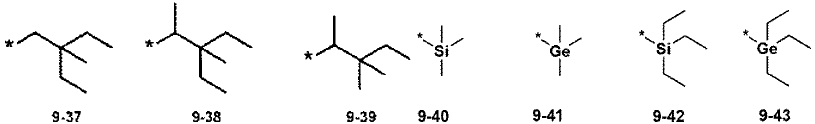

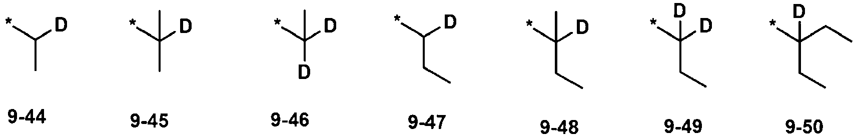

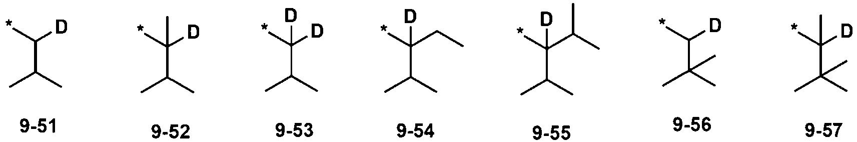

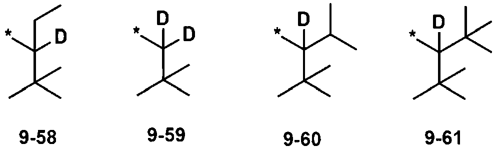

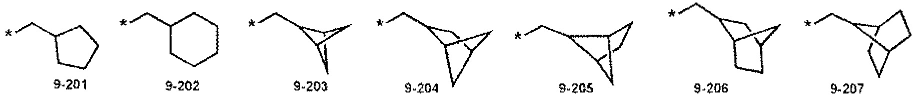

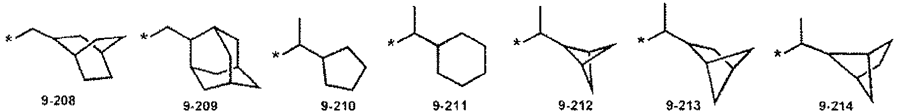

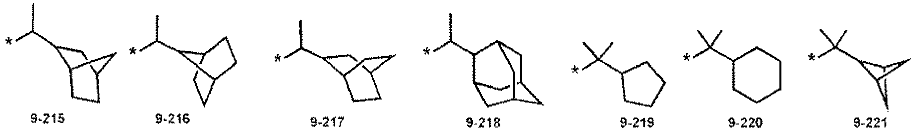

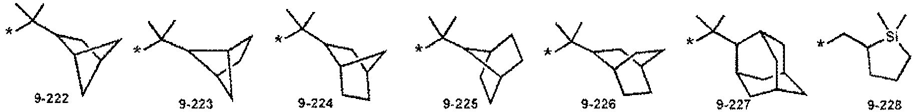

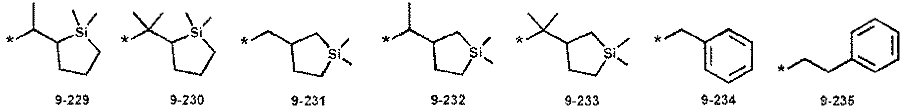

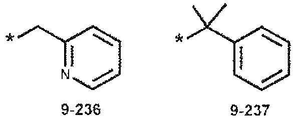

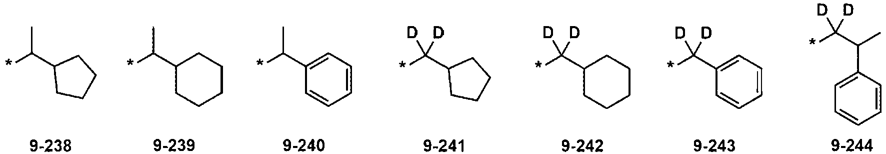

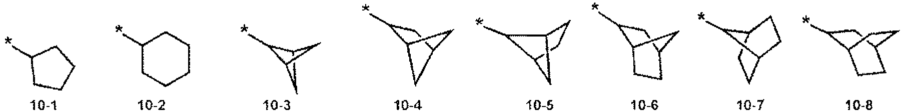

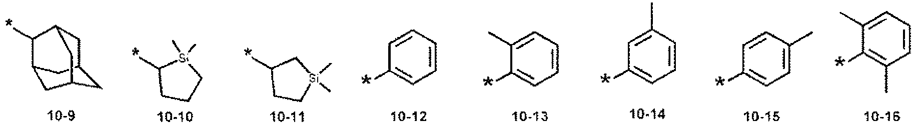

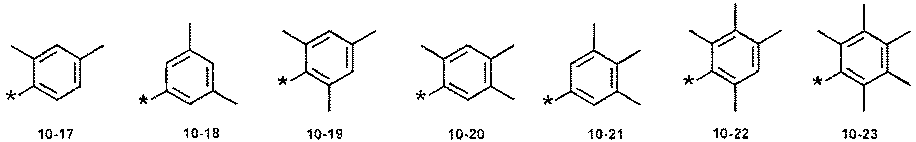

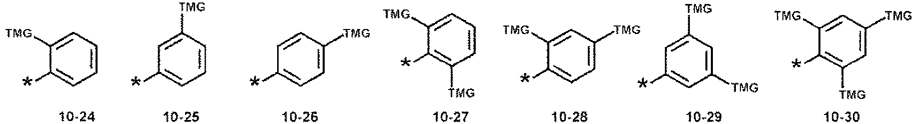

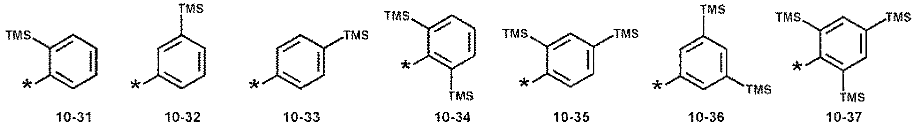

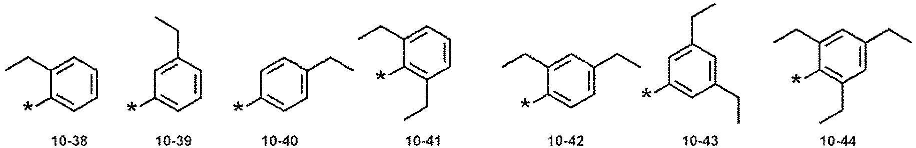

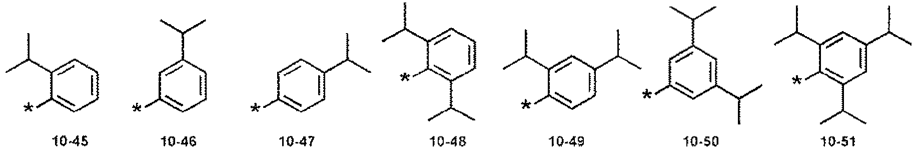

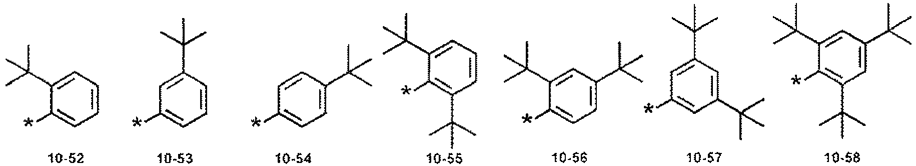

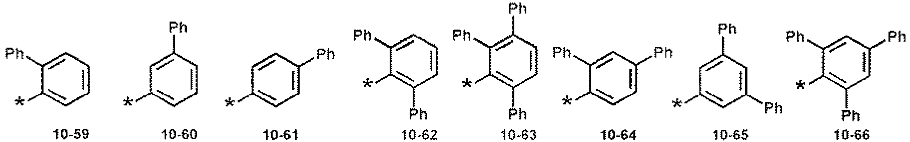

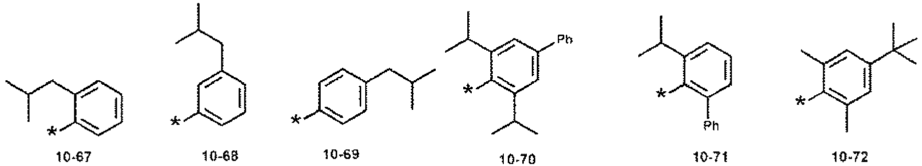

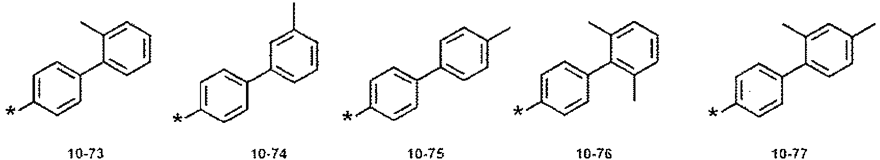

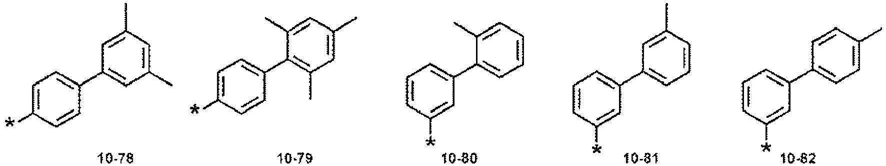

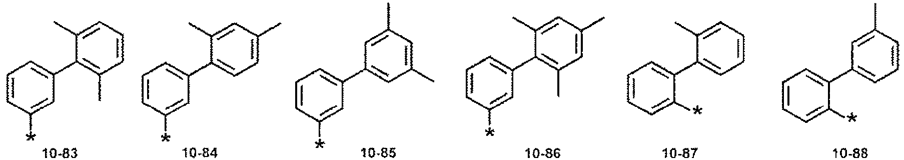

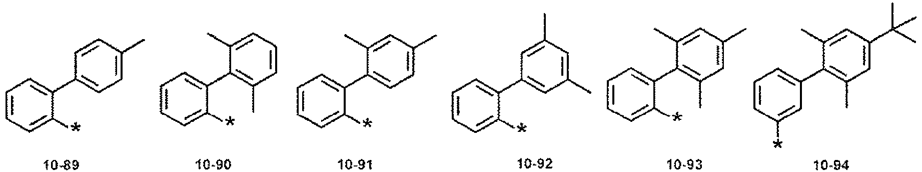

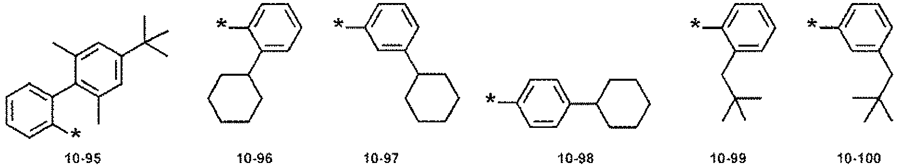

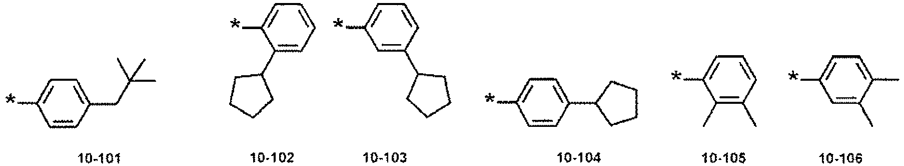

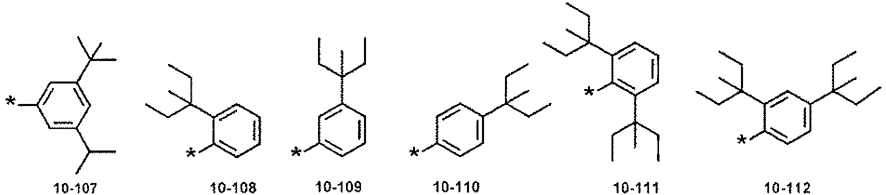

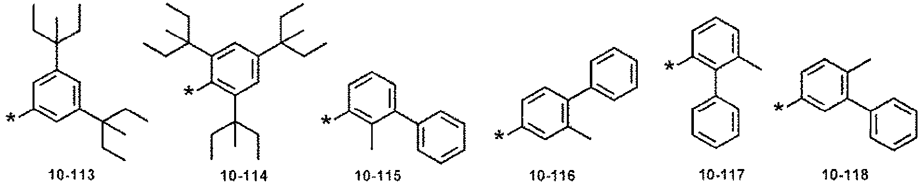

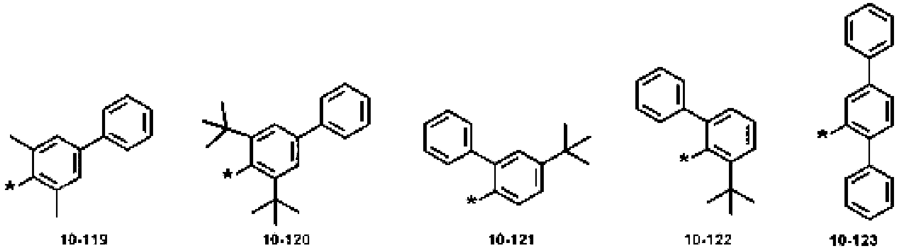

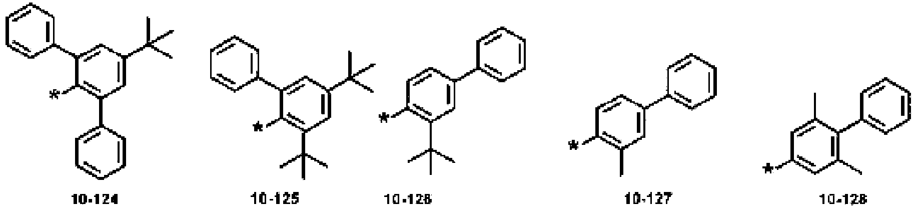

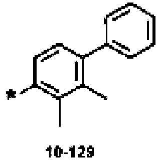

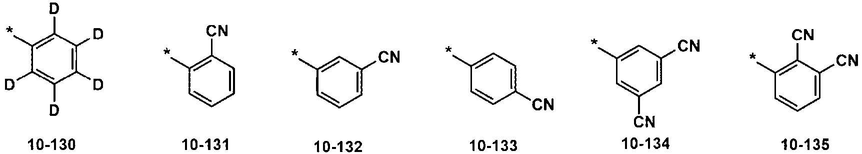

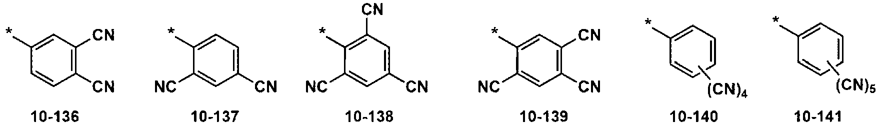

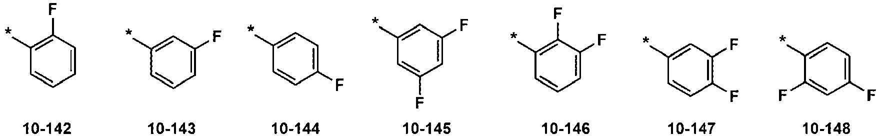

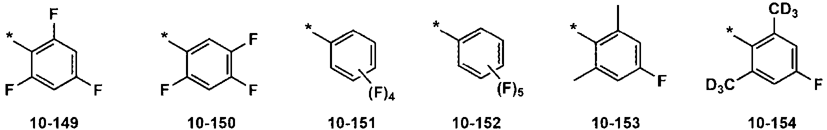

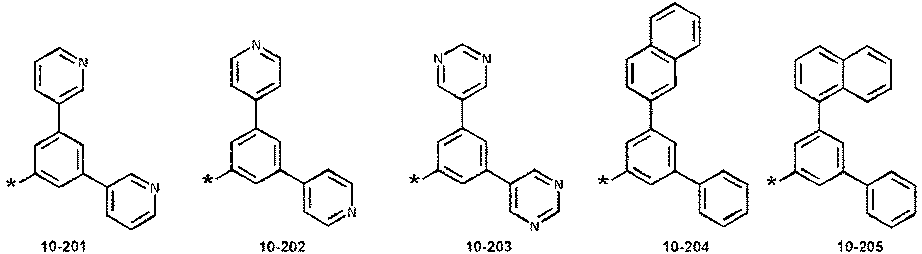

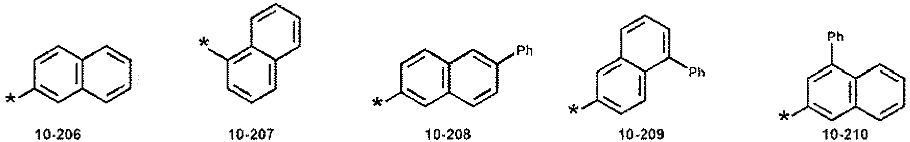

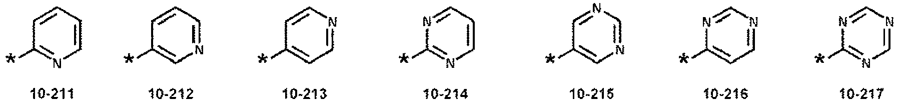

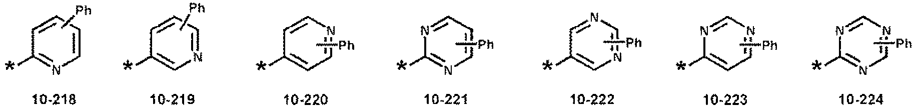

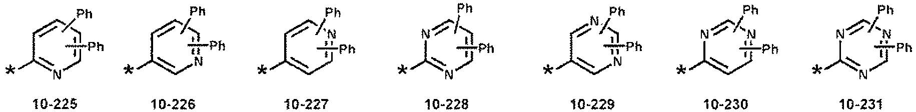

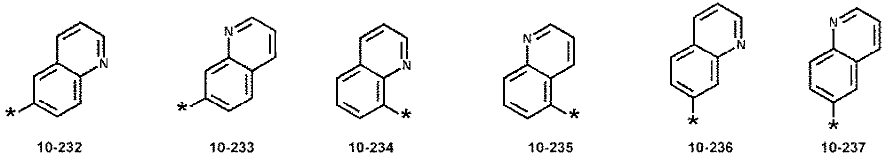

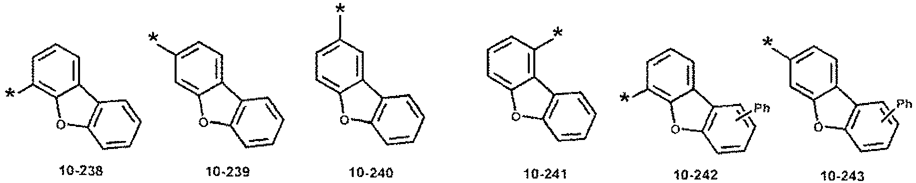

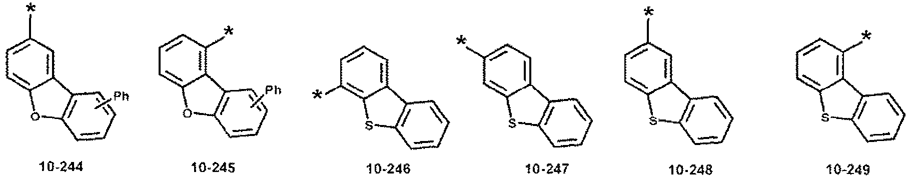

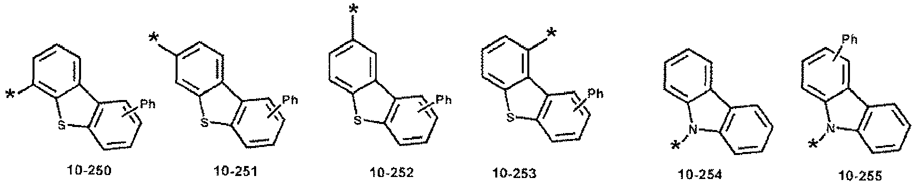

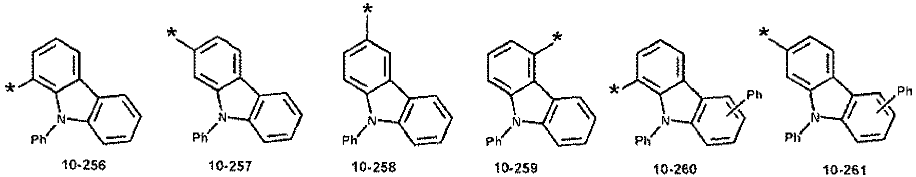

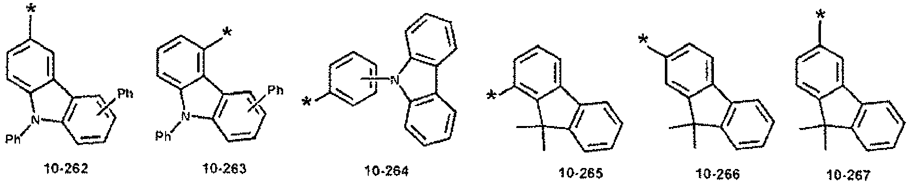

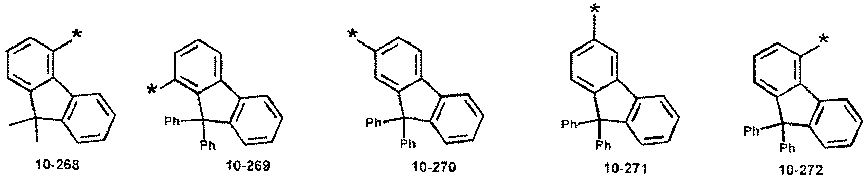

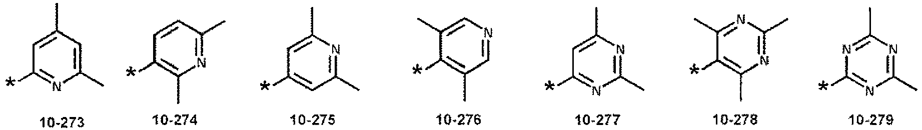

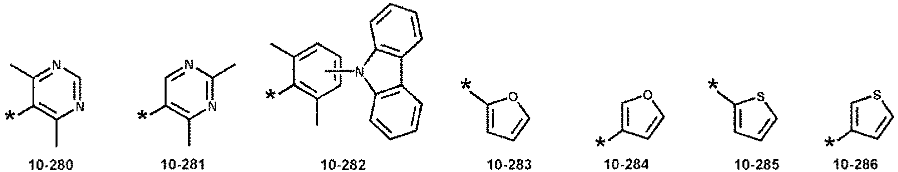

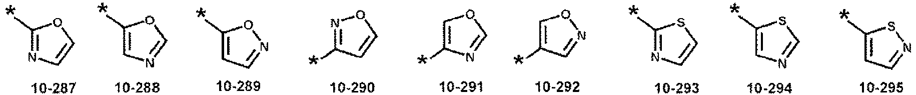

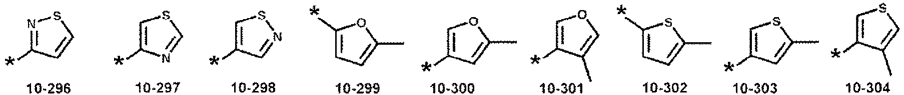

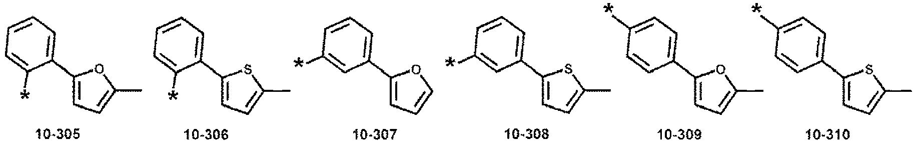

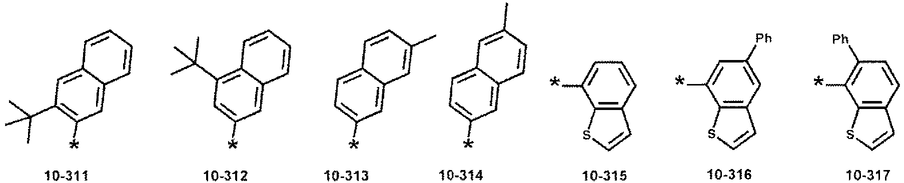

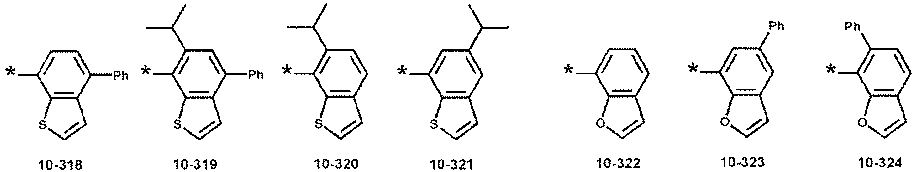

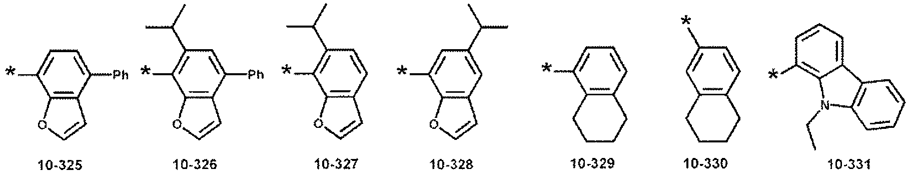

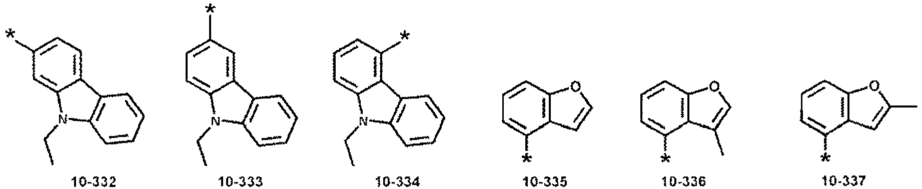

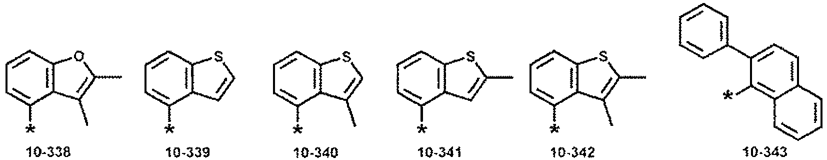

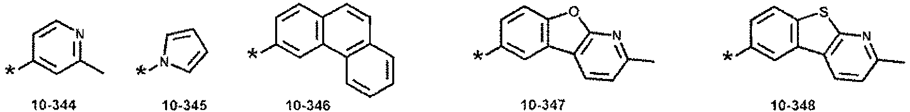

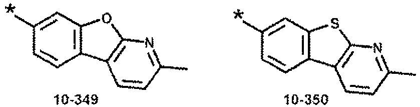

In Formulae 9-1 to 9-61, 9-201 to 9-244, 10-1 to 10-154, and 10-201 to 10-350, * represents a binding site to an adjacent atom, "Ph" represents a phenyl group, "TMS" represents a trimethylsilyl group, and "TMG" represents a trimethylgermyl group.

According to one or more embodiments, Z₁ to Z₈, R₁, R₂, R₁₀, R₂₀, R₃₀, R₄₀, R₅₀, R₆₀, and R₇₀ may each independently be:
hydrogen, deuterium, -F, -Cl, -Br, -I, -SF₅, -CD₃, -CD₂H, -CDH₂, -CF₃, - CF₂H, -CFH₂, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a group represented by one of Formulae 9-1 to 9-61, 9-201 to 9-244, 10-1 to 10-154, or 10-201 to 10-350; or
-Si(Q₁)(Q₂)(Q₃) or -Ge(Q₁)(Q₂)(Q₃).

According to one or more embodiments, at least one of Y₁ to Y₄ may be a group represented by Formula 2, or
at least one of Z₁ to Z₈, R₁, R₂, R₁₀, R₂₀, R₃₀, R₄₀, R₅₀, R₆₀, or R₇₀ may be -F, -Cl, -Br, -I, -SF₅, a cyano group, a substituted or unsubstituted C₁-C₆₀ alkyl group, a substituted or unsubstituted C₃-C₁₀ cycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, a substituted or unsubstituted monovalent non-aromatic heterocondensed polycyclic group, -Si(Q₁)(Q₂)(Q₃), or -Ge(Q₁)(Q₂)(Q₃).

According to one or more embodiments, at least one of Y₁ to Y₄ may be a group represented by Formula 2, or
at least one of Z₁ to Z₈, R₁, R₂, R₁₀, R₂₀, R₃₀, R₄₀, R₅₀, R₆₀, or R₇₀ may be a substituted or unsubstituted C₁-C₆₀ alkyl group, a substituted or unsubstituted C₃-C₁₀ cycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, a substituted or unsubstituted monovalent non-aromatic heterocondensed polycyclic group, -Si(Q₁)(Q₂)(Q₃), or -Ge(Q₁)(Q₂)(Q₃).

According to one or more embodiments, at least one of Y₁ to Y₄ may be a group represented by Formula 2, or
at least one of Z₁ to Z₈, R₁, R₂, R₁₀, R₂₀, R₃₀, R₄₀, R₅₀, R₆₀, or R₇₀ may be -F, -Cl, -Br, -I, -SF₅, a cyano group, a methyl group, an ethyl group, n-propyl group, an isopropyl group, n-butyl group, an isobutyl group, a sec-butyl group, a tert-butyl group, an n-pentyl group, an isopentyl group, a 2-methylbutyl group, a sec-pentyl group, a tert-pentyl group, a neo-pentyl group, a 3-pentyl group, a 3-methyl-2-butyl group, a phenyl group, a biphenyl group, a C₁-C₂₀ alkylphenyl group, a naphthyl group, -Si(Q₁)(Q₂)(Q₃), or -Ge(Q₁)(Q₂)(Q₃).

b10, b20, b30, b40, b50, b60, and b70 in Formulae 1 and 2 are each independently 1, 2, 3, 4, 5, 6, 7, 8, 9, 10, 11, 12, 13, or 14.

According to one or more embodiments, b10, b20, b30, b40, b50, b60, and b70 may each independently be 1, 2, 3, 4, 5, 6, 7, or 8.

According to one or more embodiments, b10, b20, b30, and b40 may each independently be 1, 2, 3, or 4.

According to one or more embodiments, b50 may be 1.

According to one or more embodiments, b60 and b70 may each independently be 1, 2, 3, or 4.

Two or more of a plurality of R₁₀ in Formulae 1 and 2 are optionally bonded to each other to form a substituted or unsubstituted C₅-C₃₀ carbocyclic group or a substituted or unsubstituted C₁-C₃₀ heterocyclic group,
two or more of a plurality of R₂₀ are optionally bonded to each other to form a substituted or unsubstituted C₅-C₃₀ carbocyclic group or a substituted or unsubstituted C₁-C₃₀ heterocyclic group,
two or more of a plurality of R₃₀ are optionally bonded to each other to form a substituted or unsubstituted C₅-C₃₀ carbocyclic group or a substituted or unsubstituted C₁-C₃₀ heterocyclic group,
two or more of a plurality of R₄₀ are optionally bonded to each other to form a substituted or unsubstituted C₅-C₃₀ carbocyclic group or a substituted or unsubstituted C₁-C₃₀ heterocyclic group,
two or more of a plurality of Rso are optionally bonded to each other to form a substituted or unsubstituted C₅-C₃₀ carbocyclic group or a substituted or unsubstituted C₁-C₃₀ heterocyclic group,
two or more of a plurality of R₆₀ are optionally bonded to each other to form a substituted or unsubstituted C₅-C₃₀ carbocyclic group or a substituted or unsubstituted C₁-C₃₀ heterocyclic group,
two or more of a plurality of R₇₀ are optionally bonded to each other to form a substituted or unsubstituted C₅-C₃₀ carbocyclic group or a substituted or unsubstituted C₁-C₃₀ heterocyclic group, and
two or more of adjacent Z₁ to Z₈, R₁, R₂, R₁₀, R₂₀, R₃₀, R₄₀, R₅₀, R₆₀, and R₇₀ are optionally bonded to each other to form a substituted or unsubstituted C₅-C₃₀ carbocyclic group or a substituted or unsubstituted C₁-C₃₀ heterocyclic group.

According to one or more embodiments, at least two of a plurality of R₁₀; at least two of a plurality of R₂₀; at least two of a plurality of R₃₀; at least two of a plurality of R₄₀; at least two of a plurality of R₅₀; at least two of a plurality of R₆₀; at least two of a plurality of R₇₀; and/or at least two of Z₁ to Z₃, R₁, R₂, R₁₀, R₂₀, R₃₀, R₄₀, R₅₀, R₆₀, and R₇₀ may optionally be bonded to each other via a single bond, a double bond, or a first linking group to form a C₅-C₃₀ carbocyclic group unsubstituted or substituted with at least one R₁₀ₐ, or a C₁-C₃₀ heterocyclic group unsubstituted or substituted with at least one R₁₀ₐ (for example, a fluorene group, a xanthene group, an acridine group, or the like, each unsubstituted or substituted with at least one R₁₀ₐ). R₁₀ₐ may be as provided herein in connection with R₁₀. The C₅-C₃₀ carbocyclic group and the C₁-C₃₀ heterocyclic group may each be as provided herein.

According to one or more embodiments, non-limiting examples of the "C₅-C₃₀ carbocyclic group unsubstituted or substituted with at least one R₁₀ₐ or a C₁-C₃₀ heterocyclic group unsubstituted or substituted with at least one R₁₀ₐ" include a benzene group, a naphthalene group, a cyclopentane group, a cyclopentadiene group, a cyclohexane group, a cycloheptane group, a bicyclo[2.2.1]heptane group, a furan group, a thiophene group, a pyrrole group, a silole group, an indene group, a benzofuran group, a benzothiophene group, an indole group, or a benzosilole group, each unsubstituted or substituted with at least one R₁₀ₐ. R₁₀ₐ may be as provided herein in connection with R₁₀.

The first linking group may be *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-S₀-*', *-O-*', *-C(=O)-*', *-S(=O)-*', *-S(=O)₂-*', *-C(R₈)=*', *=C(Ra)-*', *-C(R₈)=C(R₉)-*', *-C(=S)-*', or *-C≡C-*', wherein R₃ and R₉ may each be as provided in connection with R₁₀, and * and *' each indicate a binding site to a neighboring atom.

According to one or more embodiments, the heterocyclic compound may be represented by one of Formula 11 or Formula 12: 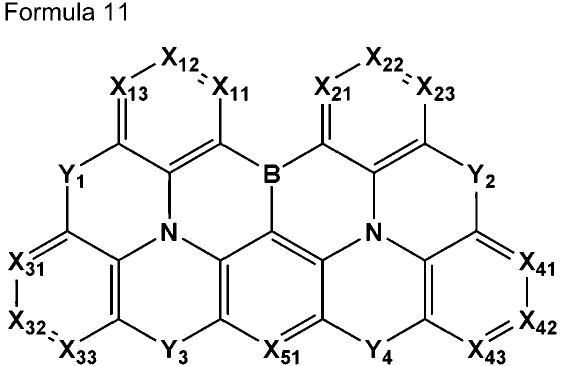 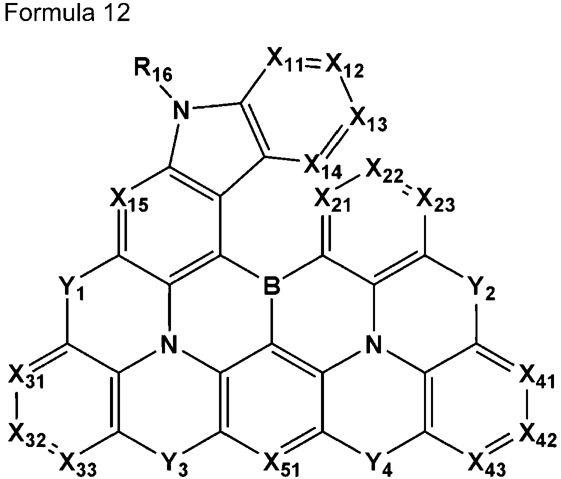 wherein, in Formulae 11 and 12,
descriptions of Y₁ to Y₄ are as provided herein,
X₁₁ may be C(R₁₁) or N, X₁₂ may be C(R₁₂) or N, X₁₃ may be C(R₁₃) or N, X₁₄ may be C(R₁₄) or N, X₁₅ may be C(R₁₅) or N,
X₂₁ may be C(R₂₁) or N, X₂₂ may be C(R₂₂) or N, and X₂₃ may be C(R₂₃) or N,
X₃₁ may be C(R₃₁) or N, X₃₂ may be C(R₃₂) or N, and X₃₃ may be C(R₃₃) or N,
X₄₁ may be C(R₄₁) or N, X₄₂ may be C(R₄₂) or N, and X₄₃ may be C(R₄₃) or N,
X₅₁ may be C(R₅₁) or N,
R₁₁ to R₁₆ may each independently be as provided herein in connection with R₁₀,
R₂₁ to R₂₃ may each independently be as provided herein in connection with R₂₀,
R₃₁ to R₃₃ may each independently be as provided herein in connection with R₃₀,
R₄₁ to R₄₃ may each independently be as provided herein in connection with R₄₀, and
R₅₁ may be as provided herein in connection with R₅₀.

According to one or more embodiments, the heterocyclic compound may be represented by one of Formulae 21 to 29: 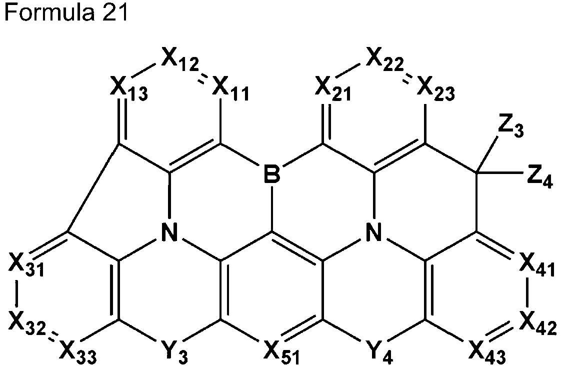 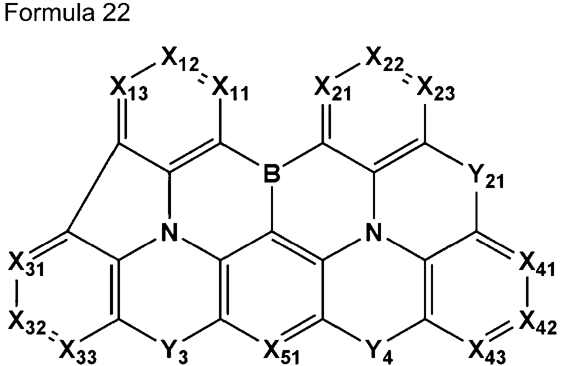 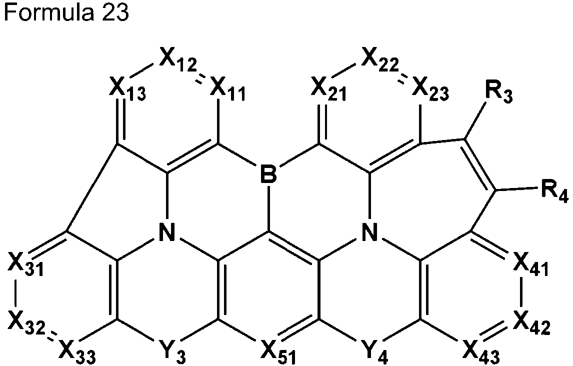 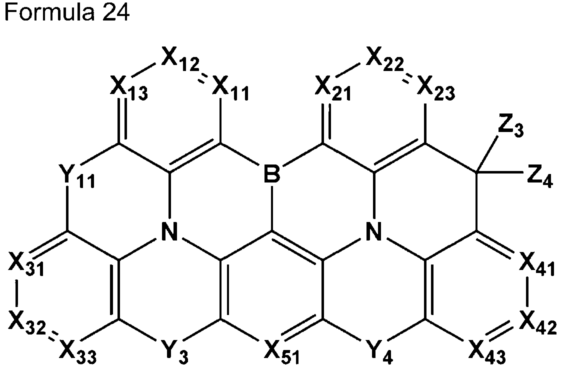 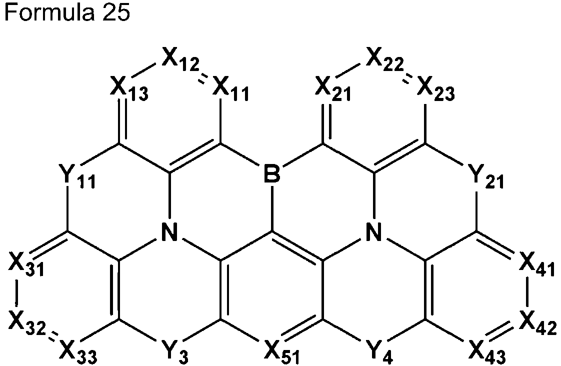 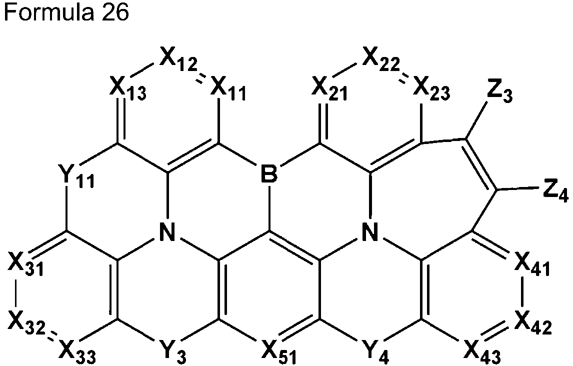 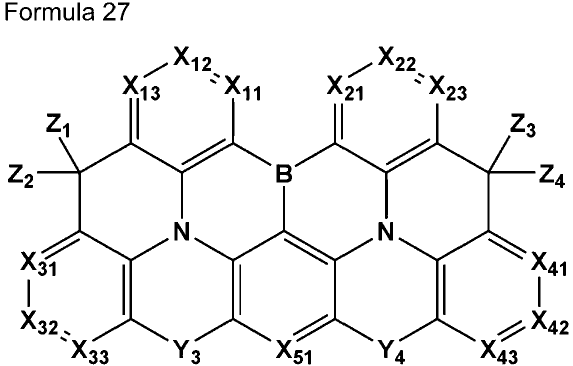 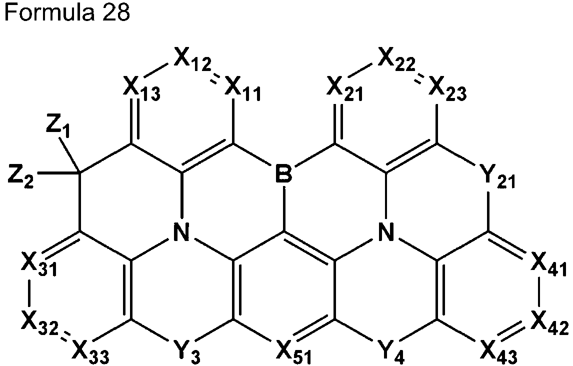 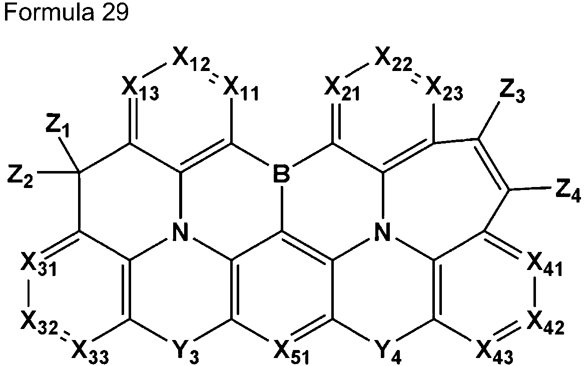 wherein, in Formulae 21 to 29,
descriptions of Y₃, Y₄, and Z₁ to Z₄ are as provided herein,
Y₁₁ may be *-O-*', *-S-*', *-Se-*', *-N(Z₁)-*', *-Si(Z₁)(Z₂)-*', *-Ge(Z₁)(Z₂)-*', or a group represented by Formula 2,
Y₂₁ may be *-O-*', *-S-*', *-Se-*', *-N(Z₃)-*', *-Si(Z₃)(Z₄)-*', *-Ge(Z₃)(Z₄)-*', or a group represented by Formula 2,
X₁₁ may be C(R₁₁) or N, X₁₂ may be C(R₁₂) or N, X₁₃ may be C(R₁₃) or N, X₁₄ may be C(R₁₄) or N, X₁₅ may be C(R₁₃) or N,
X₂₁ may be C(R₂₁) or N, X₂₂ may be C(R₂₂) or N, and X₂₃ may be C(R₂₃) or N,
X₃₁ may be C(R₃₁) or N, X₃₂ may be C(R₃₂) or N, and X₃₃ may be C(R₃₃) or N,
X₄₁ may be C(R₄₁) or N, X₄₂ may be C(R₄₂) or N, and X₄₃ may be C(R₄₃) or N,
X₅₁ may be C(R₅₁) or N,
R₁₁ to R₁₆ may each independently be as provided herein in connection with R₁₀,
R₂₁ to R₂₃ may each independently be as provided herein in connection with R₂₀,
R₃₁ to R₃₃ may each independently be as provided herein in connection with R₃₀,
R₄₁ to R₄₃ may each independently be as provided herein in connection with R₄₀, and
R₅₁ may be as provided herein in connection with R₅₀.

In one or more embodiments, in Formulae 23, 26 and 29, Z₃ and Z₄ are optionally bonded to each other to form a benzene group, a naphthalene group, a fluorene group, a xanthene group, an acridine group, a cyclopentane group, a cyclopentadiene group, a cyclohexane group, a cycloheptane group, a bicyclo[2.2.1]heptane group, a furan group, a thiophene group, a pyrrole group, a silole group, an indene group, a benzofuran group, a benzothiophene group, an indole group, or a benzosilole group, each unsubstituted or substituted with at least one R₁₀ₐ. R₁₀ₐ may be as provided herein in connection with R₁₀.

Q₁ to Q₃, Q₁₁ to Q₁₃, Q₂₁ to Q₂₃, and Q₃₁ to Q₃₃ as used herein may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, or
a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, -F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof.

According to one or more embodiments, Q₁ to Q₃, Q₁₁ to Q₁₃, Q₂₁ to Q₂₃, and Q₃₁ to Q₃₃ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, or
a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, a cyano group, a C₁-C₆₀ alkyl group, a C₆-C₆₀ aryl group, or a combination thereof.

For example, Q₁ to Q₃, Q₁₁ to Q₁₃, Q₂₁ to Q₂₃, and Q₃₁ to Q₃₃ may each independently be:
hydrogen, deuterium, -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, - CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, an neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or a combination thereof.

According to one or more embodiments, the heterocyclic compound represented by Formula 1 may contain only one boron (B).

According to one or more embodiments, the heterocyclic compound represented by Formula 1 may have an asymmetric structure.

According to one or more embodiments, the heterocyclic compound represented by Formula 1 may be one or more of compounds 1 to 66:

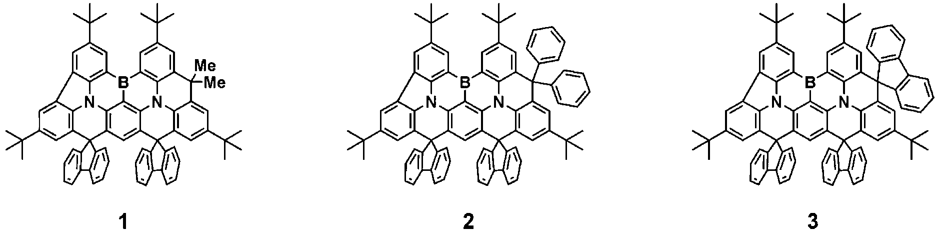

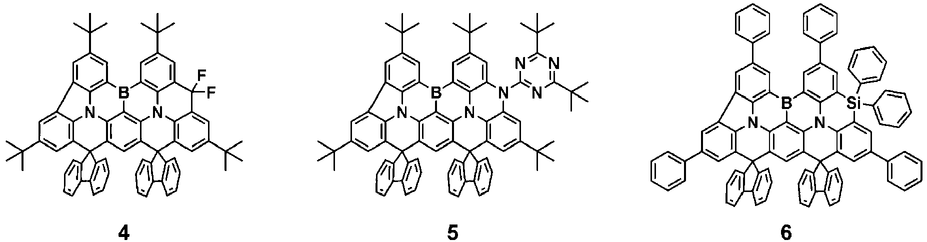

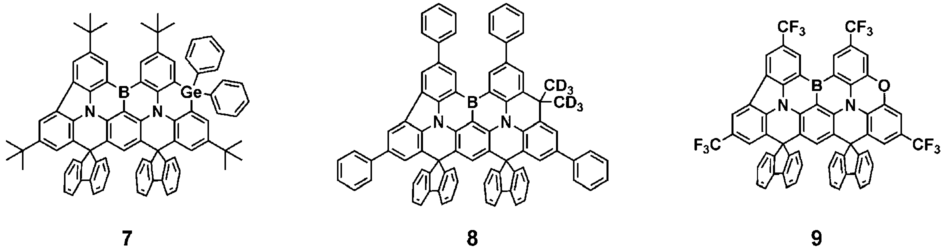

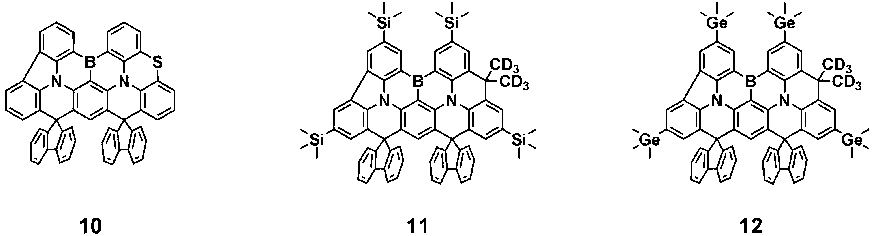

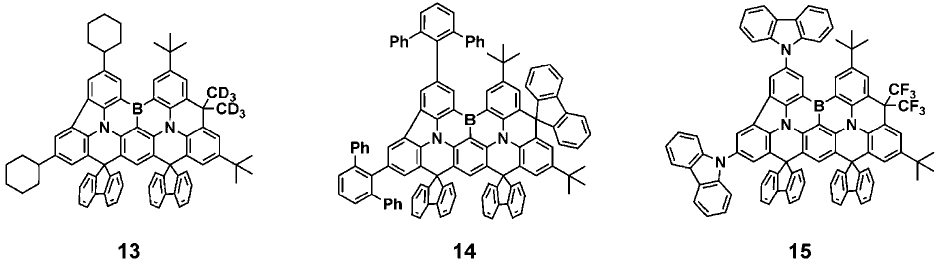

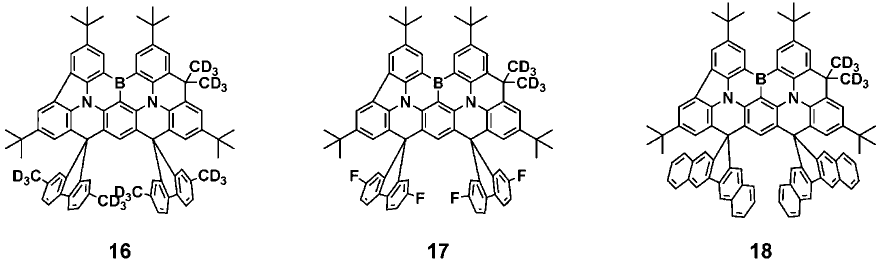

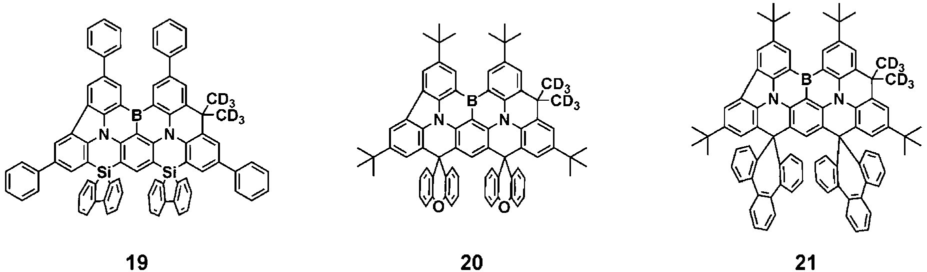

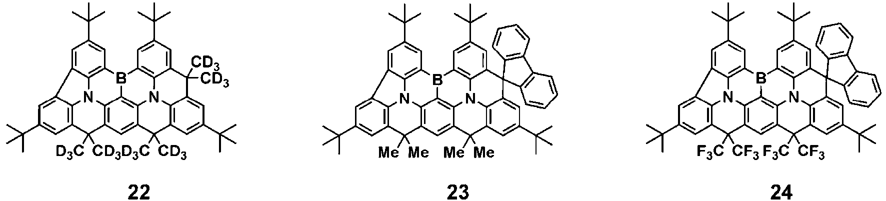

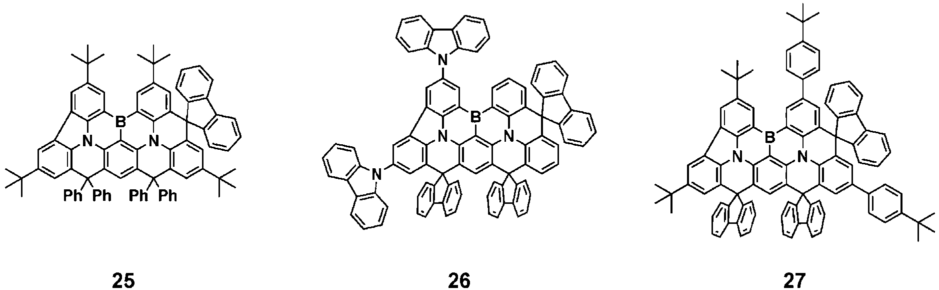

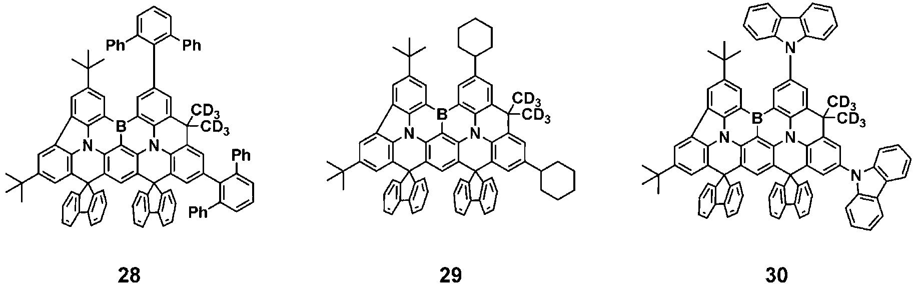

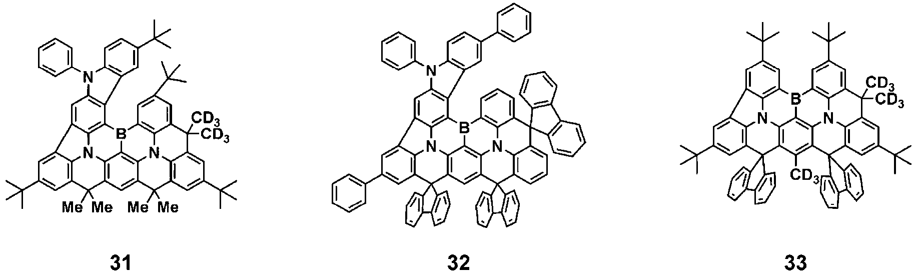

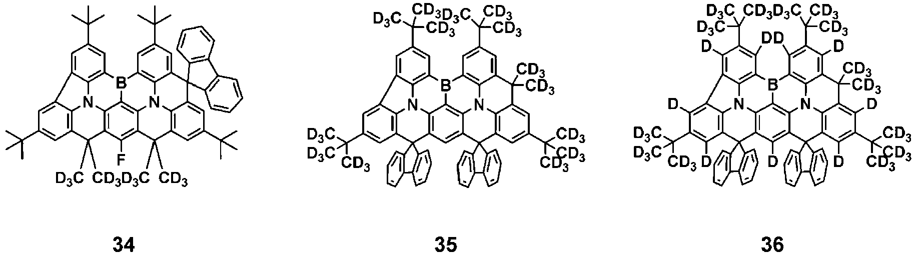

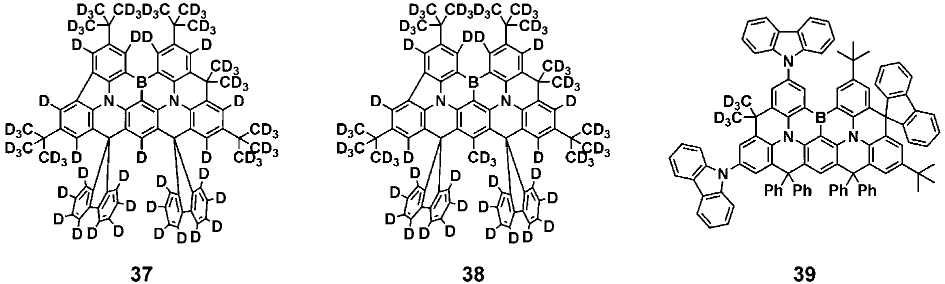

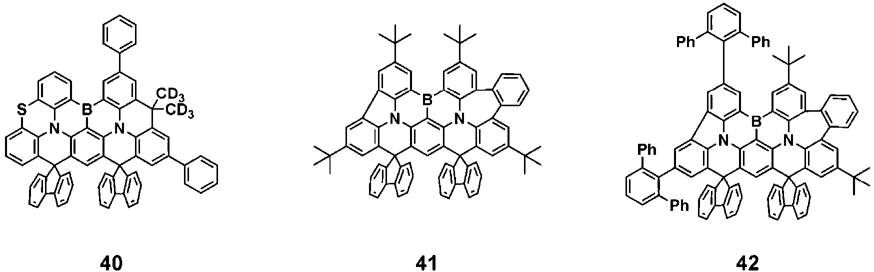

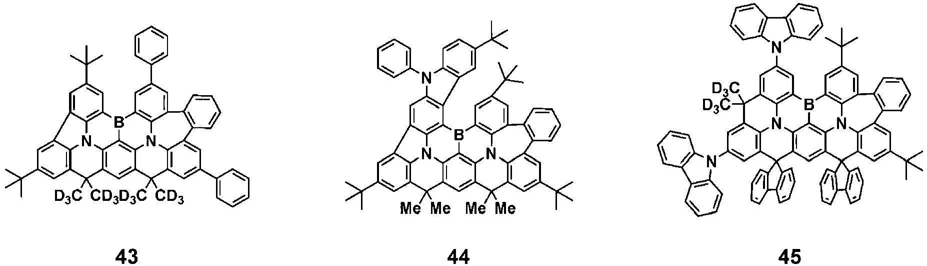

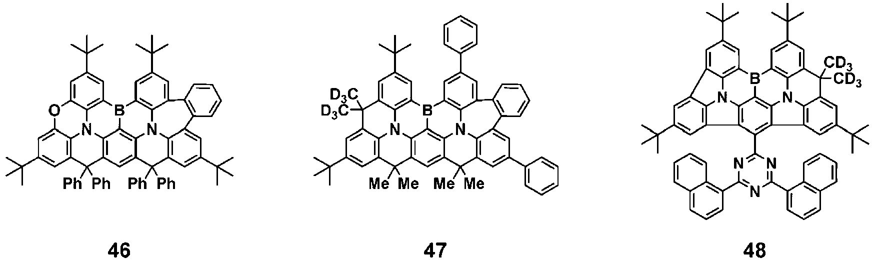

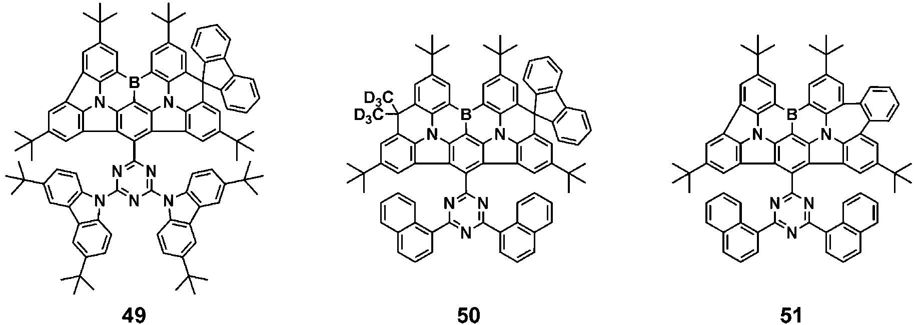

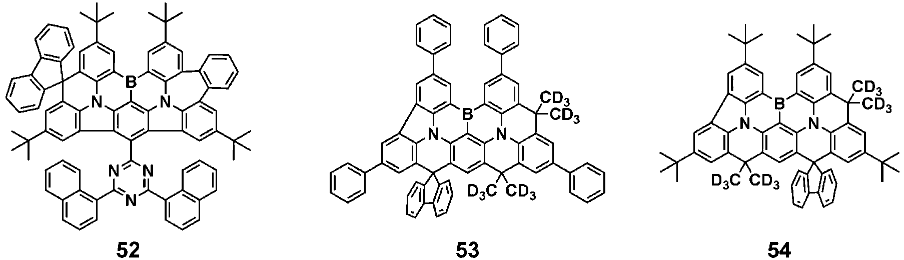

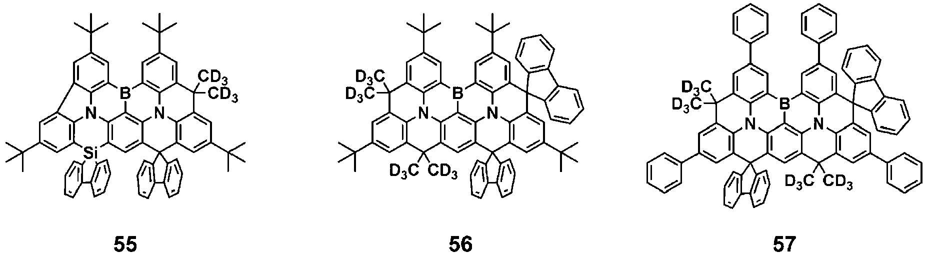

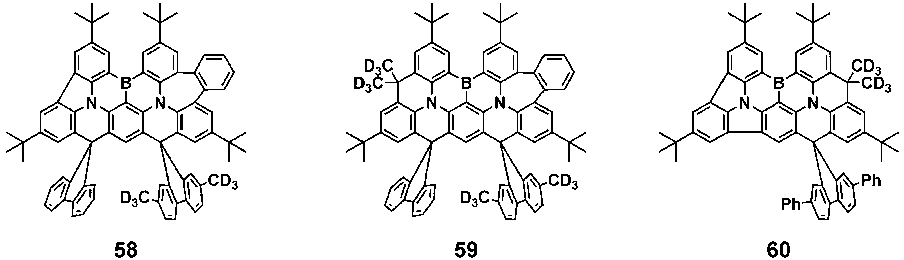

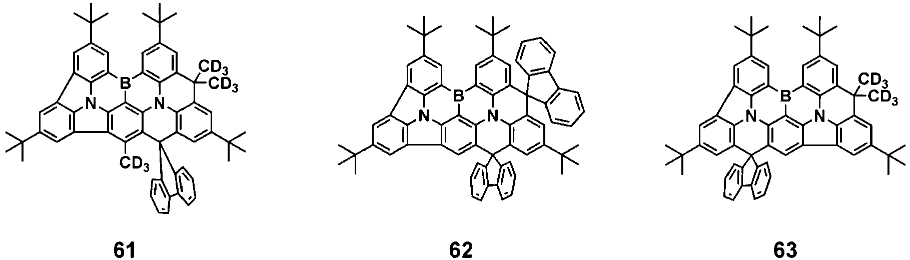

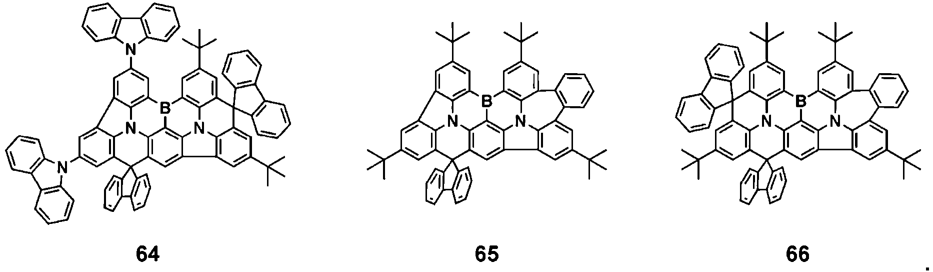

The heterocyclic compound represented by Formula 1 satisfies the structure of Formula 1, and due to this structure, the excellent luminescence efficiency can be obtained, and the roll-off phenomenon can be reduced.

Although not limited by a specific theory, the heterocyclic compound has a skeleton represented by Formula 1, thereby increasing the rigidity of the molecule, resulting in a small singlet-triplet energy difference, and thus exhibiting a narrow full width at half maximum (FWHM), a small Stokes shift, and/or a fast delayed fluorescence excitation time (tau). Therefore, electronic devices, for example, organic light-emitting devices, including at least one of the heterocyclic compounds represented by Formula 1, can exhibit high efficiency and high color purity.

According to one or more embodiments, the FWHM of an emission peak of an emission spectrum or an electroluminescence spectrum of the heterocyclic compound represented by Formula 1 may be about 60 nanometers (nm) or less. For example, the FWHM of an emission peak of an emission spectrum or an electroluminescence spectrum of the heterocyclic compound represented by Formula 1 may be about 5 nm to about 50 nm, about 7 nm to about 40 nm, or about 10 nm to about 30 nm.

A method for synthesizing the heterocyclic compound represented by Formula 1 can be recognized by those skilled in the art and by referring to the synthetic examples described herein.

The method for confirming the structure of the heterocyclic compound represented by Formula 1 is not particularly limited. According to one or more embodiments, the structure of the heterocyclic compound can be confirmed by a known method (for example, NMR, LC-MS, or the like).

### Organic light-emitting device

According to another aspect, an organic light-emitting device including at least one of the heterocyclic compounds represented by Formula 1 is provided.

According to one or more embodiments, the organic light-emitting device includes: a first electrode; a second electrode; and an organic layer disposed between the first electrode and the second electrode, wherein the organic layer includes an emission layer, and wherein the organic layer further includes at least one of the heterocyclic compounds represented by Formula 1.

In one or more embodiments, the emission layer may include at least one heterocyclic compound represented by Formula 1.

According to one or more embodiments, the emission layer may include a host and an emitter, and the emitter may include at least one heterocyclic compound represented by Formula 1.

According to one or more embodiments, the amount of the host in the emission layer may be greater than an amount of the at least one heterocyclic compound represented by Formula 1 in the emission layer, based on weight.

According to one or more embodiments, the emission layer may further include a sensitizer.

According to one or more embodiments, the sensitizer may include a phosphorescent compound (for example, an organometallic compound), a delayed fluorescent compound, or a combination thereof.

Detailed descriptions of the host, the emitter, and the sensitizer are as provided herein.

The organic light-emitting device may have characteristics of a low driving voltage, a low roll-off ratio, a relatively narrow FWHM of the emission peak in an electroluminescence (EL) spectrum and excellent external quantum efficiency, by including the emission layer including at least one of the heterocyclic compounds represented by Formula 1 as described herein.

In one or more embodiments, the heterocyclic compound represented by Formula 1 may act as a dopant (for example, an emitter or a sensitizer) in the emission layer, and the emission layer may further include a host (i.e., in the emission layer, the amount of the at least one heterocyclic compound represented by Formula 1 may be less than an amount of the host, based on weight).

According to one or more embodiments, the emission layer may emit a green light. For example, the emission layer can emit a green light having a maximum emission wavelength of about 500 nm to about 600 nm, for example, about 510 nm to about 550 nm.

The expressions that an "(emission layer) includes at least one heterocyclic compound represented by Formula 1" and "(emission layer) includes at least one of the heterocyclic compounds represented by Formula 1" may be used interchangeably herein and may be construed as meaning that the "(emission layer) may include one heterocyclic compound of Formula 1 or two or more different heterocyclic compounds of Formula 1."

For example, the emission layer may contain only compound 1 as the at least one heterocyclic compound represented by Formula 1. In this regard, compound 1 may be included in the emission layer of the organic light-emitting device. Alternatively, the emission layer may include compound 1 and compound 2 as the at least one heterocyclic compound represented by Formula 1.

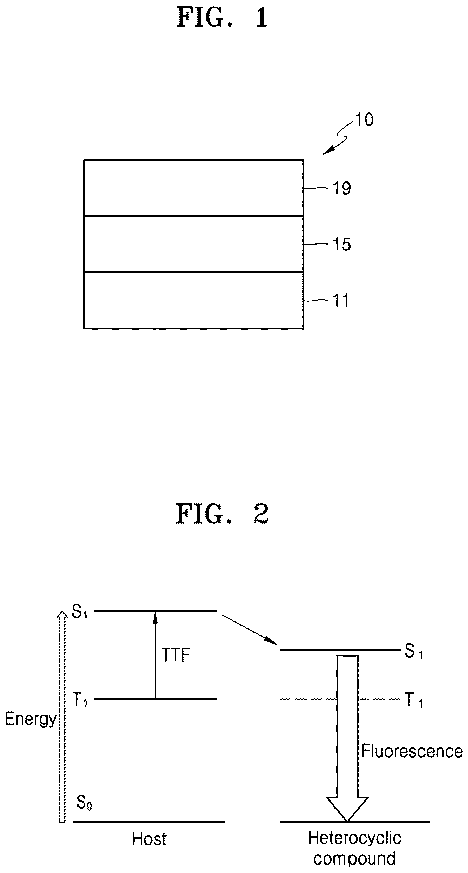

### Description of FIG. 1

FIG. 1 is a schematic cross-sectional view of an organic light-emitting device 10 according to one or more embodiments. Hereinafter, the structure of an organic light-emitting device according to one or more embodiments and a method of manufacturing an organic light-emitting device according to one or more embodiments are described with reference to FIG. 1.

The organic light-emitting device 10 of FIG. 1 includes a first electrode 11, a second electrode 19 facing the first electrode 11, and an organic layer 15 arranged between the first electrode 11 and the second electrode 19.

The organic layer 15 may include an emission layer, a hole transport region may be arranged between the first electrode 11 and the emission layer, and an electron transport region may be arranged between the emission layer and the second electrode 19.

A substrate may be further disposed under the first electrode 11 or on the second electrode 19. The substrate may be a substrate commonly used in organic light-emitting devices, for example, a glass substrate or a transparent plastic substrate, which have excellent mechanical strength, thermal stability, transparency, surface smoothness, ease of handling, and/or water repellency.

### First electrode 11

The first electrode 11 may be formed by, for example, depositing or sputtering, onto the substrate, a material for forming the first electrode 11. The first electrode 11 may be an anode. The material for forming the first electrode 11 may be selected from materials with a high work function for easy hole injection.

The first electrode 11 may be a reflective electrode, a transflective electrode, or a transmissive electrode. When the first electrode 110 is a transmissive electrode, a material for forming the first electrode 110 may be indium tin oxide (ITO), indium zinc oxide (IZO), tin oxide (SnO₂), zinc oxide (ZnO), or a combination thereof, but embodiments are not limited thereto. In some embodiments, when the first electrode 110 is a semi-transmissive electrode or a reflective electrode, as a material for forming the first electrode 110, at least one of magnesium (Mg), silver (Ag), aluminum (Al), aluminum-lithium (Al-Li), calcium (Ca), magnesium-indium (Mg-In), magnesium-silver (Mg-Ag), or a combination thereof may be used, but embodiments are not limited thereto.

The first electrode 11 may have a single-layered structure or a multi-layered structure including two or more layers.

### Emission layer

The emission layer may include at least one of the heterocyclic compounds represented by Formula 1.

A thickness of the emission layer may be about 100 Å to about 1,000 Å, for example, about 200 Å to about 600 Å. When the thickness of the emission layer is within the range described above, excellent luminescence characteristics may be obtained without a substantial increase in driving voltage.

### Description of FIG. 2

According to one or more embodiments, the heterocyclic compound represented by Formula 1 may be a fluorescent emitter.

According to one or more embodiments, the emission layer may further include a host (hereinafter referred to as 'host A', and host A is not the same as the heterocyclic compound represented by Formula 1). Host A may be understood by referring to the description of the host material provided herein, but the disclosure is not limited thereto. Host A may be a fluorescent host.

Referring to FIG. 2, energy transfer according to one or more embodiments is described as follows.

A singlet exciton is formed in host A in the emission layer, and the singlet exciton formed in host A may be transferred to a fluorescent emitter through Förster energy transfer (or Förster resonance energy transfer (FRET)).

Since singlet excitons formed in host A constitute merely 25%, the 75% proportion of triplet excitons formed in host A can be made to fuse with each other and convert to singlet excitons, thereby further improving the efficiency of the organic light-emitting device. In other words, efficiency of an organic light-emitting device may be further improved by using a triplet-triplet fusion (TTF) mechanism.

According to one or more embodiments, among the total luminescent components emitted from the light-emitting layer, the proportion of the luminescent component emitted from the heterocyclic compound represented by Formula 1 may be at least about 80 %, for example, at least about 90 %. In some embodiments, among the total luminescent components emitted from the emission layer, the proportion of the luminescent component emitted from the heterocyclic compound represented by Formula 1 may be at least about 95 %.

The heterocyclic compound represented by Formula 1 may emit fluorescence, and the host may not emit light.

According to one or more embodiments, when the emission layer further includes host A, in addition to the heterocyclic compound represented by Formula 1, the amount of the heterocyclic compound represented by Formula 1 may be 50 parts by weight or less, for example, 30 parts by weight or less, based on 100 parts by weight of the emission layer, and the amount of host A in the emission layer may be at least 50 parts by weight, for example, at least 70 parts by weight, based on 100 parts by weight of the emission layer, but embodiments are not limited thereto.

According to one or more embodiments, when the emission layer further includes host A in addition to the heterocyclic compound represented by Formula 1, host A and the heterocyclic compound represented by Formula 1 may satisfy condition A: $E {\left({H}_{A}\right)}_{S 1} > {E}_{S 1}$ Condition a wherein, in Condition A,
E(H_{A})_{S1} indicates a lowest excited singlet energy level of host A, and
E_{S1} indicates a lowest excited singlet energy level of the heterocyclic compound.

E(H_{A})_{S1} and E_{S1} may be evaluated by using a density functional theory (DFT) method of Gaussian program with structure optimization at a B3LYP/6-31G(d,p) level.

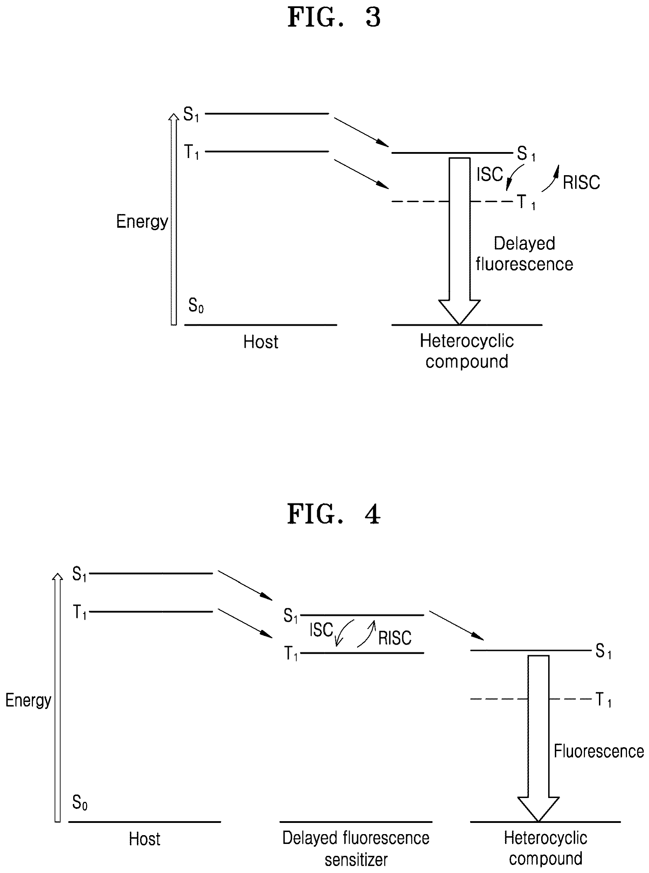

### Description of FIG. 3

According to one or more embodiments, the heterocyclic compound represented by Formula 1 may be a delayed fluorescence emitter.

According to one or more embodiments, the emission layer may further include a host (hereinafter referred to as 'host B', and host B is not the same as the heterocyclic compound represented by Formula 1). Host B may be understood by referring to the description of the host material provided herein, but embodiments are not limited thereto.

Referring to FIG. 3, energy transfer according to one or more embodiments is described as follows.

25 % of singlet excitons formed in host B in the emission layer are transferred to a delayed fluorescence emitter through FRET. Furthermore, 75% of triplet excitons formed in host B in the emission layer are transferred to the delayed fluorescence emitter through Dexter energy transfer. At least a portion of energy of the singlet of the delayed fluorescence emitter may be transferred to the triplet by intersystem crossing (ISC). The energy transferred to the triplet of the delayed fluorescent emitter may undergo reverse intersystem crossing (RISC) to the singlet. Accordingly, by transferring all the singlet excitons and triplet excitons generated in the emission layer to the heterocyclic compound, an organic light-emitting device having improved efficiency can be obtained.

According to one or more embodiments, among the total luminescent components emitted from the emission layer, the proportion of the luminescent component emitted from the heterocyclic compound represented by Formula 1 may be at least about 80 %, for example, at least about 90 %. According to one or more embodiments, among the total luminescent components emitted from the emission layer, the proportion of the luminescent component emitted from the heterocyclic compound represented by Formula 1 may be at least about 95 %.

In this regard, the heterocyclic compound represented by Formula 1 may emit fluorescence and/or delayed fluorescence, and the luminescent components of the heterocyclic compound represented by Formula 1 are the sum of prompt luminescent components of the heterocyclic compound represented by Formula 1 and delayed fluorescence components resulting from RISC of the heterocyclic compound represented by Formula 1. In addition, host B may not emit light.

According to one or more embodiments, when the emission layer further includes host B in addition to the heterocyclic compound represented by Formula 1, the amount of the heterocyclic compound represented by Formula 1 may be about 50 parts by weight or less, for example, about 30 parts by weight or less, per 100 parts by weight of the emission layer, and the amount of host B in the emission layer may be about 50 parts by weight or more, for example, about 70 parts by weight or more, per 100 parts by weight of the emission layer, but embodiments are not limited thereto.

According to one or more embodiments, when the emission layer further includes host B in addition to the heterocyclic compound represented by Formula 1, the host B and the heterocyclic compound represented by Formula 1 can satisfy Condition B: $E {\left({H}_{B}\right)}_{S 1} > {E}_{S 1}$ Condition b

In condition B,
E(H_{B})_{S1} indicates a lowest excited singlet energy level of host B, and
E_{S1} indicates a lowest excited singlet energy level of the heterocyclic compound represented by Formula 1.

E(H_{B})_{S1} and E_{S1} may be evaluated by using the DFT method of Gaussian program with structure optimization at a B3LYP/6-31G(d,p) level.

### Description of FIG. 4

According to one or more embodiments, the heterocyclic compound represented by Formula 1 is used as a fluorescent emitter, and the emission layer includes a sensitizer, for example, a delayed fluorescence sensitizer. According to another embodiment, the emission layer may further include a host (hereinafter referred to as 'host C', wherein host C is not the same as the heterocyclic compound represented by Formula 1 or the sensitizer) and a sensitizer (hereinafter referred to as 'sensitizer A', wherein sensitizer A is not the same as host C or the heterocyclic compound represented by Formula 1). Host C and sensitizer A may respectively be understood by referring to the description of the host material and the sensitizer material provided herein, but embodiments are not limited thereto.

According to one or more embodiments, among the total luminescent components emitted from the emission layer, the proportion of the luminescent component emitted from the heterocyclic compound represented by Formula 1 may be at least about 80 %, for example, at least about 90 % (for example, at least about 95 %). For example, the heterocyclic compound represented by Formula 1 may emit fluorescence. In addition, each of host C and sensitizer A may not emit light.

Referring to FIG. 4, energy transfer according to one or more embodiments is described as follows.

Singlet and triplet excitons may be formed in host C in the emission layer, and singlet and triplet excitons formed in host C may be transferred to sensitizer A and then transferred to the heterocyclic compound represented by Formula 1 through FRET. The 25% proportion of singlet excitons formed in host C are transferred to sensitizer A through FRET, and the energy of the 75% proportion of triplet excitons formed in host C is transferred to singlet and triplet states of sensitizer A. At least a portion of energy of the singlet of sensitizer A may be transferred to the triplet by ISC. The energy transferred to the triplet of sensitizer A undergoes RISC to the singlet, and then the singlet energy of sensitizer A is transferred to the heterocyclic compound represented by Formula 1 through FRET.

Accordingly, by transferring all the singlet excitons and triplet excitons generated in the emission layer to a dopant (for example, an emitter), an organic light-emitting device having improved efficiency may be obtained. In addition, because an organic light-emitting device with significantly reduced energy loss may be obtained, the lifespan characteristics of the organic light-emitting device may be improved.

Referring to FIG. 4, when the emission layer further includes host C and sensitizer A, in addition to the condensed cyclic compound, host C and sensitizer A may satisfy Condition C-1 and/or Condition C-2: ${S}_{1} \left({H}_{C}\right) \geq {S}_{1} \left({S}_{A}\right)$ Condition c-1 ${S}_{1} \left({S}_{A}\right) \geq {S}_{1} \left(HC\right)$ Condition c-2 wherein, in Conditions C-1 and C-2,
S₁(H_{C}) indicates a lowest excited singlet energy level of host C,
S₁(S_{A}) indicates a lowest excited singlet energy level of sensitizer A, and
S₁(HC) indicates a lowest excited singlet energy level of the heterocyclic compound represented by Formula 1.

S₁(H_{C}), S₁(S_{A}), and S₁(HC) may be evaluated by using the DFT method of Gaussian program with structure optimization at a B3LYP/6-31G(d,p) level.

When host C, sensitizer A, and the heterocyclic compound represented by Formula 1 satisfy Condition C-1 and/or C-2, FRET from sensitizer A to the heterocyclic compound represented by Formula 1 may be facilitated, and accordingly, the organic light-emitting device may have improved luminescence efficiency.

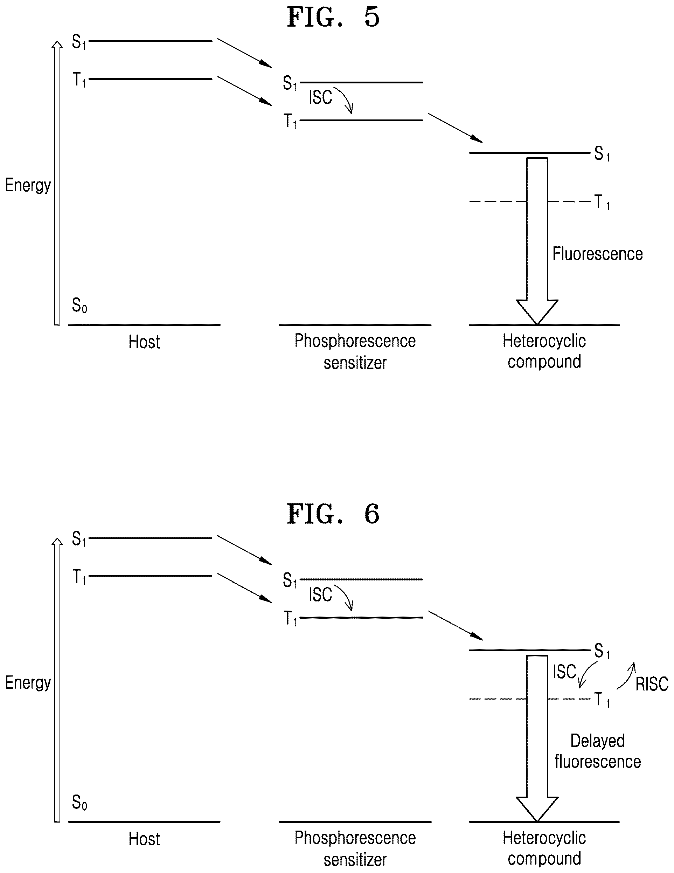

### Description of FIG. 5

According to one or more embodiments, the heterocyclic compound represented by Formula 1 may be used as a fluorescent emitter, and the emission layer may include a sensitizer, for example, a phosphorescent sensitizer.

According to one or more embodiments, the emission layer may further include a host (hereinafter referred to as 'host D', wherein host D is not the same as the heterocyclic compound represented by Formula 1 or the sensitizer) and a sensitizer (hereinafter referred to as 'sensitizer B', wherein sensitizer B is not the same as host D or the heterocyclic compound represented by Formula 1). Host D and sensitizer B may respectively be understood by referring to the description of the host material and the sensitizer material provided herein, but embodiments are not limited thereto.

According to one or more embodiments, the proportion of the luminescent component of the heterocyclic compound represented by Formula 1 among the total luminescent component emitted from the emission layer may be about 80% or more, for example, about 90% or more (as another example, about 95% or more). For example, the heterocyclic compound represented by Formula 1 may emit fluorescence. In some embodiments, each of host D and sensitizer B may not emit light.

Referring to FIG. 5, energy transfer according to one or more embodiments is described as follows.

The 75% proportion of triplet excitons formed in host D in the emission layer are transferred to sensitizer B through Dexter energy transfer, and the energy of the 25% proportion of singlet excitons formed in host D is transferred to singlet and triplet states of sensitizer B, wherein the energy transferred to the singlet state of sensitizer B undergoes ISC to the triplet state, and then the triplet energy of sensitizer B is transferred to the heterocyclic compound represented by Formula 1 through FRET.

Accordingly, by transferring all the singlet excitons and triplet excitons generated in the emission layer to a dopant (for example, an emitter), an organic light-emitting device having improved efficiency may be obtained. In addition, because an organic light-emitting device with significantly reduced energy loss may be obtained, the lifespan characteristics of the organic light-emitting device may be improved.

According to one or more embodiments, when the emission layer further includes host D and sensitizer B in addition to the heterocyclic compound represented by Formula 1, host D and sensitizer B may satisfy Conditions D-1 and/or D-2: ${T}_{1} \left({H}_{D}\right) \geq {T}_{1} \left({S}_{B}\right)$ Condition d-1 ${T}_{1} \left({S}_{B}\right) \geq {S}_{1} \left(HC\right)$ Condition d-2 wherein, in Conditions D-1 and D-2,
T₁(H_{D}) indicates a lowest excited triplet energy level of host D,
T₁(S_{B}) indicates a lowest excited triplet energy level of sensitizer B, and
S₁(HC) indicates a lowest excited singlet energy level of the heterocyclic compound represented by Formula 1.

T₁(H_{D}), T₁(S_{B}), and S₁(HC) may be evaluated by using the DFT method of Gaussian program with structure optimization at a B3LYP/6-31G(d,p) level.

When host D, sensitizer B, and the heterocyclic compound represented by Formula 1 satisfy Condition D-1 and/or D-2, FRET from sensitizer B to the heterocyclic compound represented by Formula 1 may be facilitated, and accordingly, the organic light-emitting device may have improved luminescence efficiency.

According to one or more embodiments, the amount of the sensitizer in the emission layer may be about 5 wt% to about 50 wt%, for example, about 10 wt% to about 30 wt%, based on total weight of the emission layer. When the range as described above is satisfied, effective energy transfer in the emission layer may be achieved. Thus, the organic light-emitting device may have high efficiency and long lifespan.

In one or more embodiments, the amount of the heterocyclic compound represented by Formula 1 in the emission layer may be about 0.01 wt% to about 15 wt%, for example, about 0.05 wt% to about 3 wt%, based on total weight of the emission layer, but embodiments are not limited thereto.

According to one or more embodiments, the heterocyclic compound represented by Formula 1 may further satisfy Condition 5: $0 μs < {T}_{decay} \left(HC\right) < 5 μs$ Condition 5 wherein, in condition 5,
T_{decay}(HC) indicates a decay time of the heterocyclic compound represented by Formula 1.

The decay time of the heterocyclic compound represented by Formula 1 is calculated from a time-resolved photoluminescence (TRPL) spectrum at room temperature with respect to a film (hereinafter, referred to as "film (HC)") having a thickness of 40 nm obtained by vacuum-co-depositing, on a quartz substrate, the host and the heterocyclic compound represented by Formula 1 included in the emission layer at a weight ratio of 90:10 at a vacuum degree of 10⁻⁷ torr.

### Description of FIG. 6

According to one or more embodiments, the heterocyclic compound represented by Formula 1 may be used as a delayed fluorescence emitter, and the emission layer may include a sensitizer, for example, a phosphorescent sensitizer.

According to one or more embodiments, the emission layer may further include a host (hereinafter referred to as 'host E', wherein host E is not the same as the heterocyclic compound represented by Formula 1 or the sensitizer) and a sensitizer (hereinafter referred to as 'sensitizer C', wherein sensitizer C is not the same as host E or the heterocyclic compound represented by Formula 1). Host E and sensitizer C may respectively be understood by referring to the description of the host material and the sensitizer material provided herein, but embodiments are not limited thereto.

According to one or more embodiments, the proportion of the luminescent component of the heterocyclic compound represented by Formula 1 among the total luminescent components emitted from the emission layer may be about 80% or more, for example, about 90% or more (as another example, about 95% or more). For example, the heterocyclic compound represented by Formula 1 may emit delayed fluorescence. In addition, each of host E and sensitizer C may not emit light.

With reference to FIG. 6, energy transfer according to one or more embodiments is described as follows.

The 75% proportion of triplet excitons formed in host E in the emission layer are transferred to sensitizer C through Dexter energy transfer, and the energy of the 25% proportion of singlet excitons formed in host E is transferred to singlet and triplet states of sensitizer C, wherein the energy transferred to the singlet state of sensitizer C undergoes ISC to the triplet state, and then the triplet energy of sensitizer C is transferred to the heterocyclic compound represented by Formula 1 through FRET and/or Dexter energy transfer. The energy transferred to the triplet state of the heterocyclic compound represented by Formula 1 may be RISCed to a singlet state.

Accordingly, by transferring all the singlet excitons and triplet excitons generated in the emission layer to a dopant (for example, an emitter), an organic light-emitting device having improved efficiency may be obtained. In addition, because an organic light-emitting device with significantly reduced energy loss may be obtained, the lifespan characteristics of the organic light-emitting device may be improved.

According to one or more embodiments, when the emission layer further includes host E and sensitizer C in addition to the heterocyclic compound represented by Formula 1, host E and sensitizer C may satisfy Conditions E-1, E-2, E-3, and/or E-4: ${S}_{1} \left({S}_{C}\right) \geq {S}_{1} \left(HC\right)$ Condition e-1 ${T}_{1} \left({S}_{C}\right) \geq {T}_{1} \left(HC\right)$ Condition e-2 ${T}_{1} \left({H}_{E}\right) \geq {T}_{1} \left({S}_{C}\right)$ Condition e-3 ${T}_{1} \left({S}_{C}\right) \geq {S}_{1} \left(HC\right)$ Condition e-4 wherein, in Conditions E-1, E-2, E-3, and E-4,
S₁(S_{C}) indicates a lowest excited singlet energy level of sensitizer C,
S₁(HC) is the lowest excitation singlet energy level of the heterocyclic compound represented by Formula 1,
T₁(S_{C}) indicates a lowest excited triplet energy level of sensitizer C, and
T₁(HC) is the lowest excited triplet energy level of the heterocyclic compound represented by Formula 1, and
T_{L}(H_{E}) is the lowest excited triplet energy level of host E.

S₁(S_{C}), S₁(HC), T₁(S_{C}), T₁(HC), T₁(H_{E}), and T₁(S_{C}) were evaluated using the DFT method of the Gaussian program with structural optimization at the B3LYP/6-31G(d,p) level.

When host E, sensitizer C, and the heterocyclic compound represented by Formula 1 satisfy Conditions E-1, E-2, E-3, and/or E-4, FRET and/or Dexter energy transfer from sensitizer C to the heterocyclic compound represented by Formula 1 may be promoted, and thus the luminescence efficiency of the organic light-emitting device may be improved.

According to one or more embodiments, the amount of the sensitizer in the emission layer may be about 5 wt% to about 50 wt%, for example, about 10 wt% to about 30 wt%, based on total weight of the emission layer. When the range as described above is satisfied, effective energy transfer in the emission layer may be achieved. Thus, the organic light-emitting device may have high efficiency and long lifespan.

According to one or more embodiments, the amount of the heterocyclic compound represented by Formula 1 in the emission layer may be about 0.01 wt% to about 15 wt%, for example, about 0.05 wt% to about 3 wt%, based on total weight of the emission layer, but embodiments are not limited thereto.

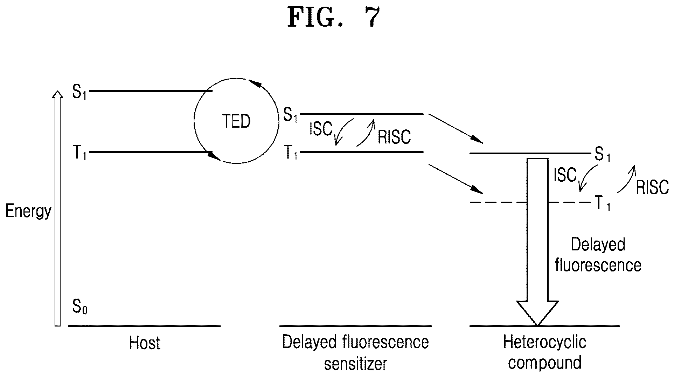

### Description of FIG. 7

According to one or more embodiments, the heterocyclic compound represented by Formula 1 is used as a delayed fluorescence emitter, and the emission layer may include a sensitizer, for example, a delayed fluorescence sensitizer.

According to one or more embodiments, the emission layer may further include a host (hereinafter referred to as 'host F', wherein host F is not the same as the heterocyclic compound represented by Formula 1 or the sensitizer) and a sensitizer (hereinafter referred to as 'sensitizer D', wherein sensitizer D is not the same as host F or the heterocyclic compound represented by Formula 1). Host F and sensitizer D can be understood with reference to the host material and sensitizer material described herein, but embodiments are not limited thereto.

According to one or more embodiments, among the total luminescent components emitted from the emission layer, the proportion of the luminescent component emitted from the heterocyclic compound represented by Formula 1 may be at least about 80%, for example, at least about 90% (as another example, at least about 95%). In some embodiments, the heterocyclic compound represented by Formula 1 may emit fluorescence and/or delayed fluorescence. In some embodiments, each of host F and sensitizer D may not emit light.

In this regard, the heterocyclic compound represented by Formula 1 may emit fluorescence and/or delayed fluorescence, and the luminescent component of the heterocyclic compound represented by Formula 1 is the sum of the prompt luminescent component of the heterocyclic compound represented by Formula 1 and the delayed fluorescence component by RISC of the heterocyclic compound represented by Formula 1.

Referring to FIG. 7, the energy transfer according to embodiment is explained as follows.

The 25% proportion of singlet excitons formed in host F in the emission layer are transferred to the singlet state of sensitizer D through FRET, and the energy of the 75% proportion of triplet excitons formed in host F is transferred to the triplet state of sensitizer C, then the singlet energy of sensitizer D is transferred to the heterocyclic compound represented by Formula 1 through FRET, and the triplet energy of sensitizer D is transferred to the heterocyclic compound represented by Formula 1 through Dexter energy transfer. Among these, the energy transferred to the triplet of sensitizer D may also be RISCed to the singlet. In some embodiments, in the case of sensitizer D, the energy of the triplet formed in sensitizer D may be transferred backward to host F (triplet exciton distributing, TED) and then transferred back to the heterocyclic compound represented by Formula 1 to emit light through RISC.

Accordingly, by transferring all the singlet excitons and triplet excitons generated in the emission layer to a dopant (for example, an emitter), an organic light-emitting device having improved efficiency may be obtained. In addition, because an organic light-emitting device with significantly reduced energy loss may be obtained, the lifespan characteristics of the organic light-emitting device may be improved.

According to one or more embodiments, when the emission layer further includes host F and sensitizer D in addition to the heterocyclic compound represented by Formula 1, host F and sensitizer D may satisfy Conditions F-1, F-2 and/or F-3: ${S}_{1} \left({H}_{F}\right) \geq {S}_{1} \left({S}_{D}\right)$ Condition f-1 ${S}_{1} \left({S}_{D}\right) \geq {S}_{1} \left(HC\right)$ Condition f-2 ${T}_{1} \left({S}_{D}\right) \geq {T}_{1} \left(HC\right)$ Condition f-3 wherein, in Conditions F-1, F-2, and F-3,
S₁(H_{F}) is the lowest excited singlet energy level of host F;
S₁(S_{D}) is the lowest excited singlet energy level of sensitizer D;
S₁(H_{D}) is the lowest excited singlet energy level of the heterocyclic compound represented by Formula 1,
T₁(S_{D}) is the lowest excited triplet energy level of sensitizer D; and
T₁(HC) indicates a lowest excited triplet energy level of the heterocyclic compound represented by Formula 1.

S₁(H_{F}), S₁(S_{D}), S₁(HC), T₁(S_{D}), and T₁(HC) were evaluated using the DFT method of the Gaussian program with structural optimization at the B3LYP/6-31G(d,p) level.

When host F, sensitizer D, and the heterocyclic compound represented by Formula 1 satisfy Conditions F-1, F-2, and/or F-3, the Dexter transition and FRET from sensitizer D to the heterocyclic compound represented by Formula 1 can be promoted, and thus the luminescence efficiency of the organic light-emitting device can be improved.

According to one or more embodiments, the amount of sensitizer D in the emission layer may be about 5 wt% to about 50 wt%, for example, about 10 wt% to about 30 wt%, based on total weight of the emission layer. When the range as described above is satisfied, effective energy transfer in the emission layer may be achieved. Thus, the organic light-emitting device may have high efficiency and long lifespan.

According to one or more embodiments, the amount of the heterocyclic compound represented by Formula 1 in the emission layer may be about 0.01 wt% to about 15 wt%, for example, about 0.05 wt% to about 3 wt%, based on total weight of the emission layer, but embodiments are not limited thereto.

### Host in emission layer

According to one or more embodiments, the host may not include metal atoms.

According to one or more embodiments, the host may include at least one compound that is a fluorene-containing compound, a carbazole-containing compound, a dibenzofuran-containing compound, a dibenzothiophene-containing compound, an indenocarbazole-containing compound, an indolocarbazole-containing compound, a benzofurocarbazole-containing compound, a benzothienocarbazole-containing compound, an acridine-containing compound, a dihydro acridine-containing compound, a triindolobenzene-containing compound, a pyridine-containing compound, a pyrimidine-containing compound, a triazine-containing compound, a silicon-containing compound, a cyano group-containing compound, a phosphine oxide-containing compound, a sulfoxide-containing compound, or a sulfonyl-containing compound.

For example, the host may be a compound including at least one carbazole ring and at least one cyano group, or a phosphine oxide-containing compound.

According to one or more embodiments, the host may consist of one kind of host. When the host consists of one kind of host, the one kind of host may be a bipolar host, an electron-transporting host, or a hole-transporting host, which will be described herein.

According to one or more embodiments, the host may include a mixture of two or more different kinds of hosts. For example, the host may be a mixture of an electron-transporting host and a hole-transporting host, a mixture of two different kinds of electron-transporting hosts, or a mixture of two different kinds of hole-transporting hosts. The electron-transporting host and the hole-transporting host may be understood by referring to the related description to be presented later.

According to one or more embodiments, the host may include an electron-transporting host including at least one electron-transporting moiety, and a hole-transporting host that does not include an electron-transporting moiety.

The electron-transporting moiety as used herein may be a cyano group, a π electron-deficient nitrogen-containing cyclic group, or a group represented by one of the following Formulae: 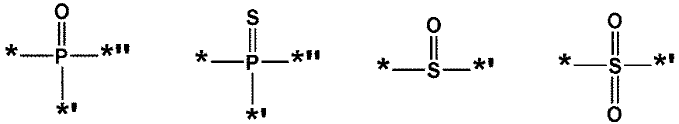 wherein, in the formulae above, *, *', and *" each indicate a binding site to a neighboring atom.

According to one or more embodiments, the electron-transporting host in the emission layer may include at least one of a cyano group or a π electron-deficient nitrogen-containing cyclic group.

According to one or more embodiments, the electron-transporting host in the emission layer may include at least one cyano group.

According to one or more embodiments, the electron-transporting host in the emission layer may include at least one cyano group and at least one π electron-deficient nitrogen-containing cyclic group.

According to one or more embodiments, the host may include an electron-transporting host and a hole-transporting host, wherein the electron-transporting host may include at least one π electron-deficient nitrogen-free cyclic group and at least one electron-transporting moiety, and the hole-transporting host may include at least one π electron-deficient nitrogen-free cyclic group and may not include an electron-transporting moiety.

The term "π electron-deficient nitrogen-containing cyclic group" as used herein refers to a cyclic group having at least one *-N=*' moiety, and for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group; or a condensed cyclic group in which two or more π electron-deficient nitrogen-containing cyclic groups are condensed with each other.

Meanwhile, the π electron-deficient nitrogen-free cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; or a condensed cyclic group of two or more π electron-deficient nitrogen-free cyclic groups, but embodiments are not limited thereto.

According to one or more embodiments, when the host is a mixture of an electron-transporting host and a hole-transporting host, the weight ratio of the electron-transporting host and the hole-transporting host may be about 1:9 to about 9:1, for example, about 2:8 to about 8:2, for example, about 4:6 to about 6:4, for example, about 5:5. When the weight ratio of the electron-transporting host and the hole-transporting host satisfies the above-described ranges, the hole-and-electron transport balance in the emission layer may be made.

The host may include at least one of 1,3,5-tri(1-phenyl-1H-benzo[d]imidazol-2-yl)benzene (TPBi), 3-tert-butyl-9,10-di(naphth-2-yl)anthracene (TBADN), 9,10-di(naphth-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazol-9-yl)benzene (TCP), 1,3-bis(N-carbazolyl)benzene (mCP), compound H50, or compound H51, but embodiments are not limited thereto:

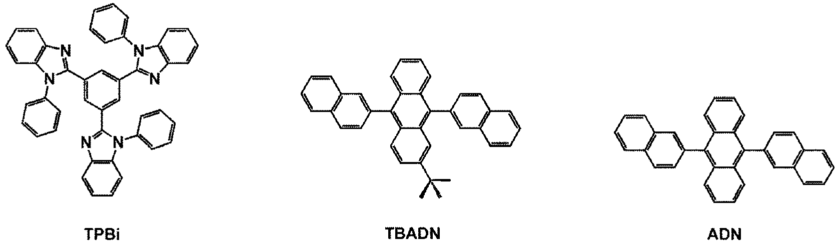

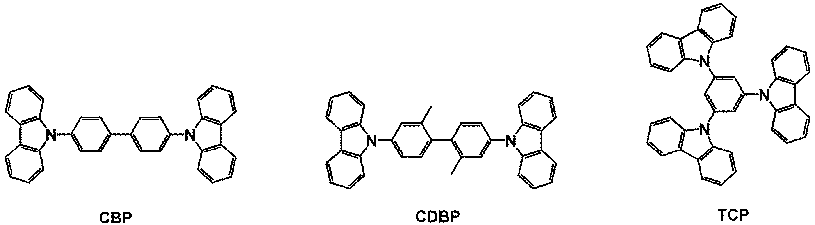

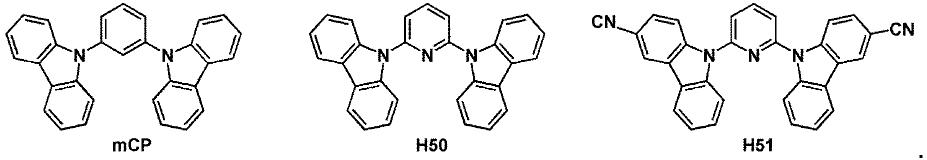

According to one or more embodiments, the host may further include a compound represented by Formula 301: 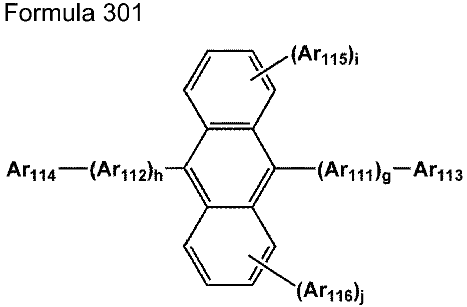 wherein Ar₁₁₁ and Ar₁₁₂ in Formula 301 may each independently be:
a phenylene group, a naphthylene group, a phenanthrenylene group, or a pyrenylene group; or
a phenylene group, a naphthylene group, a phenanthrenylene group, or a pyrenylene group, each substituted with at least one of a phenyl group, a naphthyl group, or an anthracenyl group.

Ar₁₁₃ to Ar₁₁₆ in Formula 301 may each independently be:
a C₁-C₁₀ alkyl group, a phenyl group, a naphthyl group, a phenanthrenyl group, or a pyrenyl group; or
a phenyl group, a naphthyl group, a phenanthrenyl group, or a pyrenyl group, each substituted with at least one of a phenyl group, a naphthyl group, or an anthracenyl group.

g, h, i, and j in Formula 301 may each independently be an integer from 0 to 4, and g, h, i, and j may each independently be, for example, 0, 1, or 2.

Ar₁₁₃ to Ar₁₁₆ in Formula 301 may each independently be:
a C₁-C₁₀ alkyl group that is substituted with at least one of a phenyl group, a naphthyl group, or an anthracenyl group;
a phenyl group, a naphthyl group, an anthracenyl group, a pyrenyl, a phenanthrenyl group, or a fluorenyl group;
a phenyl group, a naphthyl group, an anthracenyl group, a pyrenyl group, a phenanthrenyl group, or a fluorenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a phenyl group, a naphthyl group, an anthracenyl group, a pyrenyl group, a phenanthrenyl group, or a fluorenyl group; or 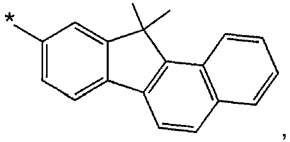 but embodiments are not limited thereto.

In one or more embodiments, the host may include a compound represented by Formula 302: 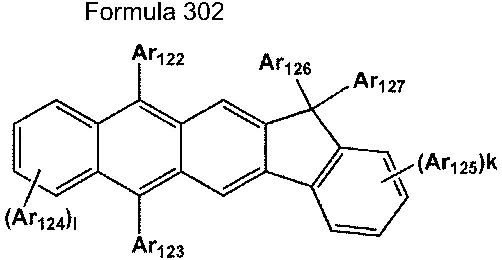 wherein Ar₁₂₂ to Ar₁₂₅ in Formula 302 are defined the same as Ar₁₁₃ in Formula 301.

Ar₁₂₆ and Ar₁₂₇ in Formula 302 may each independently be a C₁-C₁₀ alkyl group (for example, a methyl group, an ethyl group, a propyl group, or the like).

In Formula 302, k and I may each independently be an integer from 0 to 4. For example, k and I may each independently be 0, 1, or 2.

According to one or more embodiments, the host may include at least one compound among compounds H1 to H26:

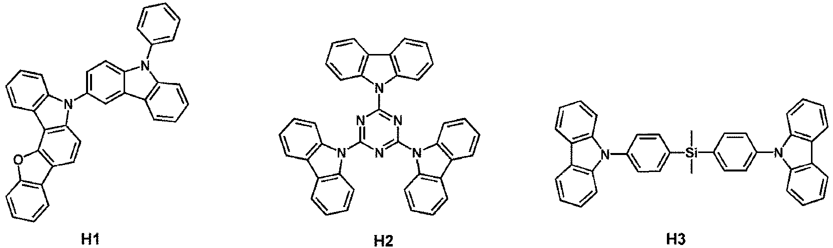

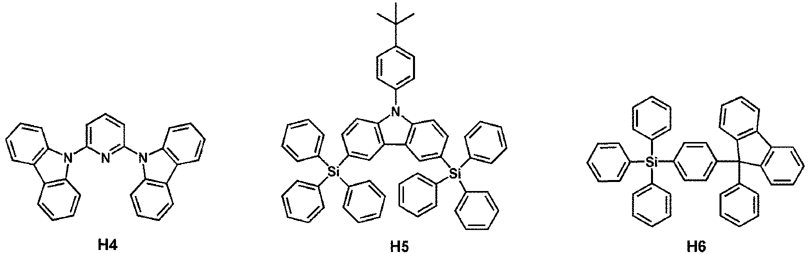

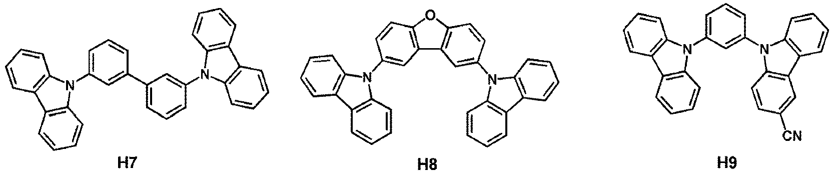

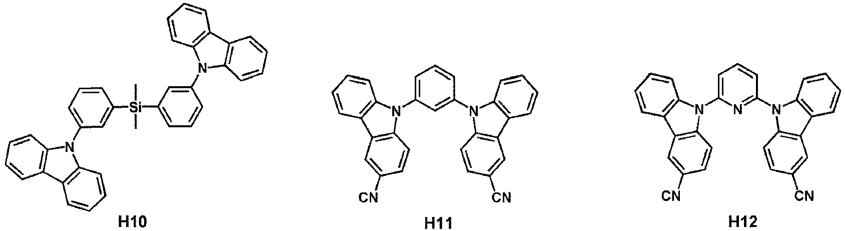

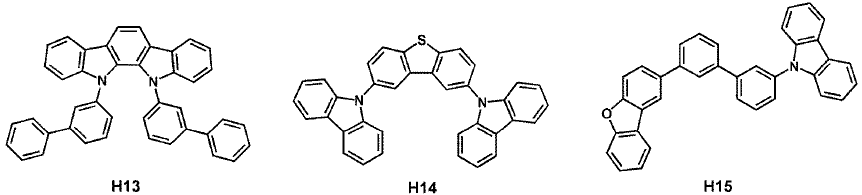

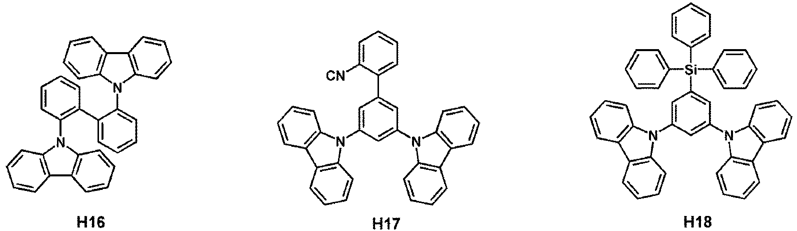

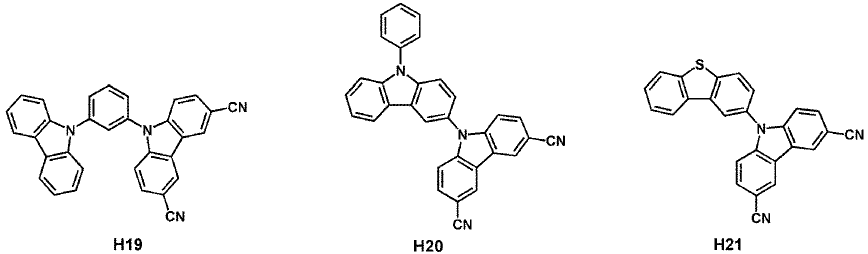

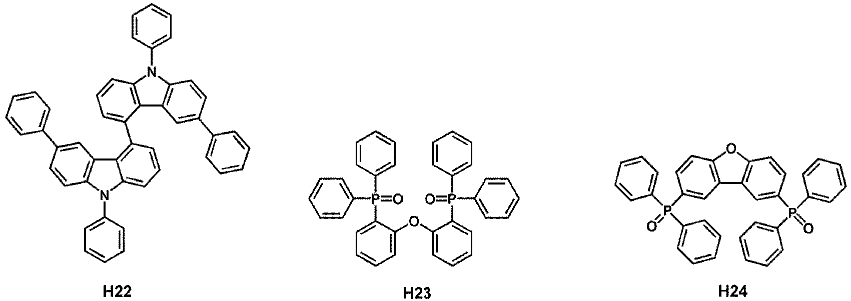

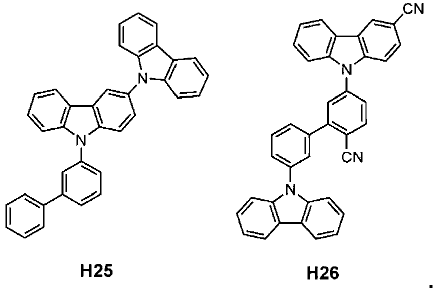

Alternatively, the host may be one of the following compounds:

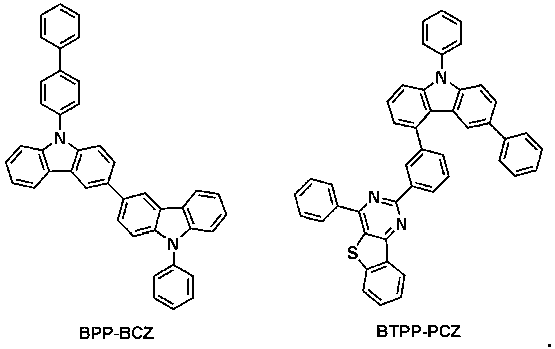

According to one or more embodiments, the host may consist of one kind of compound. For example, the one kind of compound may be a first material (hole-transporting host) or a second material (electron-transporting host) as described herein.

According to one or more embodiments, the host may include two or more kinds of compounds. For example, the host may include two or more different hole-transporting hosts, two or more different electron-transporting hosts, or a combination of one or more hole-transporting hosts and one or more electron-transporting hosts.

### Emitter in emission layer

The emitter includes at least one of the heterocyclic compounds represented by Formula 1.

### Sensitizer in emission layer

According to one or more embodiments, the sensitizer may include a phosphorescent compound.

According to one or more embodiments, the phosphorescent compound may include an organometallic compound including at least one kind of metal.

According to one or more embodiments, the organometallic compound may include at least one kind of metal (M₁₁) selected from transition metals, and an organic ligand (L₁₁), wherein L₁₁ and M₁₁ may form one cyclometallated ring, two cyclometallated rings, three cyclometallated rings, or four cyclometallated rings.

According to one or more embodiments, the organometallic compound may be represented by Formula 101.

Formula 101 M11(L11)n11(L12)n12

In Formula 101,
M₁₁ may be a transition metal,
L₁₁ may be a ligand represented by any one of Formulae 1-1 to 1-4,
L₁₂ may be a monodentate ligand or a bidentate ligand,
n11 may be 1, and
n12 may be 0, 1, or 2, 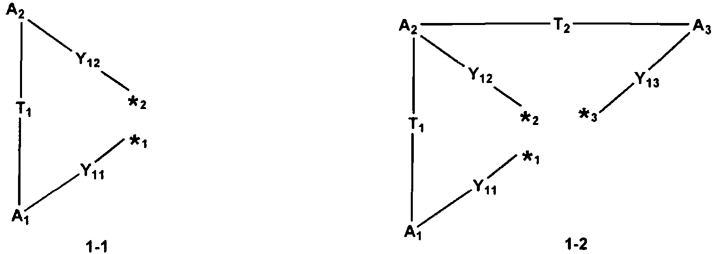 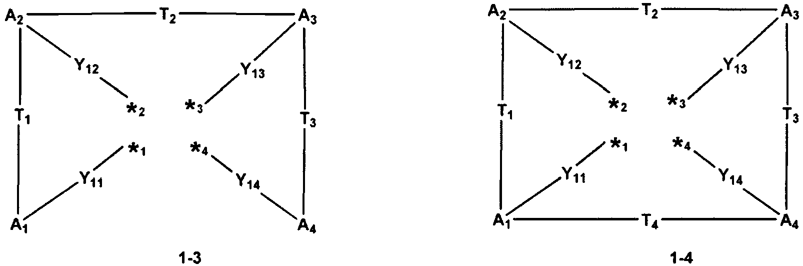
wherein, in Formulae 1-1 to 1-4,
A₁ to A₄ may each independently be a substituted or unsubstituted C₅-C₃₀ carbocyclic group, a substituted or unsubstituted C₁-C₃₀ heterocyclic group, or a non-cyclic group,
Y₁₁ to Y₁₄ may each independently be a chemical bond, O, S, N(R₉₁), B(R₉₁), P(R₉₁), or C(R₉₁)(R₉₂),
T₁ to T₄ may each independently be a single bond, a double bond, *-N(R₉₃)-*', *-B(R₉₃)-*', *-P(R₉₃)-*', *-C(R₉₃)(R₉₄)-*', *-Si(R₉₃)(R₉₄)-*', *-Ge(R₉₃)(R₉₄)-*', *-S-*', *-Se-*', *-O-*', *-C(=O)-*', *-S(=O)-*', *-S(=O)₂-*', *-C(R₉₃)=*', *=C(R₉₃)-*', *-C(R₉₃)=C(R₉₄)-*', *-C(=S)-*', or *-C≡C-*',
a substituent of the substituted C₅-C₃₀ carbocyclic group, a substituent of the substituted C₁-C₃₀ heterocyclic group, and R₉₁ to R₉₄ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), - C(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂), or -P(=S)(Q₁)(Q₂), wherein the substituent of the substituted C₅-C₃₀ carbocyclic group and the substituent of the substituted C₁-C₃₀ heterocyclic group are not hydrogen,
*₁, *₂, *₃, and *₄ each indicate a binding site to M₁₁, and
Q₁ to Q₃ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic heterocondensed polycyclic group; or
a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, - F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof.

According to one or more embodiments, the transition metal may be platinum (Pt), palladium (Pd), gold (Au), iridium (Ir), osmium (Os), titanium (Ti), zirconium (Zr), hafnium (Hf), europium (Eu), terbium (Tb), thulium (Tm), or rhodium (Rh).

According to one or more embodiments, the sensitizer may include at least one of compounds P1 to P52:

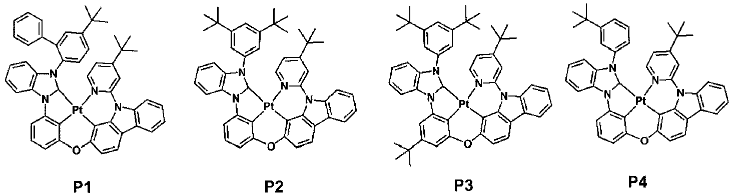

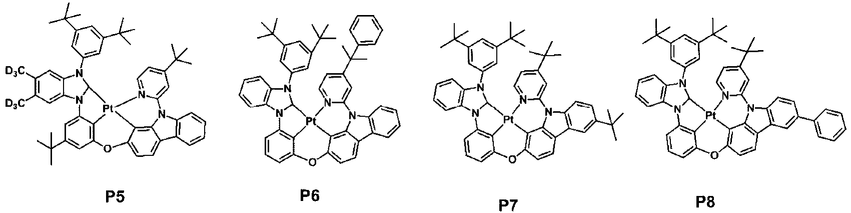

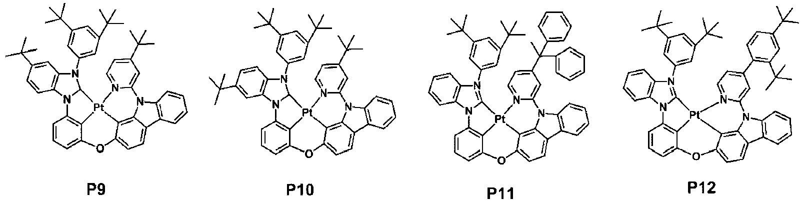

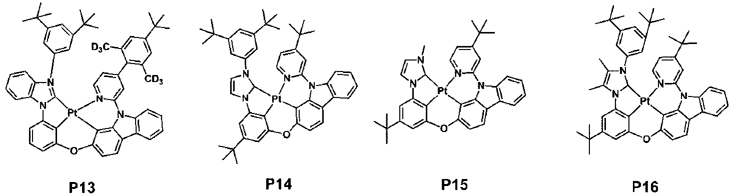

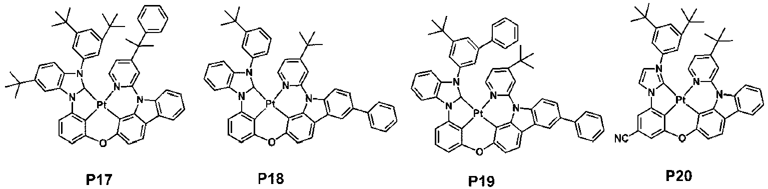

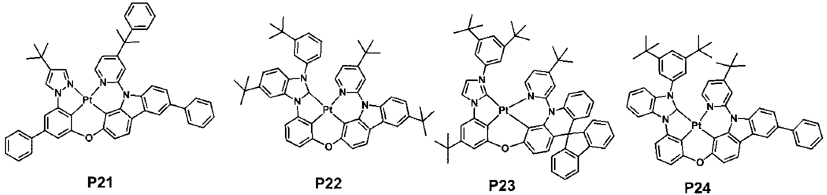

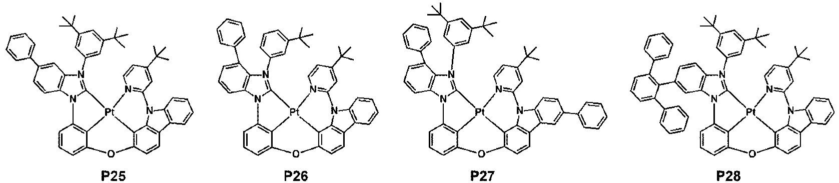

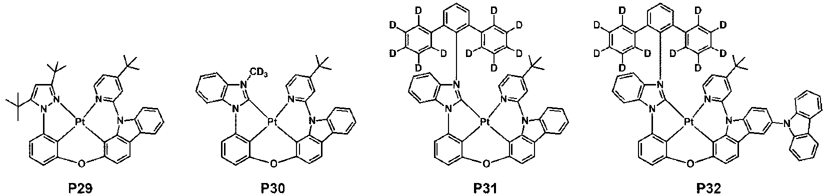

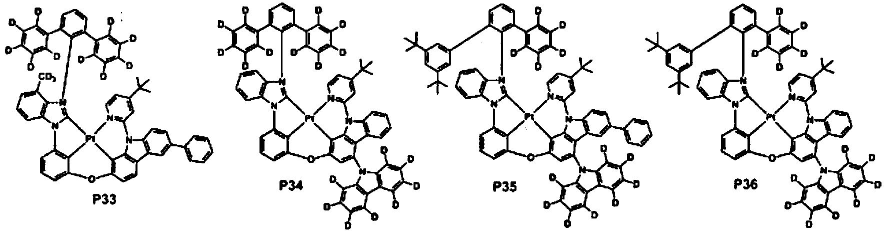

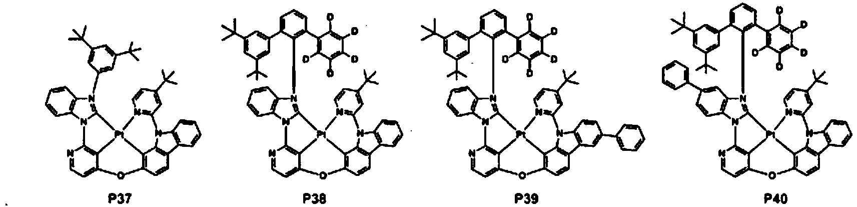

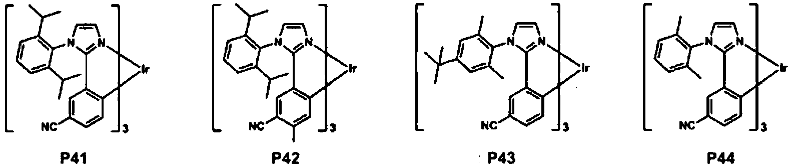

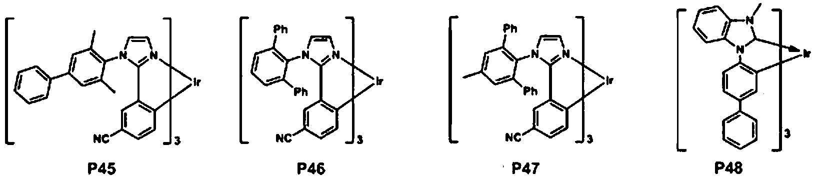

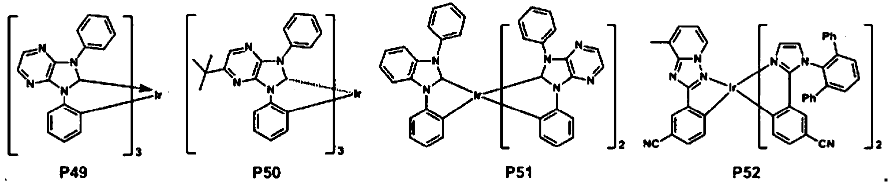

According to one or more embodiments, the sensitizer may include the following compound:

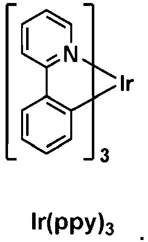

According to one or more embodiments, the sensitizer may include a delayed fluorescence compound.

According to one or more embodiments, the delayed fluorescence compound may be represented by Formula 101 or 102:

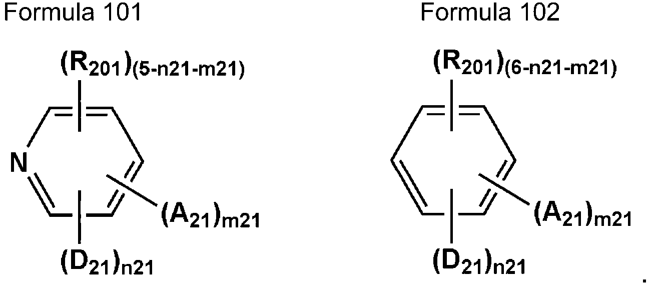

In Formulae 101 and 102,
A₂₁ may be an acceptor group,
D₂₁ may be a donor group,
m21 may be 1, 2, or 3, and n21 may be 1, 2, or 3,
in Formula 101, the sum of n21 and m21 may be 5 or less, and in Formula 102, the sum of n21 and m21 may be 6 or less;
each R₂₀₁ may independently be hydrogen, deuterium, -F, -Cl, -Br, -I, - SF₅, a hydroxyl group, a cyano group, a nitro group, an amino group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -C(Q₁)(Q₂)(Q₃), - B(Q₁)(Q₂), -N(Q₁)(Q₂), -P(Q₁)(Q₂), -C(=O)(Q₁), -S(=O)(Q₁), -S(=O)₂(Q₁), - P(=O)(Q₁)(Q₂), or -P(=S)(Q₁)(Q₂), wherein a plurality of R₂₀₁ may be optionally bonded to each other to form a substituted or unsubstituted C₅-C₃₀ carbocyclic group or a substituted or unsubstituted C₁-C₃₀ heterocyclic group, and
Q₁ to Q₃ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic heterocondensed polycyclic group; or
   a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, - F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof.

In one or more embodiments, in Formulae 101 and 102, D₂₁ may be a substituted or unsubstituted π electron-deficient nitrogen-free cyclic group.

According to one or more embodiments, the π electron-deficient nitrogen-free cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; or a condensed cyclic group of two or more π electron-deficient nitrogen-free cyclic groups, but embodiments are not limited thereto.

For example, in Formulae 101 and 102, A₂₁ may be:
-F, a cyano group, or a π electron-deficient nitrogen-containing cyclic group;
a C₁-C₆₀ alkyl group, a π electron-deficient nitrogen-containing cyclic group, or a π electron-deficient nitrogen-free cyclic group, each substituted with at least one of -F or a cyano group; or
a π electron-deficient nitrogen-containing cyclic group that is substituted with at least one of deuterium, a C₁-C₆₀ alkyl group, a π electron-deficient nitrogen-containing cyclic group, or a π electron-deficient nitrogen-free cyclic group.

According to one or more embodiments, the π electron-deficient nitrogen-free cyclic group is as described herein.

The term "π electron-deficient nitrogen-containing cyclic group" used herein refers to a cyclic group having at least one *-N=*' moiety, and, for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, a benzimidazolobenzimidazole group; or a condensed cyclic group in which two or more π electron-deficient nitrogen-containing cyclic groups are condensed with each other.

According to one or more embodiments, the amount of the sensitizer in the organic layer may be greater than the amount of the emitter in the organic layer. For example, the sensitizer and the emitter may have a volume ratio of about 30:0.1 to about 10:3 or about 10:0.1 to about 20:5. For example, the sensitizer and the emitter may have a weight ratio of about 10:0.1 to about 20:5. According to one or more embodiments, the host and the sensitizer in the organic layer may have a volume ratio of about 60:40 to about 95:5 or about 70:30 to about 90:10. According to one or more embodiments, the host and the sensitizer may have a weight ratio of about 60:40 to about 95:5. By satisfying the amount range as described above, the organic light-emitting device may have improved luminescence efficiency and/or lifespan characteristics.

FIG. 1 is a schematic cross-sectional view of an organic light-emitting device 10 according to one or more embodiments. Hereinafter, the structure and manufacturing method of the organic light-emitting device 10 according to one or more embodiments will be described in further detail with reference to FIG. 1. The organic light-emitting device 10 may have a structure in which a first electrode 11, an organic layer 15, and a second electrode 19 are sequentially stacked.

A substrate may be further disposed under the first electrode 11 or on the second electrode 19. The substrate may be a substrate commonly used in organic light-emitting devices, for example, a glass substrate or a transparent plastic substrate, which have excellent mechanical strength, thermal stability, transparency, surface smoothness, ease of handling, and/or water repellency.

The first electrode 11 may be formed by, for example, depositing or sputtering, onto the substrate, a material for forming the first electrode 11. The first electrode 11 may be an anode. The material for forming the first electrode 11 may be selected from materials with a high work function for easy hole injection. The first electrode 11 may be a reflective electrode, a transflective electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be a metal, such as magnesium (Mg), silver (Ag), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 may be disposed on the first electrode 11.

The organic layer 15 may include a hole transport region, an emission layer, and an electron transport region.

The hole transport region may be disposed between the first electrode 11 and the emission layer.

The hole transport region may include a hole transport layer, a hole transport layer, an electron-blocking layer, a buffer layer, or a combination thereof.

The hole transport region may include only either a hole transport layer or a hole transport layer. In some embodiments, the hole transport region may have a hole transport layer/hole transport layer structure or a hole transport layer/hole transport layer/electron-blocking layer structure, in which respective layers of each structure are sequentially stacked in the stated order from the first electrode 11.

When the hole transport region includes a hole injection layer, the hole injection layer can be formed on the first electrode 11 using various methods such as vacuum deposition, spin coating, casting, and Langmuir-Blodgett (LB) method, but embodiments are not limited thereto.

When a hole injection layer is formed by vacuum deposition, the deposition conditions may vary depending on a compound that is used as a material for forming the hole injection layer, and the structure and thermal characteristics of a hole injection layer to be formed, and may include a deposition temperature of about 100 °C to about 500 °C, a vacuum degree of about 10⁻⁸ torr to about 10⁻³ torr, and a deposition rate of about 0.01 angstroms per second (Å/sec) to about 100 Å/sec. However, the deposition conditions are not limited thereto.

When a hole injection layer is formed by spin coating, the coating conditions may vary according to a compound that is used as a material for forming the hole injection layer, and the structure and thermal characteristics of the hole injection layer, and may include a coating speed of about 2,000 revolutions per minute (rpm) to about 5,000 rpm and a heat treatment temperature for removing a solvent after coating of about 80 °C to about 200 °C. However, the coating conditions are not limited thereto.

The conditions for forming the hole transport layer and the electron-blocking layer may be referred to the description provided for the conditions for forming the hole injection layer.

The hole transport region may include at least one of m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, or a compound represented by Formula 202, but embodiments are not limited thereto: 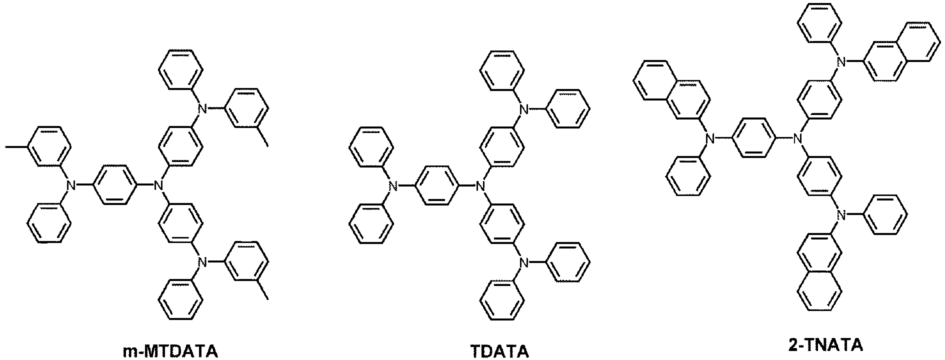 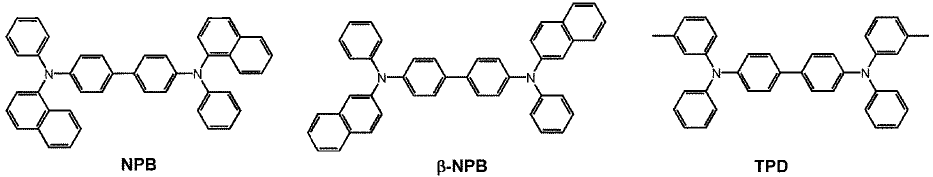 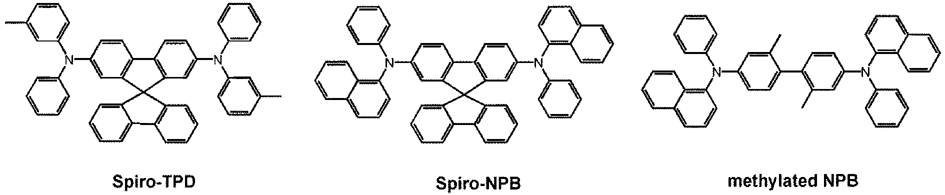 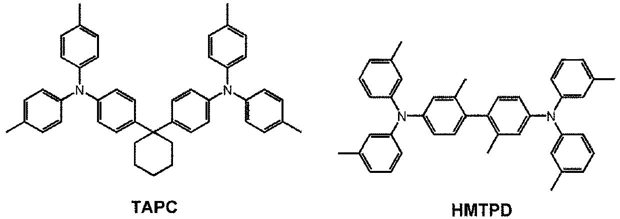 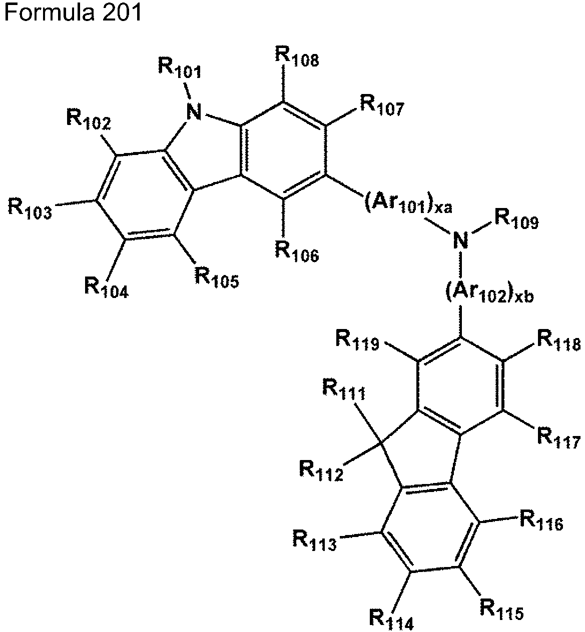 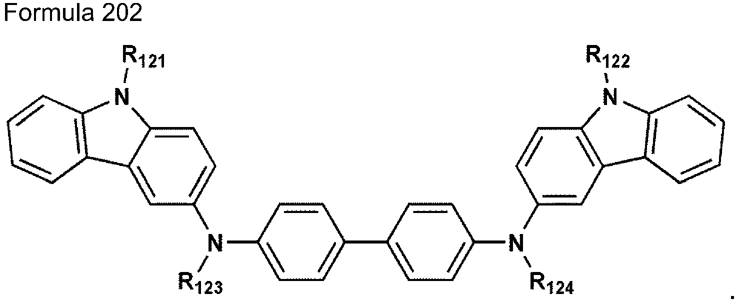 Ar₁₀₁ and Ar₁₀₂ in Formula 201 may each independently be:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1, and xb may be 0, but xa and xb are not limited thereto.

R₁₀₁ to R₁₀₈, R₁₁₁ to R₁₁₉, and R₁₂₁ to R₁₂₄ in Formulae 201 and 202 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, or a hexyl group), a C₁-C₁₀ alkoxy group (for example, a methoxy group, an ethoxy group, a propoxy group, a butoxy group, or a pentoxy group), or a C₁-C₁₀ alkylthio group;
a C₁-C₁₀ alkyl group, a C₁-C₁₀ alkoxy group, or a C₁-C₁₀ alkylthio group, each substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof;
a phenyl group, a naphthyl group, an anthracenyl group, a fluorenyl group, or a pyrenyl group; or
a phenyl group, a naphthyl group, an anthracenyl group, a fluorenyl group, or a pyrenyl group, each substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, or a combination thereof, but embodiments are not limited thereto.

R₁₀₉ in Formula 201 may be:
a phenyl group, a naphthyl group, an anthracenyl group, or a pyridinyl group; or
a phenyl group, a naphthyl group, an anthracenyl group, or a pyridinyl group, each substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

According to one or more embodiments, the compound represented by Formula 201 may be represented by Formula 201A, but embodiments are not limited thereto:

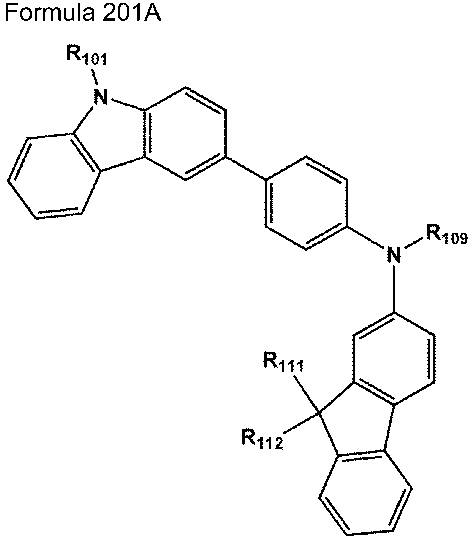

R₁₀₁, R₁₁₁, R₁₁₂, and R₁₀₉ in Formula 201A may each be as described herein.

For example, the compound represented by Formula 201 and the compound represented by Formula 202 may include, but are not limited to, compounds HT1 to HT20:

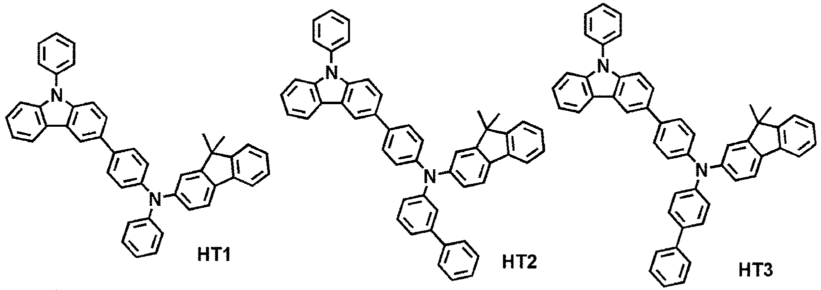

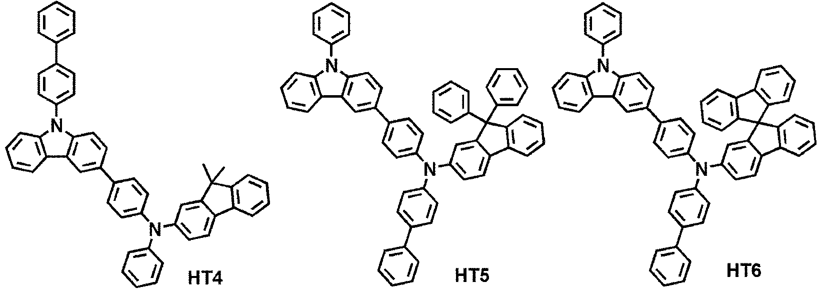

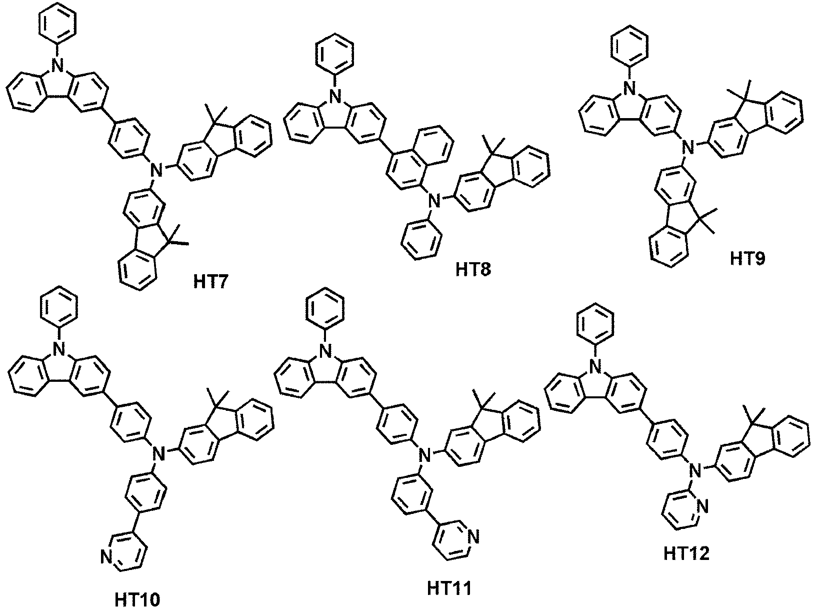

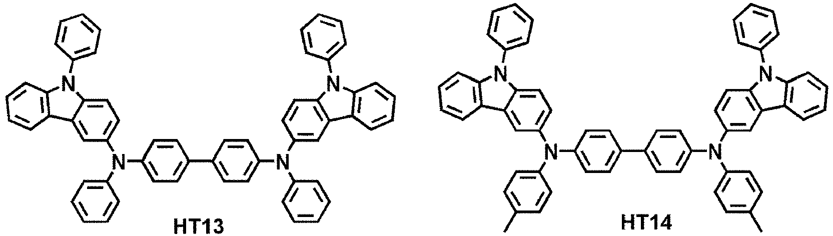

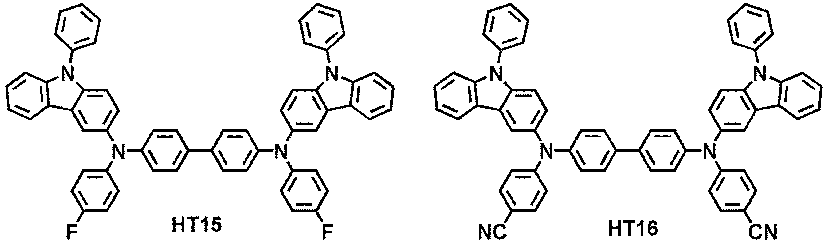

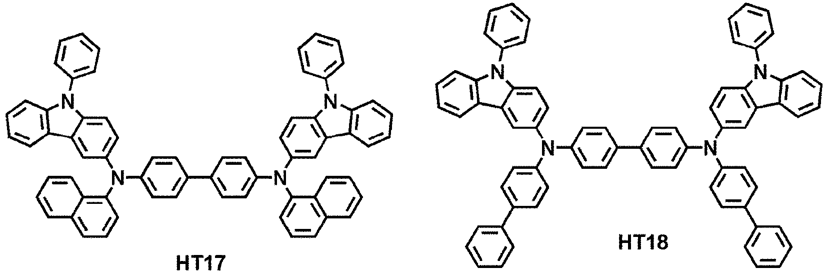

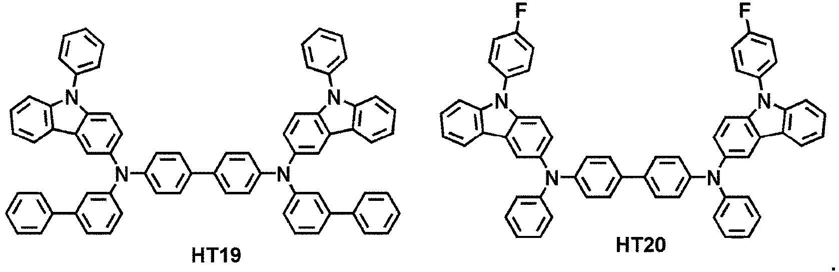

A thickness of the hole transport region may be about 50 Å to about 10,000 Å, for example, about 100 Å to about 1,000 Å. When the hole transport region includes at least one of a hole injection layer and a hole transport layer, the thickness of the hole injection layer may be about 100 Å to about 10,000 Å, for example, about 100 Å to about 1,000 Å, and the thickness of the hole transport layer may be about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to the above-described materials, a charge-generation material for improving conductivity. The charge-generation material may be homogeneously or non-homogeneously dispersed in the hole transport region.

The charge-generation material may be, for example, a p-dopant. The p-dopant may be, but is not limited to, one of a quinone derivative, a metal oxide, or a cyano group-containing compound. Non-limiting examples of the p-dopant include a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenum oxide; or a cyano group-containing compound, such as compound HT-D1 or F12, but embodiments are not limited thereto:

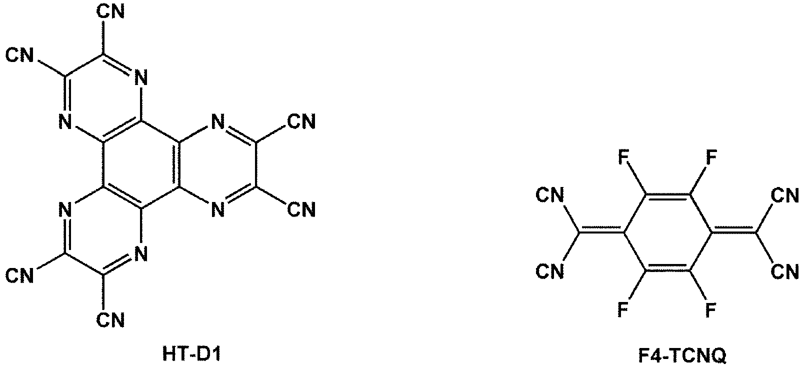

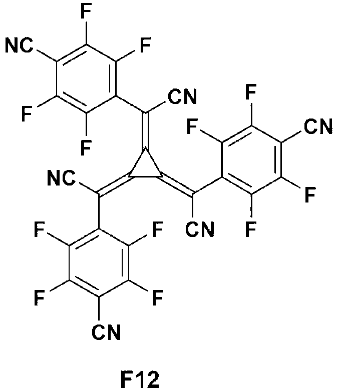

The hole transport region may include a buffer layer.

The buffer layer may compensate for an optical resonance distance according to a wavelength of light emitted from an emission layer, and thus, efficiency of a formed organic light-emitting device may be improved.

In some embodiments, when the hole transport region includes an electron-blocking layer, a material for forming the electron-blocking layer may be selected from, but is not limited to, the above-described materials that may be used in the hole transport region and a host material described herein. For example, when the hole transport region includes an electron-blocking layer, a material for forming the electron-blocking layer may be mCP, which will be described herein.

The emission layer (EML) may be formed on the hole transport region by vacuum deposition, spin coating, casting, LB method, or the like. When the emission layer is formed by vacuum deposition or spin coating, the deposition or coating conditions may generally be similar to those applied in forming the hole injection layer although the deposition or coating conditions may vary according to a material that is used to form the emission layer.

When the organic light-emitting device is a full-color organic light-emitting device, the emission layer may be patterned into a red emission layer, a green emission layer, and/or a blue emission layer. In one or more embodiments, the emission layer may have a structure in which a red emission layer, a green emission layer, and/or a blue emission layer are stacked, and thus, various modifications such as emission of white light are possible.

When the emission layer includes a host and a dopant, the amount of the dopant may generally be about 0.01 parts by weight to about 15 parts by weight with respect to 100 parts by weight of the host, but embodiments are not limited thereto.

A thickness of the emission layer may be about 100 Å to about 1,000 Å, for example, about 200 Å to about 600 Å. When the thickness of the emission layer is within the range described above, excellent luminescence characteristics may be obtained without a substantial increase in driving voltage.

Next, an electron transport region may be located on the emission layer.

The electron transport region may include a hole-blocking layer, an electron transport layer, an electron injection layer, or a combination thereof.

For example, the electron transport region may have a hole-blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole-blocking layer, the electron transport layer, and the electron injection layer which constitute the electron transport region may be referred to the description provided for the conditions for forming the hole injection layer.

When the electron transport region includes a hole-blocking layer, the hole-blocking layer may include, for example, at least one of 2,9-dimethyl-4,7-diphenyl-1,10-phenanthroline (BCP), 4,7-diphenyl-1,10-phenanthroline (Bphen), or bis(2-methyl-8-quinolinolato-N1,O8)-(1,1'-biphenyl-4-olato)aluminum (BAlq), but embodiments are not limited thereto:

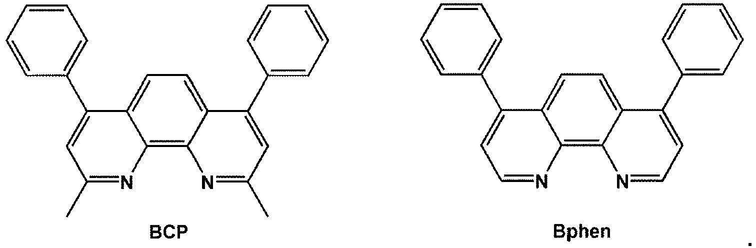

A thickness of the hole-blocking layer may be about 20 Å to about 1,000 Å, for example, about 30 Å to about 300 Å. When the thickness of the hole-blocking layer is within these ranges, excellent hole-blocking characteristics may be obtained without a substantial increase in driving voltage.

The electron transport layer may further include at least one of BCP, Bphen, tris(8-hydroxy-quinolinato)aluminum (Alq₃), BAlq, 3-(4-biphenylyl)-4-phenyl-5-tert-butylphenyl-1,2,4-triazole (TAZ), or 4-(naphthalen-1-yl)-3,5-diphenyl-4H-1,2,4-triazole (NTAZ), but embodiments are not limited thereto:

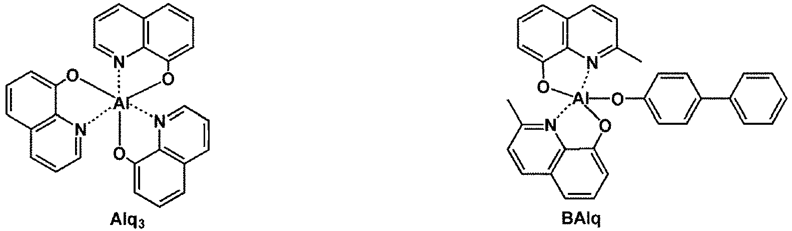

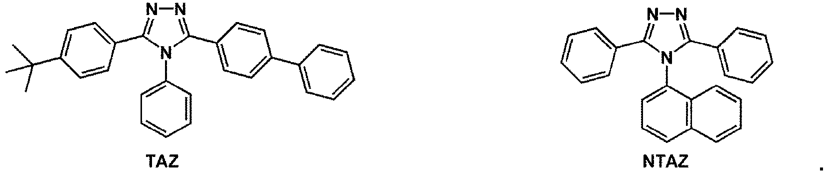

In one or more embodiments, the electron transport layer may include at least one of ET1 to ET25, but embodiments are not limited thereto:

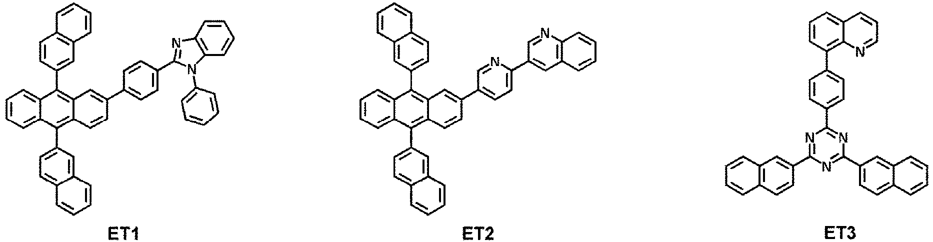

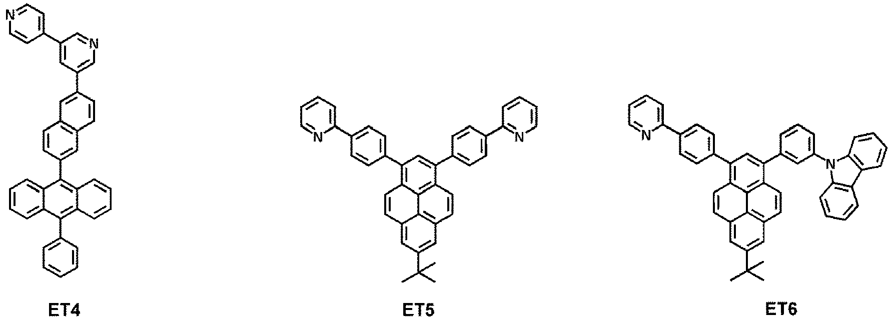

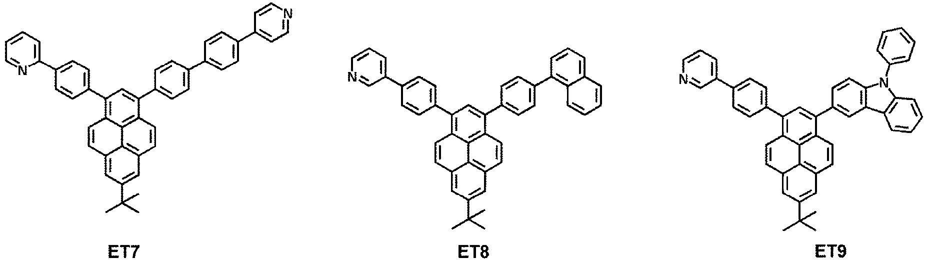

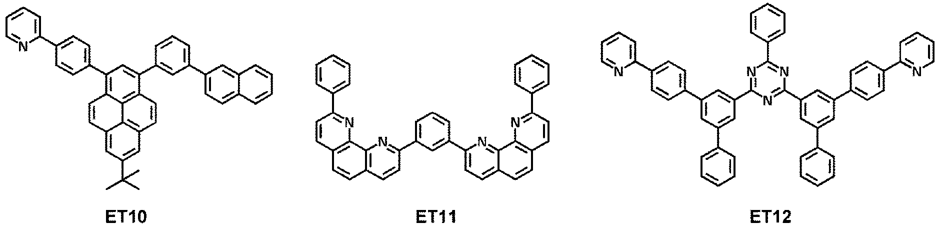

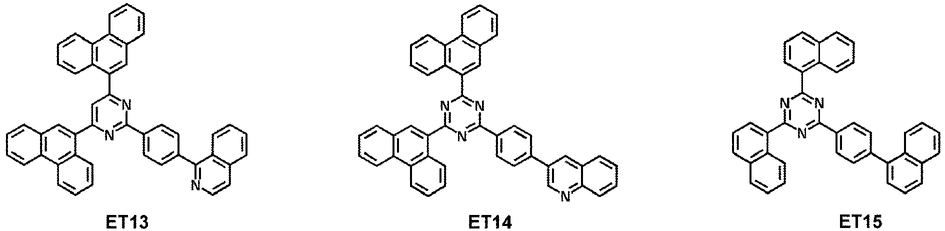

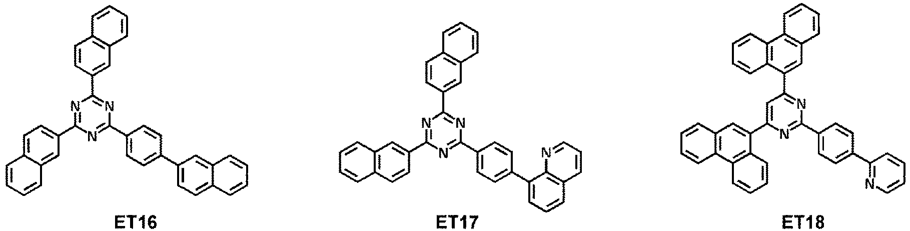

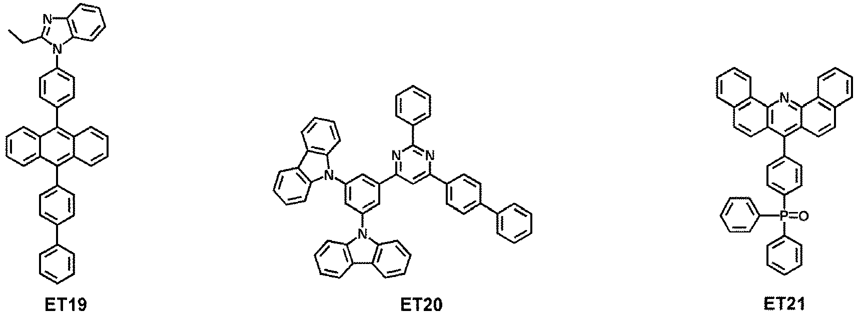

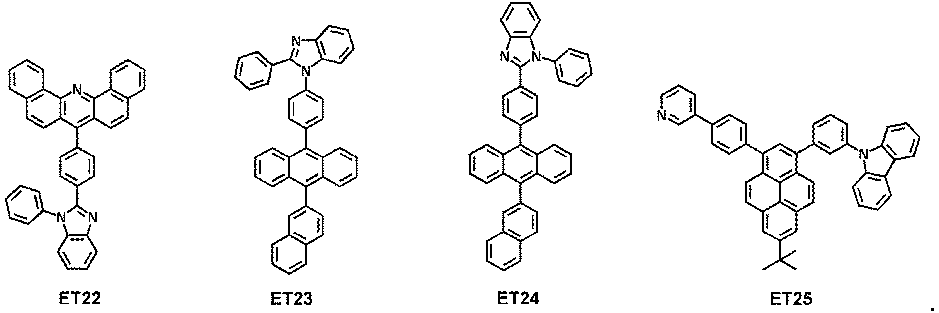

A thickness of the electron transport layer may be about 100 Å to about 1,000 Å, for example, about 150 Å to about 500 Å. When the thickness of the electron transport layer is within these ranges, satisfactory electron transporting characteristics may be obtained without a substantial increase in driving voltage.

The electron transport layer may further include a metal-containing material, in addition to the material as described herein.

The metal-containing material may include a Li complex. The Li complex may include, for example, compound ET-D1 (lithium quinolate, LiQ) or ET-D2, but embodiments are not limited thereto:

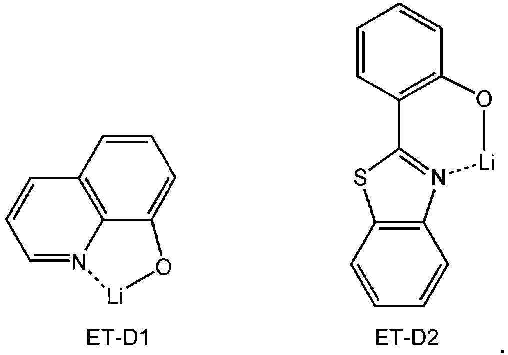

The electron transport region may include an electron injection layer that facilitates injection of electrons from the second electrode 19.

The electron injection layer may include LiF, NaCl, CsF, Li₂O, BaO, or a combination thereof.

The thickness of the electron injection layer may be about 1 Å to about 100 Å, for example, about 3 Å to about 90 Å. When the thickness of the electron injection layer is within the range as described above, satisfactory electron injection characteristics may be obtained without a substantial increase in driving voltage.

The second electrode 19 may be disposed on the organic layer 15. The second electrode 19 may be a cathode. A material for forming the second electrode 19 may be a metal, an alloy, an electrically conductive compound, or a combination thereof, which have a relatively low work function. For example, lithium (Li), magnesium (Mg), silver (Ag), aluminum (Al), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, various modifications, such as formation of a transmissive second electrode using ITO or IZO, is possible.

The organic light-emitting device has been described with reference to FIG. 1, but embodiments are not limited thereto.

According to another aspect, an electronic apparatus may include the organic light-emitting device.

The electronic apparatus may further include a thin-film transistor in addition to the organic light-emitting device as described herein. The thin-film transistor may include a source electrode, a drain electrode, and an active layer, wherein any one of the source electrode or the drain electrode may be electrically connected to any one of the first electrode or the second electrode of the organic light-emitting device.

According to another aspect, a diagnostic composition is provided, including at least one of the heterocyclic compounds represented by Formula 1.

The diagnostic composition may contain at least one heterocyclic compound represented by Formula 1.

Since the heterocyclic compound represented by Formula 1 can provide high luminescence efficiency, a diagnostic composition including at least one of the heterocyclic compounds represented by Formula 1 can have high diagnostic efficiency.

The diagnostic composition may be used in various applications including a diagnosis kit, a diagnosis reagent, a biosensor, a biomarker, or the like, but embodiments are not limited thereto.

The term "C₁-C₆₀ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an iso-amyl group, a hexyl group, or the like. The term "C₁-C₆₀ alkylene group" as used herein refers to a divalent group having the same structure as the C₁-C₆₀ alkyl group.

Other examples of the C₁-C₆₀ alkyl group, the C₁-C₂₀ alkyl group, and/or the C₁-C₁₀ alkyl group include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched C₆ alkyl group, for example, a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group), and non-limiting examples thereof include a methoxy group, an ethoxy group, an isopropyloxy group, or the like.

Other examples of the C₁-C₆₀ alkoxy group, the C₁-C₂₀ alkoxy group, or the C₁-C₁₀ alkoxy group as used herein are a methoxy group, an ethoxy group, a propoxy group, a butoxy group, a pentoxy group, or the like.

The term "C₁-C₆₀ alkylthio group" as used herein refers to a monovalent group represented by -SA_{101'} (wherein A_{101'} is the C₁-C₆₀ alkyl group).

The term "C₂-C₆₀ alkenyl group" as used herein refers to a structure containing at least one carbon-carbon double bond in the middle or at the end of the C₂-C₆₀ alkyl group, and non-limiting examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and non-limiting examples thereof include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon group having 3 to 10 carbon atoms, and non-limiting examples thereof include a cyclopropyl group, a cyclobutyl group, a cyclopentyl group, a cyclohexyl group, a cycloheptyl group, or the like. The term "C₃-C₁₀ cycloalkylene group" as used herein refers to a divalent group having the same structure as the C₃-C₁₀ cycloalkyl group.

Other examples of the C₃-C₁₀ cycloalkyl group as used herein may include a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1]hexyl group, a bicyclo[2.2.1]heptyl(norbornanyl) group, a bicyclo[2.2.2]octyl group, or the like.

The term "C₁-C₁₀ heterocycloalkyl group" as used herein refers to a monovalent saturated group having at least one heteroatom selected from B, N, O, P, Si, S, Se, and Ge as a ring-forming atom and 1 to 10 carbon atoms as ring-forming atom(s), and non-limiting examples thereof include a tetrahydrofuranyl group, a tetrahydrothiophenyl group, or the like. The term "C₁-C₁₀ heterocycloalkylene group" as used herein refers to a divalent group having the same structure as the C₁-C₁₀ heterocycloalkyl group.

Other examples of the C₁-C₁₀ heterocycloalkyl group include a silolanyl group, a silinanyl group, tetrahydrofuranyl group, a tetrahydro-2H-pyranyl group, a tetrahydrothiophenyl group, or the like.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from B, N, O, P, Si, S, Se, and Ge as a ring-forming atom, 1 to 10 carbon atoms as ring-forming atom(s), and at least one double bond in its ring. Non-limiting examples of the C₁-C₁₀ heterocycloalkenyl group include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused with each other.

The term "C₇-C₆₀ alkyl aryl group" as used herein refers to a C₆-C₆₀ aryl group that is substituted with at least one C₁-C₆₀ alkyl group. The term "C₇-C₆₀ aryl alkyl group" as used herein refers to a C₁-C₆₀ alkyl group that is substituted with at least one C₆-C₆₀ aryl group.

The term "C₁-C₆₀ heteroaryl group" as used herein refers to a monovalent group having a cyclic heteroaromatic system that has at least one heteroatom selected from B, N, O, P, Si, S, Se, and Ge as a ring-forming atom, and 1 to 60 carbon atoms as ring-forming atom(s). The term "C₁-C₆₀ heteroarylene group" as used herein refers to a divalent group having a cyclic heteroaromatic system that has at least one heteroatom selected from B, N, O, P, Si, S, Se, and Ge as a ring-forming atom, and 1 to 60 carbon atoms as ring-forming atom(s). Non-limiting examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the rings may be fused with each other.

The term "C₂-C₆₀ alkyl heteroaryl group" as used herein refers to a C₁-C₆₀ heteroaryl group that is substituted with at least one C₁-C₆₀ alkyl group. The term "C₂-C₆₀ heteroaryl alkyl group" as used herein refers to a C₁-C₆₀ alkyl group that is substituted with at least one C₁-C₆₀ heteroaryl group.

The term "C₆-C₆₀ aryloxy group" as used herein refers to -OA₁₀₂ (wherein A₁₀₂ is the C₆-C₆₀ aryl group), and the term "C₆-C₆₀ arylthio group" as used herein refers to -SA₁₀₃ (wherein A₁₀₃ is the C₆-C₆₀ aryl group).

The term "C₁-C₆₀ heteroaryloxy group" as used herein indicates -OA₁₀₄ (wherein A₁₀₄ is a C₁-C₆₀ heteroaryl group), and the term "C₁-C₆₀ heteroarylthio group" as used herein indicates -SA₁₀₅ (wherein A₁₀₅ is the C₁-C₆₀ heteroaryl group).

The term "monovalent non-aromatic condensed polycyclic group" as used herein refers to a monovalent group (for example, having 8 to 60 carbon atoms) having two or more rings condensed with each other, only carbon atoms as ring-forming atoms, and no aromaticity in its entire molecular structure. Non-limiting examples of the monovalent non-aromatic condensed polycyclic group include a fluorenyl group or the like. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed with each other, a heteroatom selected from B, N, O, P, Si, S, Se, and Ge, other than carbon atoms, as a ring-forming atom, and no aromaticity in its entire molecular structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Non-limiting examples of the "C₅-C₃₀ carbocyclic group (unsubstituted or substituted with at least one R₁₀ₐ)" as used herein include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a silole group, a fluorene group, or the like (each unsubstituted or substituted with at least one R₁₀ₐ).

The term "C₁-C₃₀ heterocyclic group" as used herein refers to a saturated or unsaturated heterocyclic group having, as a ring-forming atom, at least one heteroatom selected from B, N, O, Si, P, S, Se, and Ge other than 1 to 30 carbon atoms as ring-forming atom(s). The C₁-C₃₀ heterocyclic group may be a monocyclic group or a polycyclic group. Non-limiting examples of the "C₁-C₃₀ heterocyclic group (unsubstituted or substituted with at least one R₁₀ₐ)" as used herein include a thiophene group, a furan group, a pyrrole group, a silole group, borole group, a phosphole group, a selenophene group, a germole group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, or the like (each unsubstituted or substituted with at least one R₁₀ₐ).

As used herein, "TMS" represents * -Si(CH₃)₃, and "TMG" represents * - Ge(CH₃)₃.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, the substituted monovalent non-aromatic heterocondensed polycyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, and the substituted divalent non-aromatic heterocondensed polycyclic group is each independently:
deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₁)(Q₁₂)(Q₁₃), -Ge(Q₁₁)(Q₁₂)(Q₁₃), -C(=O)(Q₁₁), - S(=O)(Q₁₁), -S(=O)₂(Q₁₁), -B(Q₁₁)(Q₁₂), -P(Q₁₁)(Q₁₂), -P(=O)(Q₁₁)(Q₁₂), - P(=S)(Q₁₁)(Q₁₂), or a combination thereof,
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₁)(Q₂₂)(Q₂₃), -Ge(Q₂₁)(Q₂₂)(Q₂₃), -C(=O)(Q₂₁), - S(=O)(Q₂₁), -S(=O)₂(Q₂₁), -B(Q₂₁)(Q₂₂), -P(Q₂₁)(Q₂₂), -P(=O)(Q₂₁)(Q₂₂), - P(=S)(Q₂₁)(Q₂₂), or a combination thereof,
-N(Q₃₁)(Q₃₂), -Si(Q₃₁)(Q₃₂)(Q₃₃), -Ge(Q₃₁)(Q₃₂)(Q₃₃), -C(=O)(Q₃₁), - S(=O)(Q₃₁), -S(=O)₂(Q₃₁), -B(Q₃₁)(Q₃₂), -P(Q₃₁)(Q₃₂), -P(=O)(Q₃₁)(Q₃₂), or - P(Q₃₁)(Q₃₂); or
a combination thereof, and
Q₁ to Q₃, Q₁₁ to Q₁₃, Q₂₁ to Q₂₃, and Q₃₁ to Q₃₃ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, or
   a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, -F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof.

Hereinafter, compounds and organic light-emitting devices, according to one or more embodiments, will be described in further detail with reference to Synthesis Example and Examples. However, the following examples are not intended to limit the scope of the disclosure. The wording "'B' was used instead of 'A'" used in describing Synthesis Examples means that an amount of 'A' used was identical to an amount of 'B' used, in terms of a molar equivalent.

### EXAMPLES

### Synthesis Examples

### Synthesis Example 1: Synthesis of compound 25

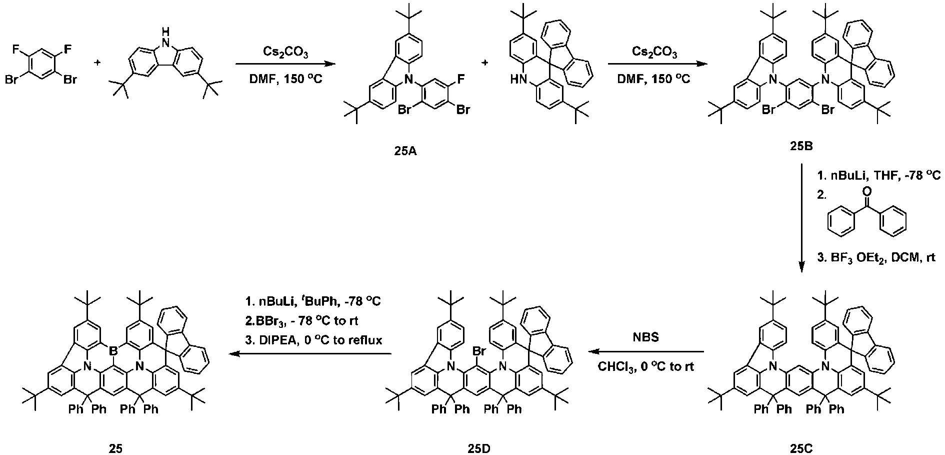

### (1) Synthesis of compound 25A

1,5-dibromo-2,4-difluorobenzene (2.0 grams (g), 7.36 millimoles (mmol)), 3,6-di-tert-butyl-9H-carbazole (2.2 g, 8.01 mmol), and cesium carbonate (2.9 g, 8.83 mmol) were mixed with 35 milliliters (mL) of dimethylformamide (DMF), stirred under reflux at 150°C for 6 hours, and then cooled to room temperature. Water was added to the mixture obtained therefrom and the resultant solution was washed using dichloromethane. The solid obtained by concentrating the organic layer under reduced pressure was purified by column chromatography (eluents: hexane and ethyl acetate) to obtain 2.3 g (58% yield) of compound 25A. The obtained compound was identified by high resolution mass spectrometry using matrix assisted laser desorption ionization (HRMS (MALDI)) and HPLC analysis.

HRMS (MALDI) calculated for C₂₆H₂₆Br₂FN: m/z 531.3074 Found: 531.3074.

### (2) Synthesis of compound 25B

Compound 25A (2.8 g, 5.27 mmol), 2,7-di-tert-butyl-10H-spiro[acridine-9,9'-fluorene] (2.6 g, 5.80 mmol), and cesium carbonate (2.1 g, 6.32 mmol) were mixed with 25 mL of dimethylformamide, stirred under at 150°C reflux for 6 hours, and then cooled to room temperature. Water was added to the mixture obtained therefrom and the resultant solution was washed using dichloromethane. The solid obtained by concentrating the organic layer under reduced pressure was purified by column chromatography (eluents: hexane and ethyl acetate) to obtain 3.6 g (71% yield) of compound 25B. The obtained compound was identified by HRMS (MALDI) and HPLC analysis.

HRMS (MALDI) calculated for C₅₉H₅₈Br₂N₂: m/z 952.2967 Found: 952.2966.

### (3) Synthesis of compound 25C

Compound 25B (3.0 g, 3.14 mmol) was mixed in 60 mL of tetrahydrofuran and then cooled to -78°C. Subsequently, butyllithium (n-butyllithium 2.5 M in hexane) (3.1 mL, 7.9 mmol) was slowly added thereto. After stirring for 3 more hours at the same temperature, benzophenone (1.7 g, 9.42 mmol) was slowly added thereto after mixing with 10 mL of tetrahydrofuran. The mixture obtained therefrom was stirred at room temperature for 18 hours, then neutralized with dilute hydrochloric acid and washed with dichloromethane. The solid obtained by depressurizing the organic layer was mixed again with dichloromethane, and then boron trifluoride-diethyl etherate (0.4 mL, 3.14 mmol) was slowly added, and the resulting mixture was stirred at room temperature for 12 hours. Water was added to the mixture obtained therefrom and the resultant solution was washed using dichloromethane. The solid obtained by concentrating the organic layer under reduced pressure was purified by column chromatography (eluents: hexane and ethyl acetate) to obtain 1.7 g of compound 25C (47% yield). The obtained compound was identified by HRMS (MALDI) and HPLC analysis.

HRMS (MALDI) calculated for C₈₅H₇₆N₂: m/z 1124.6009 Found: 1124.6010.

### (4) Synthesis of compound 25D

Compound 25C (1.9 g, 1.69 mmol) was mixed with 80 mL of chloroform, and then the temperature was lowered to 0°C while blocking light with aluminum foil. Subsequently, N-bromosuccinimide (0.3 g, 1.86 mmol) was slowly added thereto. This mixture was stirred at room temperature for 14 hours, and then water was added, followed by washing with dichloromethane. The solid obtained by concentrating the organic layer under reduced pressure was purified by column chromatography (eluents: hexane and ethyl acetate) to obtain 1.1 g (53% yield) of compound 25D. The obtained compound was identified by HRMS (MALDI) and HPLC analysis.

HRMS (MALDI) calculated for C₈₅H₇₅BrN₂: m/z 1202.5114 Found: 1202.5112.

### (5) Synthesis of compound 25

Compound 25D (2.3 g, 1.91 mmol) was mixed in 100 mL of tertbutylbenzene and then cooled to -78°C. To the mixture obtained therefrom, butyllithium (n-butyllithium 2.5 M in hexane) (1.5 mL, 3.82 mmol) was slowly added, and the mixture was stirred at the same temperature for 2 hours. Boron tribromide (1 M in dichloromethane) (4.8 mL, 4.8 mmol) was slowly added and stirred at room temperature for 18 hours. Subsequently, N,N-diisopropylethylamine (1.0 mL, 5.7 mmol) was slowly added at 0°C, and the mixture was stirred under reflux at 130°C for 4 hours. Water was added to the mixture obtained therefrom and the resultant solution was washed using dichloromethane. The solid obtained by concentrating the organic layer under reduced pressure was purified by column chromatography (eluents: hexane and ethyl acetate) to obtain 0.56 g (27% yield) of Compound 25. The obtained compound was identified by HRMS (MALDI) and HPLC analysis.

HRMS (MALDI) calculated for C₈₅H₇₃BN₂: m/z 1132.5867 Found: 1132.5868.

### Synthesis Example 2: Synthesis of compound 33

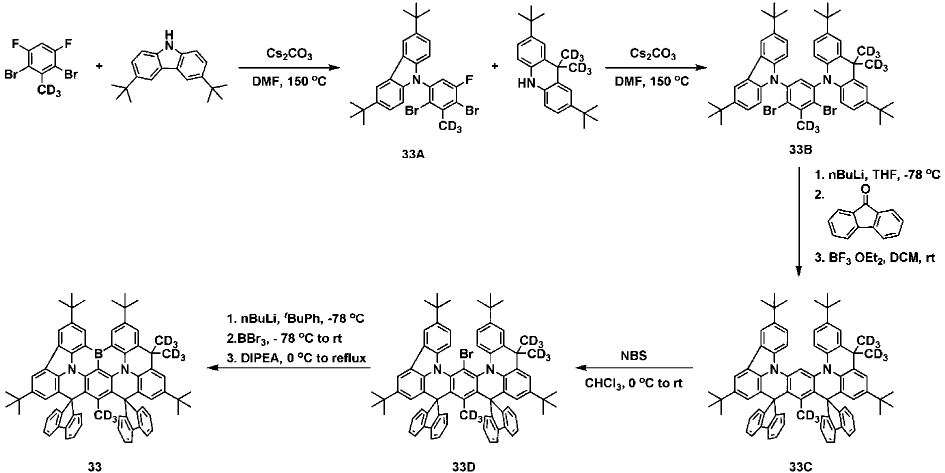

Compound 33 (0.62 g, 33% yield) was obtained using the same method as the synthesis method for compounds 25A, 25B, 25C, 25D, and 25 of Synthesis Example 1, except that 2,4-dibromo-1,5-difluoro-3-(methyl-d3)benzene was used instead of 1,5-dibromo-2,4-difluorobenzene, 2,7-di-tert-butyl-9,9-bis(methyl-d₃)-9,10-dihydroacridine was used instead of 2,7-di-tert-butyl-10H-spiro[acridine-9,9'-fluorene], and 9H-fluoren-9-one was used instead of benzophenone. The obtained compound was identified by HRMS (MALDI) and HPLC analysis.

HRMS (MALDI) calculated for C₇₆H₆₀D₉BN₂: m/z 1026.6119 Found: 1026.6117.

### Synthesis Example 3: Synthesis of compound 43

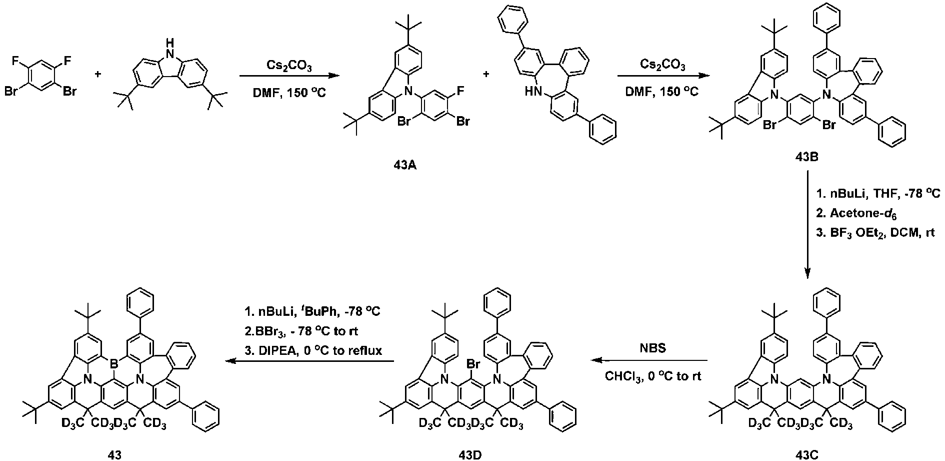

Compound 43 (0.34 g, 22% yield) was obtained using the same method as the synthesis method for compounds 25A, 25B, 25C, 25D, and 25 of Synthesis Example 1, except that 6, 12-diphenyl-9H-tribenzo[b,d,f]azepine was used instead of 2,7-di-tert-butyl-10H-spiro[acridine-9,9'-fluorene] and acetone-d₆ was used instead of benzophenone. The obtained compound was identified by HRMS (MALDI) and HPLC analysis.

HRMS (MALDI) calculated for C₅₂H₄₁D₁₂BN₂: m/z 848.5055, Found: 848.5056.

### EXAMPLES

### Example 1

As an anode, an indium tin oxide (ITO)-patterned glass substrate was cut to a size of 50 mm x 50 mm x 0.5 mm, sonicated in isopropyl alcohol and deionized (DI) water for 5 minutes each, cleaned by irradiation of ultraviolet rays and exposure to ozone for 30 minutes, and then mounted on a vacuum deposition apparatus.

Compound HT3 and compound F12 (p-dopant) were vacuum-codeposited on the anode at a weight ratio of 98:2 to form a hole injection layer having a thickness of 100 Å, and compound HT3 was vacuum-deposited on the hole injection layer to form a hole transport layer having a thickness of 1,650 Å.

Next, on the hole transport layer, a mixture of compound BPP-BCZ and compound BTPP-PCZ, which were pre-mixed at the weight ratio of 50:50, and is defined as a host on the hole transport layer, was co-deposited with compound 25 (emitter) in a weight ratio of 99:1 to form an emission layer having a thickness of 400 Å.

Thereafter, compound ET3 and LiQ (n-dopant) were co-deposited at a volume ratio of 50:50 on the emission layer to form an electron transport layer having a thickness of 350 Å, LiQ was vacuum-deposited on the electron transport layer to form an electron injection layer having a thickness of 10 Å, and Al was vacuum-deposited on the electron injection layer to form a cathode having a thickness of 1,000 Å, thereby completing the fabrication of an organic light-emitting device.

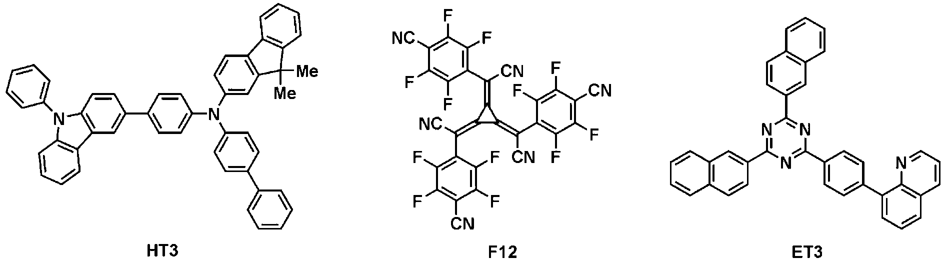

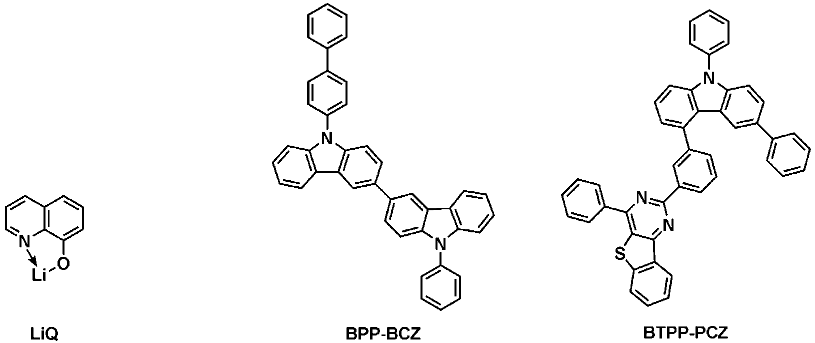

### Examples 2 to 6 and Comparative Examples 1 to 4

Organic light-emitting devices were manufactured using the same method as Example 1, except that each compound listed in Table 1 was used instead of Compound 25 as an emitter when forming the emission layer.

For the organic light-emitting devices fabricated in Examples 1 to 6 and Comparative Examples 1 to 4, driving voltage (volts, V), maximum value of external quantum efficiency (max EQE, %), maximum emission wavelength (λₘₐₓ, nm), FWHM (nm), and roll-off ratio (%) were evaluated, and the results are shown in Table 1, respectively. As evaluation apparatuses, a current-voltage meter (Keithley 2400) and a luminance meter (Minolta Cs-1000A) were used. The roll-off ratio was calculated according to Equation 1. 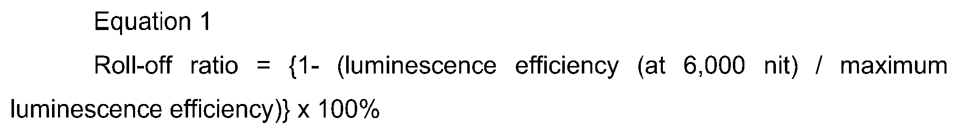 Roll-off ratio = {1- (luminescence efficiency (at 6,000 nit) / maximum luminescence efficiency)) x 100% Equation 1

**Table 1**

| | Emitter in emission layer | Driving voltage (V) | Max EQE (%) | λₘₐₓ (EL) (nm) | FWHM (EL) (nm) | Roll-off ratio (%) |
|---|---|---|---|---|---|---|
| Example 1 | Compound 25 | 4.4 | 6.3 | 525 | 28 | 68 |
| Example 2 | Compound 33 | 4.5 | 6.2 | 521 | 25 | 70 |
| Example 3 | Compound 43 | 4.5 | 6.2 | 527 | 29 | 66 |
| Example 4 | Compound 31 | 4.6 | 6.1 | 542 | 26 | 69 |
| Example 5 | Compound 46 | 4.4 | 6.2 | 524 | 30 | 68 |
| Example 6 | Compound 50 | 4.4 | 6.2 | 533 | 32 | 67 |
| Comparative Example 1 | Compound A | 5.1 | 5 | 524 | 32 | 76 |
| Comparative Example 2 | Compound B | 5.1 | 5.5 | 526 | 31 | 74 |
| Comparative Example 3 | Compound C | 4.8 | 5.1 | 523 | 33 | 80 |
| Comparative Example 4 | Compound D | 4.8 | 5.1 | 522 | 34 | 78 |

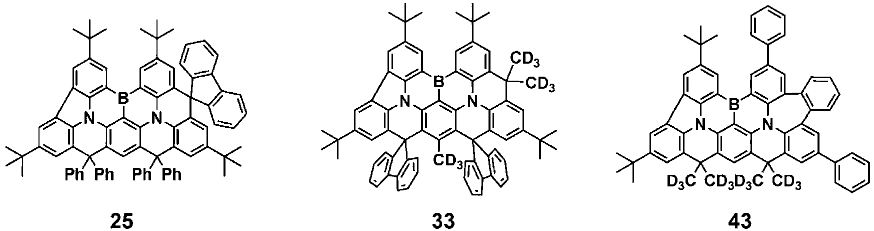

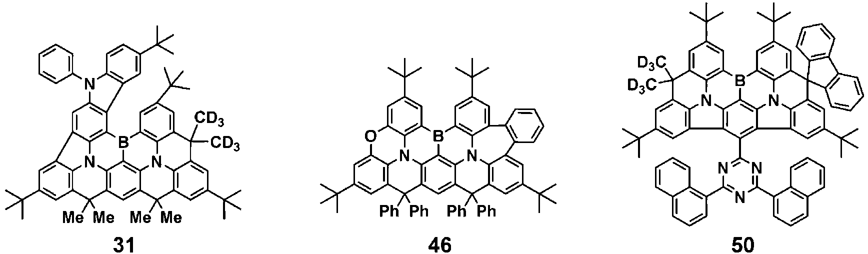

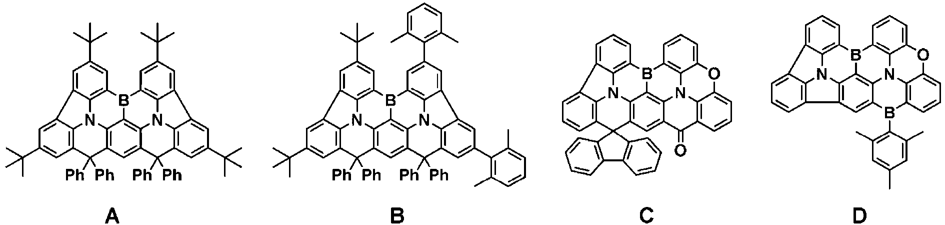

Referring to Table 1, it was found that an organic light-emitting device according to one or more embodiments had a low driving voltage, high external quantum efficiency, narrow FWHM, and a low roll-off ratio. In addition, it was found that the organic light-emitting devices of Examples 1 to 6 had lower driving voltages, higher external quantum efficiencies, narrower or equal FWHM, and lower roll-off ratios compared to the organic light-emitting devices of Comparative Examples 1 to 4.

### Example 7

As an anode, an ITO-patterned glass substrate was cut to a size of 50 mm x 50 mm x 0.5 mm, sonicated in isopropyl alcohol and DI water for 5 minutes each, cleaned by irradiation of ultraviolet rays and exposure to ozone for 30 minutes, and then mounted on a vacuum deposition apparatus.

Compound HT3 and compound F12 (p-dopant) were vacuum-codeposited on the anode at a weight ratio of 98:2 to form a hole injection layer having a thickness of 100 Å, and compound HT3 was vacuum-deposited on the hole injection layer to form a hole transport layer having a thickness of 1,650 Å.

Next, a mixture of compound BPP-BCZ and compound BTPP-PCZ, which were pre-mixed at a weight ratio of 50:50, and is a host, compound Ir(ppy)₃, which is the sensitizer, and compound 25, which is an emitter, were co-deposited on the hole transport layer in the weight ratio of 92:7:1 to form an emission layer having a thickness of 400 Å.

Thereafter, compound ET3 and LiQ (n-dopant) were co-deposited at a volume ratio of 50:50 on the emission layer to form an electron transport layer having a thickness of 350 Å, LiQ was vacuum-deposited on the electron transport layer to form an electron injection layer having a thickness of 10 Å, and Al was vacuum-deposited on the electron injection layer to form a cathode having a thickness of 1,000 Å, thereby completing the fabrication of an organic light-emitting device.

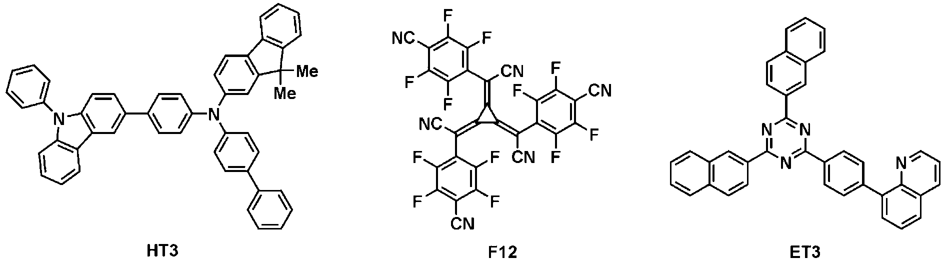

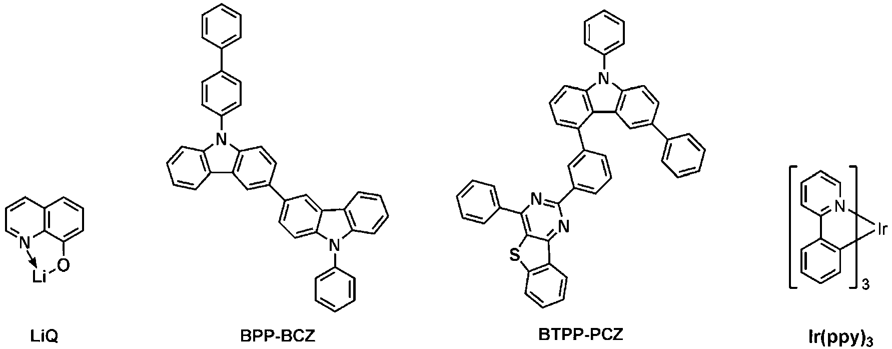

### Examples 8 to 11 and Comparative Examples 5 to 8

Organic light-emitting devices were manufactured using the same method as Example 7, except that each compound listed in Table 2 was used instead of Compound 25 as an emitter when forming the emission layer.

For the organic light-emitting devices fabricated in Examples 7 to 11 and Comparative Examples 5 to 8, driving voltage (V), maximum value of external quantum efficiency (max EQE, %), maximum emission wavelength (λₘₐₓ, nm), FWHM (nm), and roll-off ratio (%) were evaluated, and the results are shown in Table 2, respectively. As evaluation apparatuses, a current-voltage meter (Keithley 2400) and a luminance meter (Minolta Cs-1000A) were used. The roll-off ratio was calculated according to Equation 1.

**Table 2**

| | Emitter in emission layer | Driving voltage (V) | Max EQE (%) | λₘₐₓ (EL) (nm) | FWHM (EL) (nm) | Roll-off ratio (%) |
|---|---|---|---|---|---|---|
| Example 7 | Compound 25 | 4.2 | 28 | 526 | 29 | 12 |
| Example 8 | Compound 33 | 4.3 | 27 | 524 | 26 | 13 |
| Example 9 | Compound 43 | 4.4 | 27 | 528 | 30 | 11 |
| Example 10 | Compound 31 | 4.4 | 26.5 | 543 | 28 | 14 |
| Example 11 | Compound 46 | 4.3 | 27 | 526 | 31 | 14 |
| Comparative Example 5 | Compound A | 4.7 | 26 | 528 | 32 | 16 |
| Comparative Example 6 | Compound B | 4.7 | 26.5 | 530 | 31 | 14 |
| Comparative Example 7 | Compound C | 4.9 | 22 | 524 | 33 | 17 |
| Comparative Example 8 | Compound D | 4.9 | 23 | 523 | 34 | 16 |

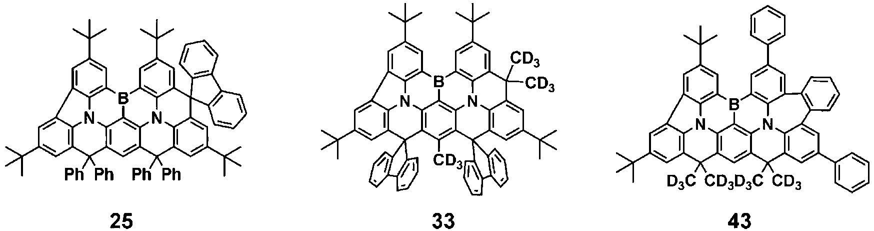

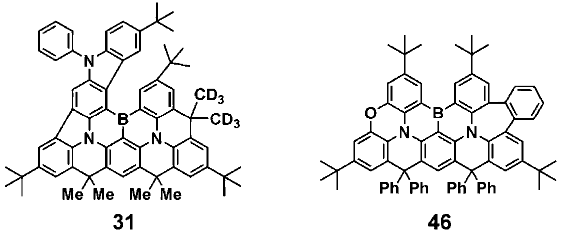

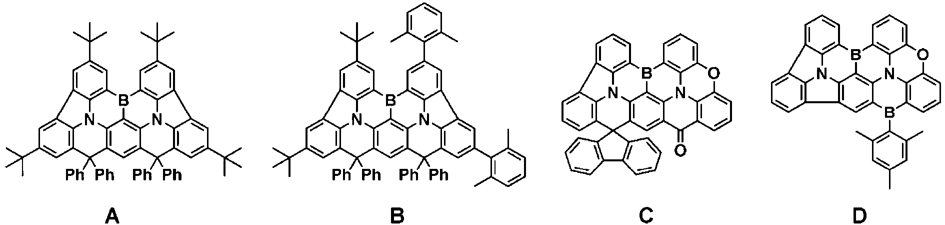

Referring to Table 2, it can be seen that an organic light-emitting device according to one or more embodiments had a low driving voltage, high external quantum efficiency, narrow FWHM, and a low roll-off ratio. In addition, it can be seen that the organic light-emitting devices of Examples 7 to 11 had lower driving voltages, higher or equivalent external quantum efficiencies, narrower or equal FWHM, and lower or equivalent roll-off ratios compared to the organic light-emitting devices of Comparative Examples 5 to 8.

Since heterocyclic compounds according to embodiments have excellent luminescence characteristics and charge mobility characteristics, an electronic device employing the heterocyclic compound represented by Formula 1, for example, an organic light-emitting device, can have the characteristics of low driving voltage, high efficiency, and long life. Therefore, a high-quality organic light-emitting device and an electronic apparatus including the same can be obtained using the heterocyclic compound represented by Formula 1.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

1. A heterocyclic compound represented by Formula 1: 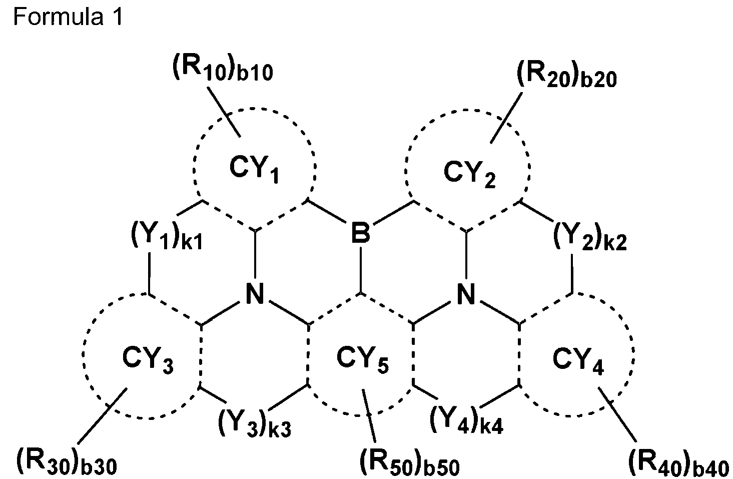
wherein, in Formula 1,
Y₁ is a single bond, *-O-*', *-S-*', *-Se-*', *-N(Z₁)-*', *-C(Z₁)(Z₂)-*', *-C(Z₁)=C(Z₂)-*', *-Si(Z₁)(Z₂)-*', *-Ge(Z₁)(Z₂)-*', or a group represented by Formula 2,
Y₂ is *-O-*', *-S-*', *-Se-*', *-N(Z₃)-*', *-C(Z₃)(Z₄)-*', *-C(Z₃)=C(Z₄)-*', *-Si(Z₃)(Z₄)-*', *-Ge(Z₃)(Z₄)-*', or a group represented by Formula 2,
Y₃ is a single bond, *-O-*', *-S-*', *-Se-*', *-N(Z₅)-*', *-C(Z₅)(Z₅)-*', *-C(Z₅)=C(Z₅)-*', *-Si(Z₅)(Z₆)-*', *-Ge(Z₅)(Z₆)-*', or a group represented by Formula 2, and
Y₄ is a single bond, *-O-*', *-S-*', *-Se-*', *-N(Z₇)-*', *-C(Z₇)(Z₈)-*', *-C(Z₇)=C(Z₈)-*', *-Si(Z₇)(Z₈)-*', *-Ge(Z₇)(Z₈)-, or a group represented by Formula 2, 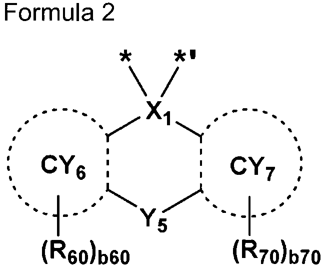
wherein, in Formula 2,
X₁ is C, Si, or Ge,
Y₅ is a single bond, *-O-*', *-S-*', *-Se-*', *-N(R₁)-*', *-C(R₁)(R₂)-*', *-C(R₁)=C(R₂)-*', *-Si(R₁)(R₂)-*', *-Ge(R₁)(R₂)-*', *-S(=O)₂-*', or *-C(=O)-*',
wherein, in Formulae 1 and 2,
k1 to k4 are each independently 1, 2, 3, 4, or 5,
ring CY₁ to ring CY₇ are each independently a C₅-C₃₀ carbocyclic group or a C₁-C₃₀ heterocyclic group,
Z₁ to Z₈, R₁, R₂, R₁₀, R₂₀, R₃₀, R₄₀, R₅₀, R₆₀, and R₇₀ are each independently hydrogen, deuterium, -F, -Cl, -Br, -I, -SF₅, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic heterocondensed polycyclic group, -N(Q₁)(Q₂), -Si(Q₁)(Q₂)(Q₃), -Ge(Q₁)(Q₂)(Q₃), - C(=O)(Q₁), -S(=O)(Q₁), -S(=O)₂(Q₁), -B(Q₁)(Q₂), -P(Q₁)(Q₂), -P(=O)(Q₁)(Q₂), or - P(=S)(Q₁)(Q₂),
b10, b20, b30, b40, b50, b60, and b70 are each independently 1, 2, 3, 4, 5, 6, 7, 8, 9, 10, 11, 12, 13, or 14,
two or more of a plurality of R₁₀ are optionally bonded to each other to form a substituted or unsubstituted C₅-C₃₀ carbocyclic group or a substituted or unsubstituted C₁-C₃₀ heterocyclic group,
two or more of a plurality of R₂₀ are optionally bonded to each other to form a substituted or unsubstituted C₅-C₃₀ carbocyclic group or a substituted or unsubstituted C₁-C₃₀ heterocyclic group,
two or more of a plurality of R₃₀ are optionally bonded to each other to form a substituted or unsubstituted C₅-C₃₀ carbocyclic group or a substituted or unsubstituted C₁-C₃₀ heterocyclic group,
two or more of a plurality of R₄₀ are optionally bonded to each other to form a substituted or unsubstituted C₅-C₃₀ carbocyclic group or a substituted or unsubstituted C₁-C₃₀ heterocyclic group,
two or more of a plurality of R₅₀ are optionally bonded to each other to form a substituted or unsubstituted C₅-C₃₀ carbocyclic group or a substituted or unsubstituted C₁-C₃₀ heterocyclic group,
two or more of a plurality of R₆₀ are optionally bonded to each other to form a substituted or unsubstituted C₅-C₃₀ carbocyclic group or a substituted or unsubstituted C₁-C₃₀ heterocyclic group,
two or more of a plurality of R₇₀ are optionally bonded to each other to form a substituted or unsubstituted C₅-C₃₀ carbocyclic group or a substituted or unsubstituted C₁-C₃₀ heterocyclic group,
two or more of adjacent Z₁ to Z₈, R₁, R₂, R₁₀, R₂₀, R₃₀, R₄₀, R₅₀, R₆₀, and R₇₀ are optionally bonded to each other to form a substituted or unsubstituted C₅-C₃₀ carbocyclic group or a substituted or unsubstituted C₁-C₃₀ heterocyclic group,
* and *' each indicate a binding site to a neighboring atom,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic heterocondensed polycyclic group is each independently:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₁)(Q₁₂)(Q₁₃), -Ge(Q₁₁)(Q₁₂)(Q₁₃), -C(=O)(Q₁₁), -S(=O)(Q₁₁), -S(=O)₂(Q₁₁), -B(Q₁₁)(Q₁₂), -P(Q₁₁)(Q₁₂), -P(=O)(Q₁₁)(Q₁₂), -P(=S)(Q₁₁)(Q₁₂), or a combination thereof,
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₁)(Q₂₂)(Q₂₃), - Ge(Q₂₁)(Q₂₂)(Q₂₃), -C(=O)(Q₂₁), -S(=O)(Q₂₁), -S(=O)₂(Q₂₁), -B(Q₂₁)(Q₂₂), -P(Q₂₁)(Q₂₂), -P(=O)(Q₂₁)(Q₂₂), -P(=S)(Q₂₁)(Q₂₂), or a combination thereof,
-N(Q₃₁)(Q₃₂), -Si(Q₃₁)(Q₃₂)(Q₃₃), -Ge(Q₃₁)(Q₃₂)(Q₃₃), -C(=O)(Q₃₁), -S(=O)(Q₃₁), -S(=O)₂(Q₃₁), -B(Q₃₁)(Q₃₂), -P(Q₃₁)(Q₃₂), -P(=O)(Q₃₁)(Q₃₂), or -P(=S)(Q₃₁)(Q₃₂); or
a combination thereof, and
Q₁ to Q₃, Q₁₁ to Q₁₃, Q₂₁ to Q₂₃, and Q₃₁ to Q₃₃ are each independently:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, or
a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, -F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof.

2. The heterocyclic compound of claim 1, wherein
Y₁ is a single bond, *-O-*', *-S-*', *-C(Z₁)(Z₂)-*', or a group represented by Formula 2,
Y₂ is *-O-*', *-S-*', *-Se-*', *-N(Z₃)-*', *-C(Z₃)(Z₄)-*', *-C(Z₃)=C(Z₄)-*', *-Si(Z₃)(Z₄)-*', *-Ge(Z₃)(Z₄)-*', or a group represented by Formula 2,
Y₃ is a single bond, *-C(Z₅)(Z₆)-*', *-Si(Z₅)(Z₆)-*' or a group represented by Formula 2, and
Y₄ is a single bond, *-C(Z₇)(Z₈)-*', *-Si(Z₇)(Z₈)-*', or a group represented by Formula 2.

3. The heterocyclic compound of claims 1 or 2, wherein Y₁ and Y₂ are different from each other; and/or
wherein ring CY₁ to ring CY₇ are each independently a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, a dibenzosilole group, a dibenzoborole group, a dibenzophosphole group, a dibenzoselenophene group, a dibenzogermole group, a dibenzothiophene 5-oxide group, a 9H-fluoren-9-one group, or a dibenzothiophene 5,5-dioxide group.

4. The heterocyclic compound of any of claims 1-3, wherein
the group represented by Formula 2 is a group represented by one of Formulae 2A to 2C: 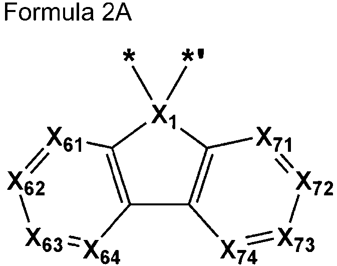 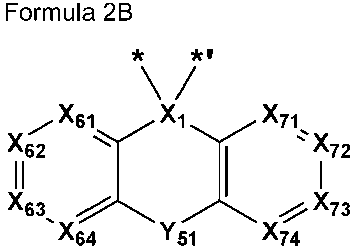 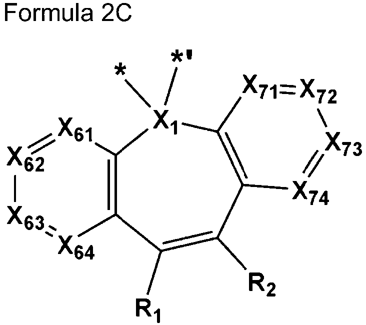 wherein, in Formulae 2A to 2C,
Y₅₁ is *-O-*', *-S-*', *-Se-*', *-N(R₁)-*', *-C(R₁)(R₂)-*', *-Si(R₁)(R₂)-*', *-Ge(R₁)(R₂)-*', *-S(=O)₂-*', or *-C(=O)-*',
X₁, R₁, and R₂ are as described in claim 1,
X₆₁ is C(R₆₁) or N, X₆₂ is C(R₆₂) or N, X₆₃ is C(R₆₃) or N, and X₆₄ is C(R₆₄) or N,
X₇₁ is C(R₇₁) or N, X₇₂ is C(R₇₂) or N, X₇₃ is C(R₇₃) or N, and X₇₄ is C(R₇₄) or N,
R₆₁ to R₆₄ are each independently as described in connection with R₆₀,
R₇₁ to R₇₄ are each independently as described in connection with R₇₀, and
* indicates a binding site to a neighboring atom.

5. The heterocyclic compound of any of claims 1-4, wherein
Z₁ to Z₈, R₁, R₂, R₁₀, R₂₀, R₃₀, R₄₀, R₅₀, R₆₀, and R₇₀ are each independently:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (norbornanyl group), a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or a combination thereof;
a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, - Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Si(Q₁)(Q₂)(Q₃), -Ge(Q₁)(Q₂)(Q₃), -C(=O)(Q₁), -S(=O)(Q₁), - S(=O)₂(Q₁), -B(Q₁)(Q₂), -P(Q₁)(Q₂), -P(=O)(Q₁)(Q₂), or -P(=S)(Q₁)(Q₂).

6. The heterocyclic compound of any of claims 1-5, wherein
at least one of Y₁ to Y₄ is the group represented by Formula 2, or
at least one of Z₁ to Z₈, R₁, R₂, R₁₀, R₂₀, R₃₀, R₄₀, R₅₀, R₆₀, and R₇₀ is a substituted or unsubstituted C₁-C₆₀ alkyl group, a substituted or unsubstituted C₃-C₁₀ cycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, a substituted or unsubstituted monovalent non-aromatic heterocondensed polycyclic group, -Si(Q₁)(Q₂)(Q₃), or -Ge(Q₁)(Q₂)(Q₃).

7. The heterocyclic compound of any of claims 1-6, wherein
the heterocyclic compound is a heterocyclic compound represented by Formula 11 or 12: 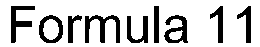 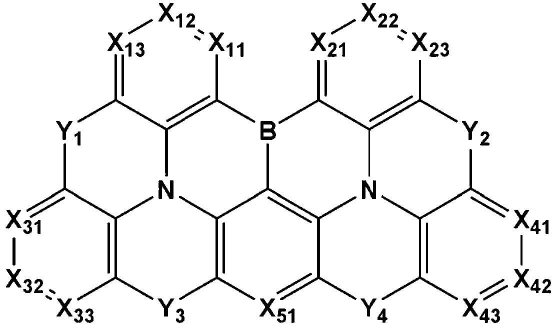 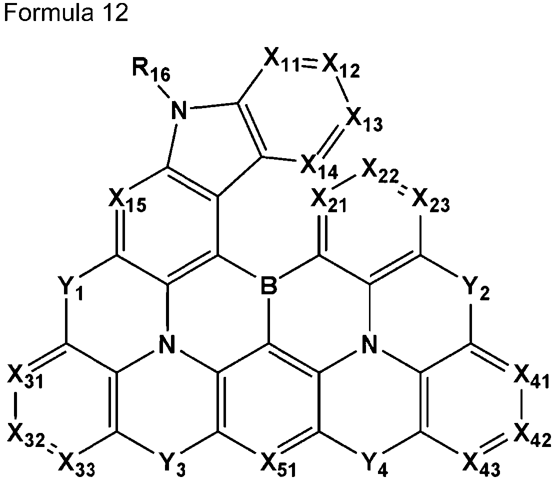 wherein, in Formulae 11 and 12,
Y₁ to Y₄ are as described in claim 1,
X₁₁ is C(R₁₁) or N, X₁₂ is C(R₁₂) or N, X₁₃ is C(R₁₃) or N, X₁₄ is C(R₁₄) or N, and X₁₅ is C(R₁₅) or N,
X₂₁ is C(R₂₁) or N, X₂₂ is C(R₂₂) or N, and X₂₃ is C(R₂₃) or N,
X₃₁ is C(R₃₁) or N, X₃₂ is C(R₃₂) or N, and X₃₃ is C(R₃₃) or N,
X₄₁ is C(R₄₁) or N, X₄₂ is C(R₄₂) or N, and X₄₃ is C(R₄₃) or N,
X₅₁ is C(R₅₁) or N,
R₁₁ to R₁₆ are each independently as described in connection with R₁₀,
R₂₁ to R₂₃ are each independently as described in connection with R₂₀,
R₃₁ to R₃₃ are each independently as described in connection with R₃₀,
R₄₁ to R₄₃ are each independently as described in connection with R₄₀, and
R₅₁ is as described in connection with R₅₀.

8. The heterocyclic compound of any of claims 1-7, wherein
the heterocyclic compound is a heterocyclic compound represented by one of Formulae 21 to 29: 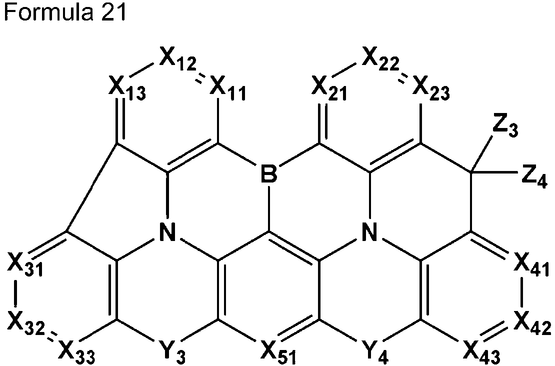 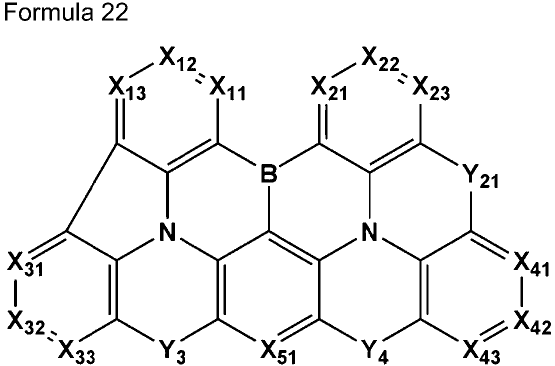 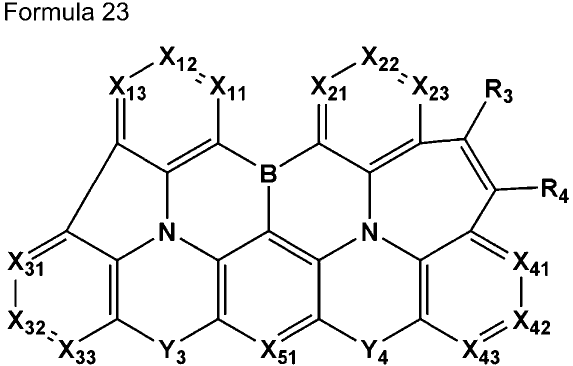 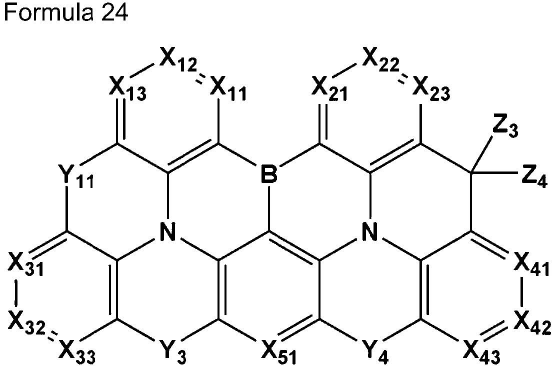 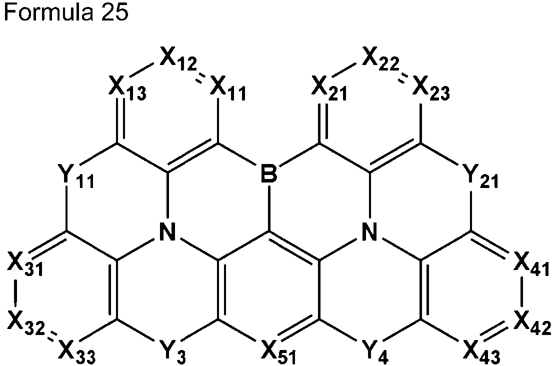 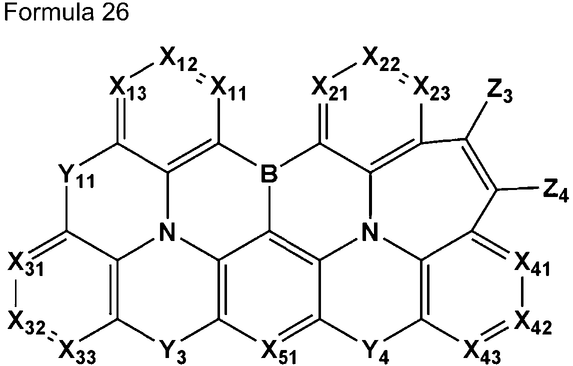 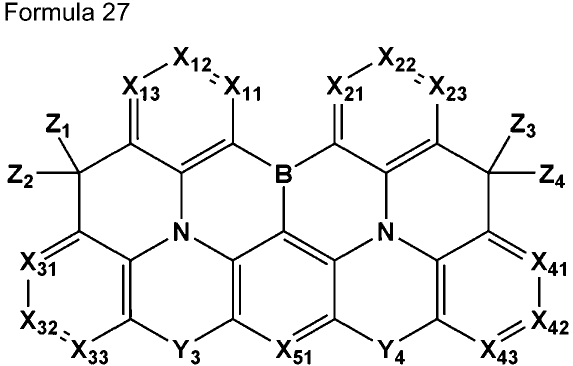 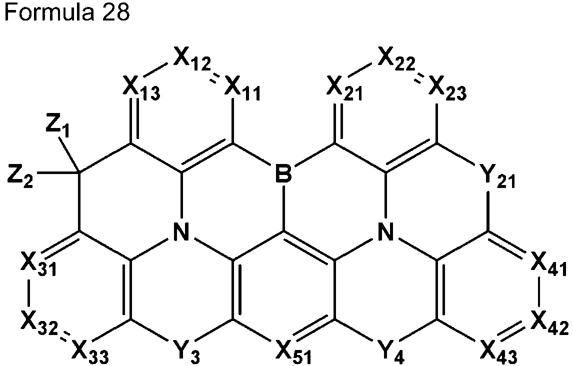 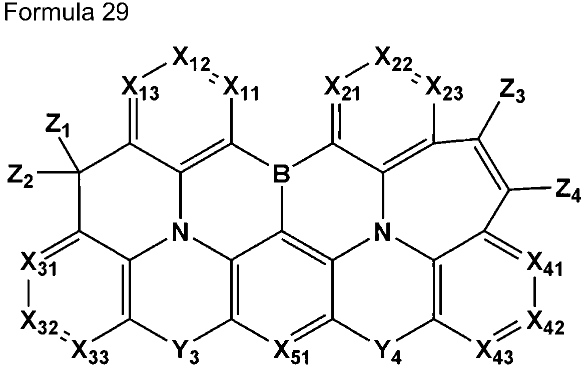 wherein, in Formulae 21 to 29,
Y₃, Y₄, and Z₁ to Z₄ are each as described in claim 1,
Y₁₁ is *-O-*', *-S-*', *-Se-*', *-N(Z₁)-*', *-Si(Z₁)(Z₂)-*', *-Ge(Z₁)(Z₂)-*', or a group represented by Formula 2,
Y₂₁ is *-O-*', *-S-*', *-Se-*', *-N(Z₃)-*', *-Si(Z₃)(Z₄)-*', *-Ge(Z₃)(Z₄)-*', or a group represented by Formula 2,
X₁₁ is C(R₁₁) or N, X₁₂ is C(R₁₂) or N, X₁₃ is C(R₁₃) or N, X₁₄ is C(R₁₄) or N, and X₁₅ is C(R₁₅) or N,
X₂₁ is C(R₂₁) or N, X₂₂ is C(R₂₂) or N, and X₂₃ is C(R₂₃) or N,
X₃₁ is C(R₃₁) or N, X₃₂ is C(R₃₂) or N, and X₃₃ is C(R₃₃) or N,
X₄₁ is C(R₄₁) or N, X₄₂ is C(R₄₂) or N, and X₄₃ is C(R₄₃) or N,
X₅₁ is C(R₅₁) or N,
R₁₁ to R₁₆ are each independently as described in connection with R₁₀,
R₂₁ to R₂₃ are each independently as described in connection with R₂₀,
R₃₁ to R₃₃ are each independently as described in connection with R₃₀,
R₄₁ to R₄₃ are each independently as described in connection with R₄₀, and
R₅₁ is as described in connection with R₅₀.

9. The heterocyclic compound of any of claims 1-8, wherein the heterocyclic compound contains only one boron (B); and/or
wherein the heterocyclic compound has an asymmetric structure.

10. The heterocyclic compound of any of claims 1-9, wherein
the heterocyclic compound is one of compounds 1 to 66:

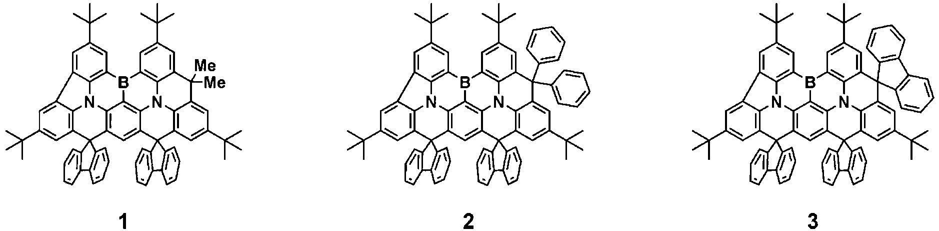

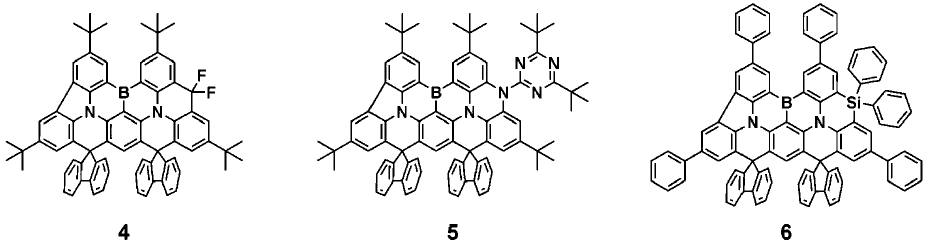

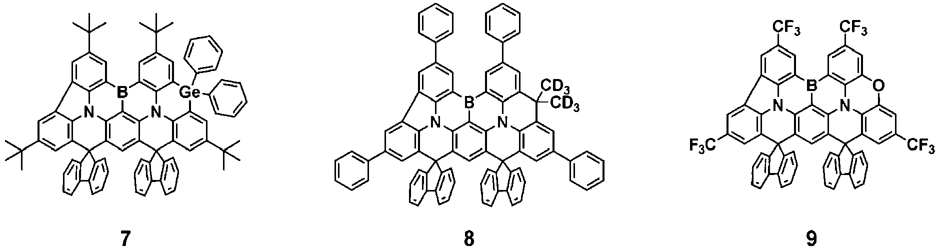

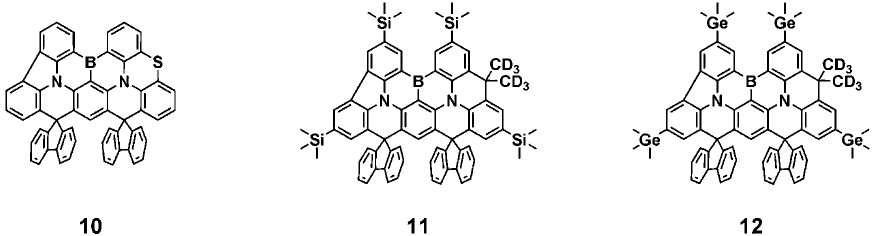

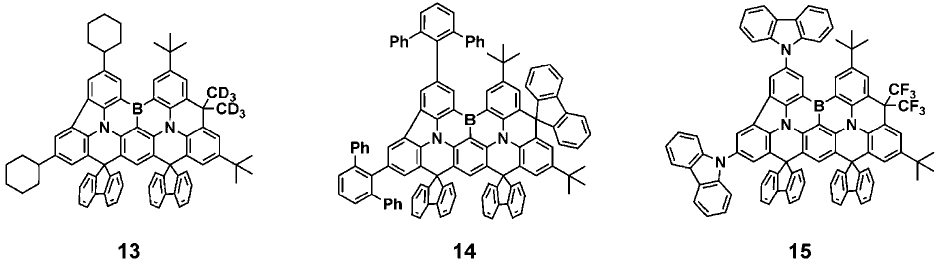

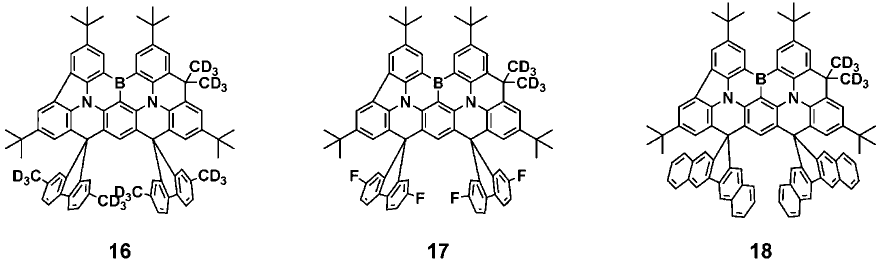

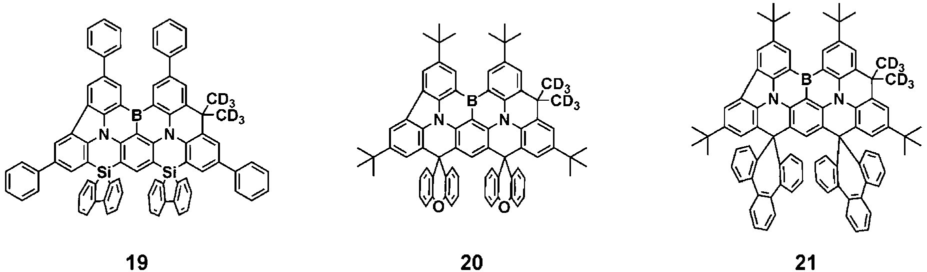

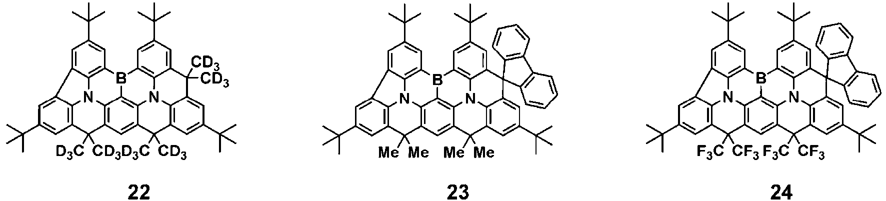

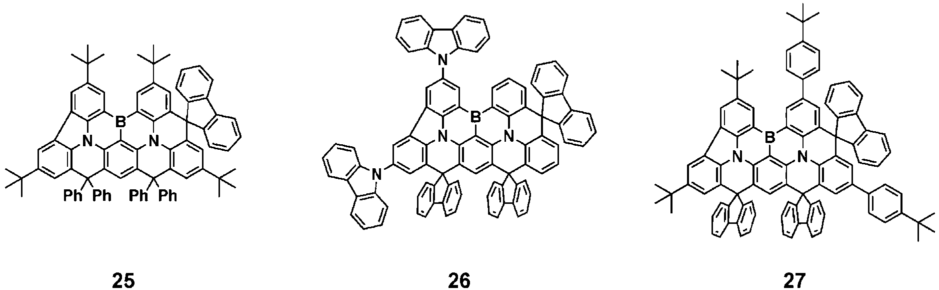

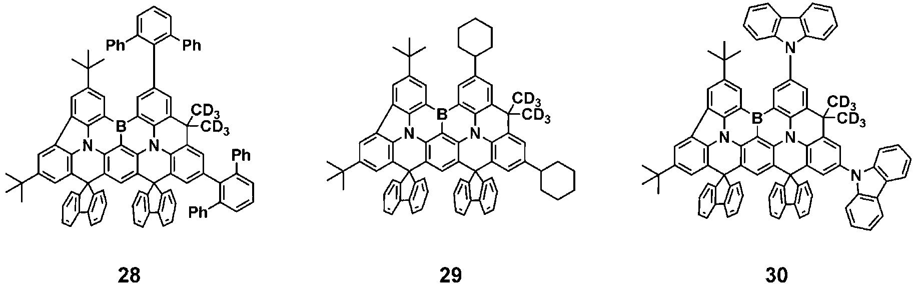

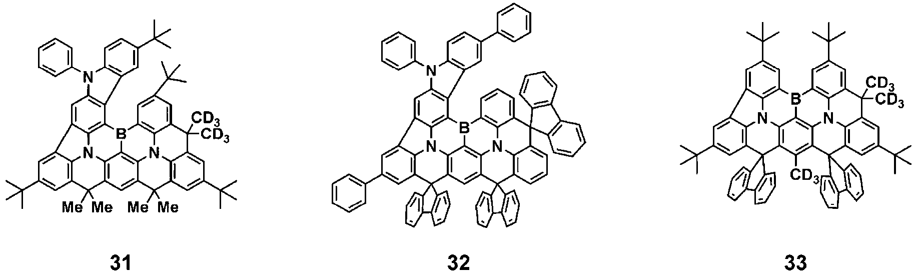

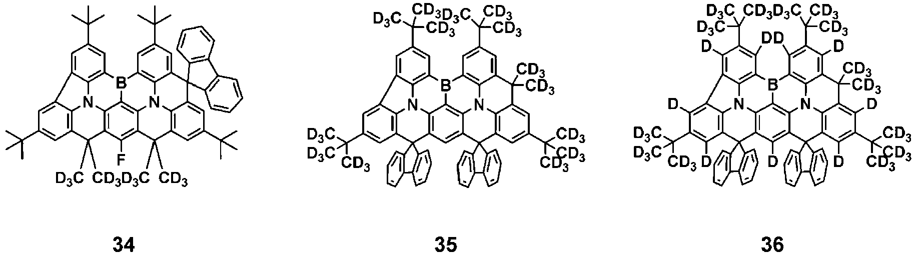

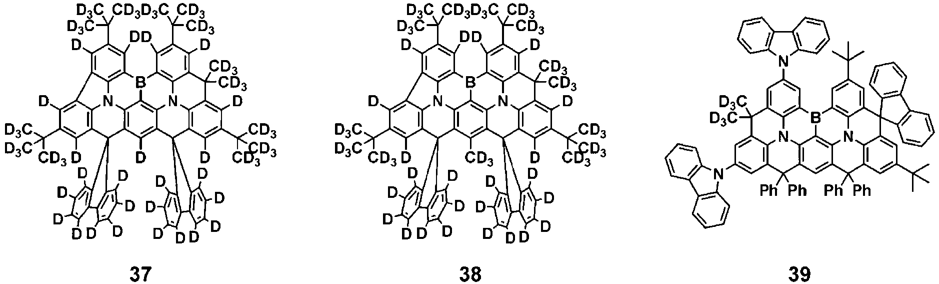

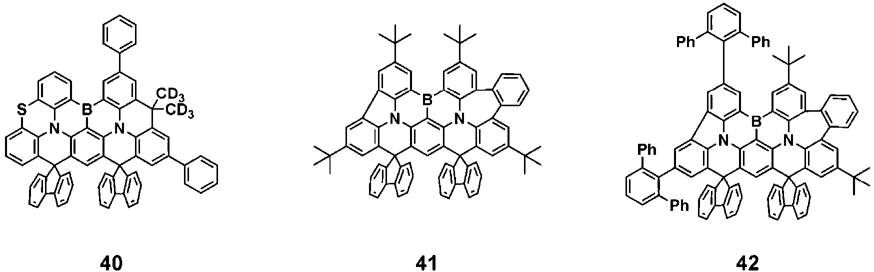

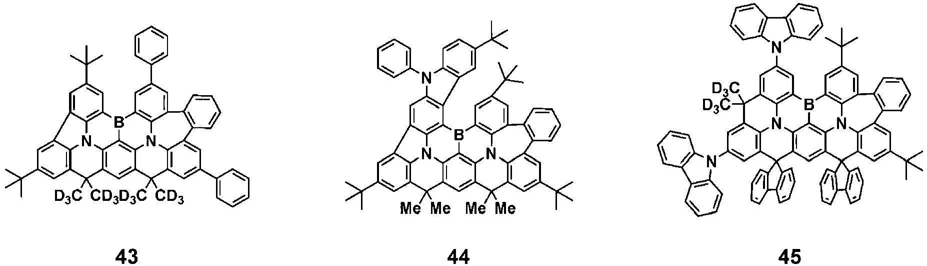

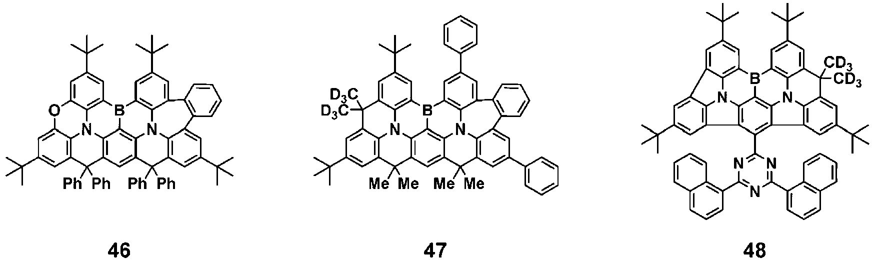

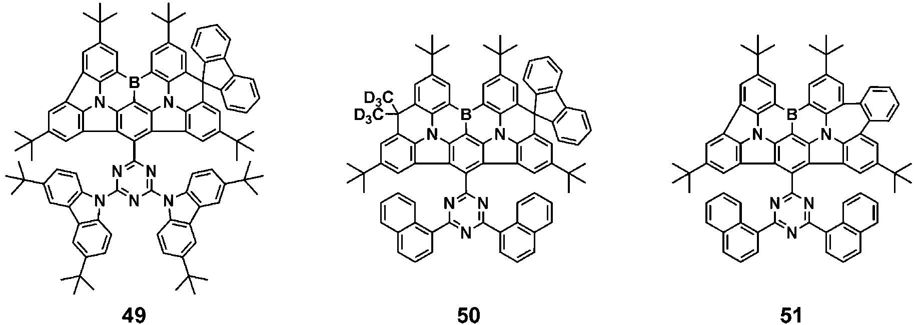

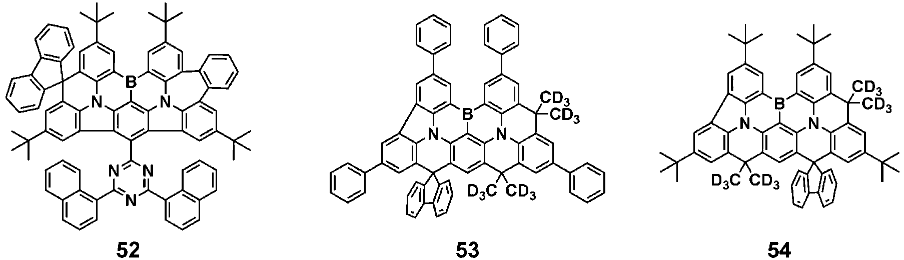

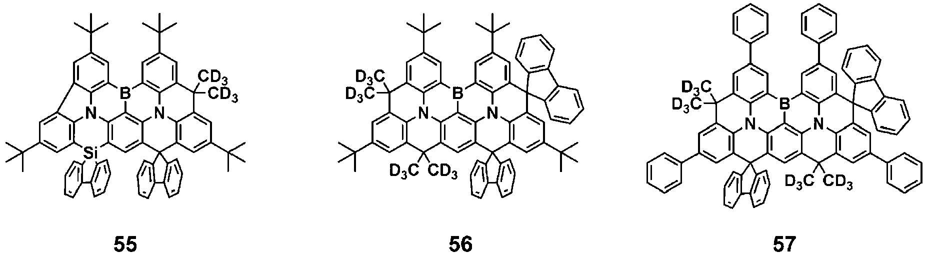

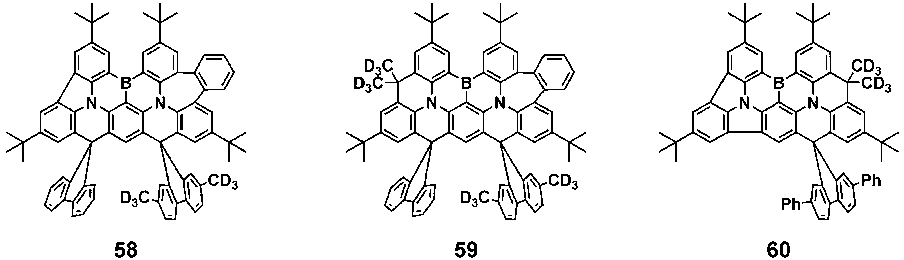

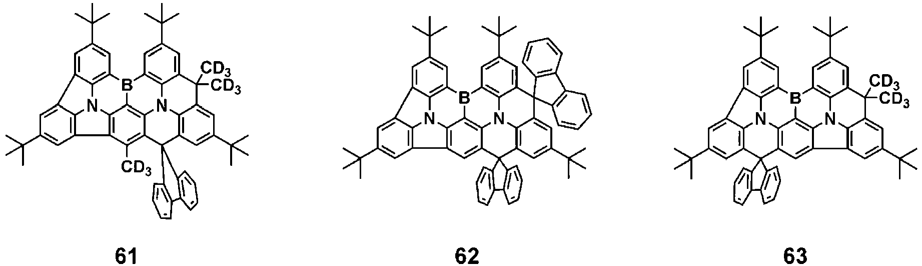

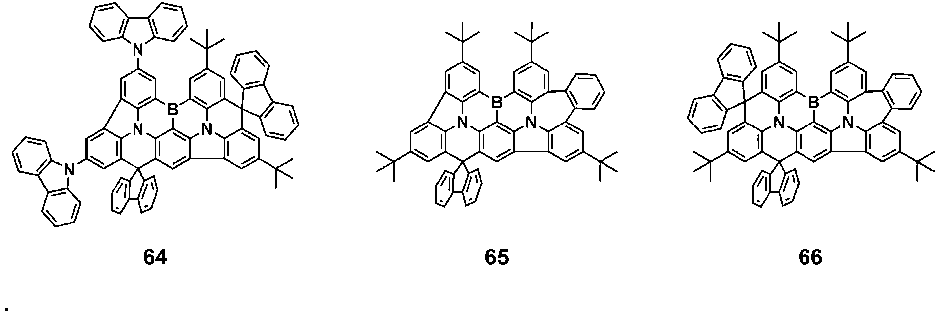

11. An organic light-emitting device, comprising:
a first electrode;
a second electrode, and
an organic layer disposed between the first electrode and the second electrode,
wherein the organic layer comprises an emission layer, and
wherein the organic layer further comprises at least one heterocyclic compound of any of claims 1-10.

12. The organic light-emitting device of claim 11, wherein the emission layer comprises the at least one heterocyclic compound;
preferably wherein the emission layer emits a green light having a maximum emission wavelength of 500 nanometers to 600 nanometers.

13. The organic light-emitting device of claim 12, wherein
the emission layer comprises a host and an emitter, and
the emitter comprises the at least one heterocyclic compound.

14. The organic light-emitting device of claim 13, wherein an amount of the host in the emission layer is greater than an amount of the at least one heterocyclic compound in the emission layer, based on weight; and/or
wherein the emission layer further comprises a sensitizer, preferably wherein the sensitizer comprises a phosphorescent dopant.

15. An electronic apparatus, comprising the organic light-emitting device of any of claims 11-14.

## Amended claims

### Amended claims in accordance with Rule 137(2) EPC.

1. A heterocyclic compound represented by Formula 1: 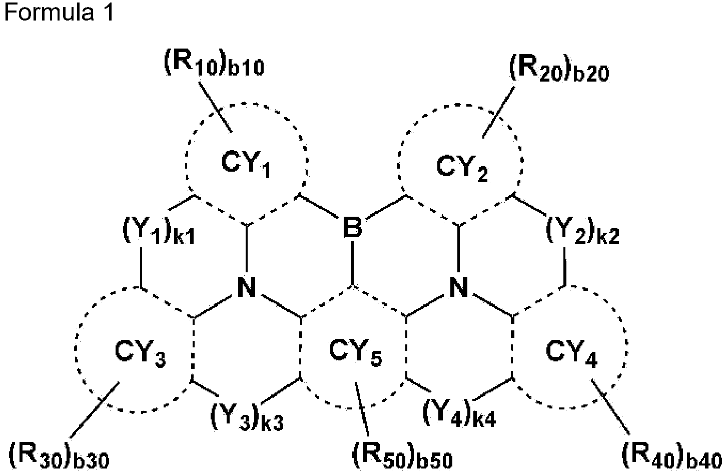 wherein, in Formula 1,
Y₁ is a single bond, *-O-*', *-S-*', *-C(Z₁)(Z₂)-*', or a group represented by Formula 2,
Y₂ is *-O-*', *-S-*', *-Se-*', *-N(Z₃)-*', *-C(Z₃)(Z₄)-*', *-C(Z₃)=C(Z₄)-*', *-Si(Z₃)(Z₄)-*', *-Ge(Z₃)(Z₄)-*', or a group represented by Formula 2, wherein Y₁ and Y₂ are different from each other;
Y₃ is a single bond, *-C(Z₅)(Z₅)-*', *- *-Si(Z₅)(Z₆)-*', or a group represented by Formula 2, and
Y₄ is a single bond, *-C(Z₇)(Z₈)-*', *- *-Si(Z₇)(Z₈)-*', or a group represented by Formula 2, 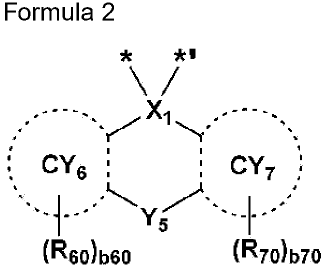 wherein, in Formula 2,
X₁ is C, Si, or Ge,
Y₅ is a single bond, *-O-*', *-S-*', *-Se-*', *-N(R₁)-*', *-C(R₁)(R₂)-*', *-C(R₁)=C(R₂)-*', *-Si(R₁)(R₂)-*', *-Ge(R₁)(R₂)-*', *-S(=O)₂-*', or *-C(=O)-*',
wherein, in Formulae 1 and 2,
k1 to k4 are each independently 1, 2, 3, 4, or 5,
ring CY₁ to ring CY₇ are each independently a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, a dibenzosilole group, a dibenzoborole group, a dibenzophosphole group, a dibenzoselenophene group, a dibenzogermole group, a dibenzothiophene 5-oxide group, a 9H-fluoren-9-one group, or a dibenzothiophene 5,5-dioxide group,
Z₁ to Z₈, R₁, R₂, R₁₀, R₂₀, R₃₀, R₄₀, R₅₀, R₆₀, and R₇₀ are each independently hydrogen, deuterium, -F, -Cl, -Br, -I, -SF₅, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic heterocondensed polycyclic group, -N(Q₁)(Q₂), -Si(Q₁)(Q₂)(Q₃), -Ge(Q₁)(Q₂)(Q₃), - C(=0)(Q₁), -S(=O)(Q₁), -S(=O)₂(Q₁), -B(Q₁)(Q₂), -P(Q₁)(Q₂), -P(=O)(Q₁)(Q₂), or - P(=S)(Q₁)(Q₂),
b10, b20, b30, b40, b50, b60, and b70 are each independently 1, 2, 3, 4, 5, 6, 7, 8, 9, 10, 11, 12, 13, or 14,
two or more of a plurality of R₁₀ are optionally bonded to each other to form a substituted or unsubstituted C₅-C₃₀ carbocyclic group or a substituted or unsubstituted C₁-C₃₀ heterocyclic group,
two or more of a plurality of R₂₀ are optionally bonded to each other to form a substituted or unsubstituted C₅-C₃₀ carbocyclic group or a substituted or unsubstituted C₁-C₃₀ heterocyclic group,
two or more of a plurality of R₃₀ are optionally bonded to each other to form a substituted or unsubstituted C₅-C₃₀ carbocyclic group or a substituted or unsubstituted C₁-C₃₀ heterocyclic group,
two or more of a plurality of R₄₀ are optionally bonded to each other to form a substituted or unsubstituted C₅-C₃₀ carbocyclic group or a substituted or unsubstituted C₁-C₃₀ heterocyclic group,
two or more of a plurality of R₅₀ are optionally bonded to each other to form a substituted or unsubstituted C₅-C₃₀ carbocyclic group or a substituted or unsubstituted C₁-C₃₀ heterocyclic group,
two or more of a plurality of R₆₀ are optionally bonded to each other to form a substituted or unsubstituted C₅-C₃₀ carbocyclic group or a substituted or unsubstituted C₁-C₃₀ heterocyclic group,
two or more of a plurality of R₇₀ are optionally bonded to each other to form a substituted or unsubstituted C₅-C₃₀ carbocyclic group or a substituted or unsubstituted C₁-C₃₀ heterocyclic group,
two or more of adjacent Z₁ to Z₈, R₁, R₂, R₁₀, R₂₀, R₃₀, R₄₀, R₅₀, R₆₀, and R₇₀ are optionally bonded to each other to form a substituted or unsubstituted C₅-C₃₀ carbocyclic group or a substituted or unsubstituted C₁-C₃₀ heterocyclic group,
* and *' each indicate a binding site to a neighboring atom,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic heterocondensed polycyclic group is each independently:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q11)(Q12), -Si(Q₁₁)(Q₁₂)(Q₁₃), -Ge(Q₁₁)(Q₁₂)(Q₁₃), -C(=O)(Q₁₁), -S(=O)(Q₁₁), -S(=O)2(Q11), -B(Q₁₁)(Q₁₂), -P(Q₁₁)(Q₁₂), -P(=O)(Q₁₁)(Q₁₂), -P(=S)(Q₁₁)(Q₁₂), or a combination thereof,
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q21)(Q22), -Si(Q₂₁)(Q₂₂)(Q₂₃), - Ge(Q₂₁)(Q₂₂)(Q₂₃), -C(=O)(Q₂₁), -S(=O)(Q₂₁), -S(=O)₂(Q₂₁), -B(Q₂₁)(Q₂₂), -P(Q₂₁)(Q₂₂), -P(=O)(Q₂₁)(Q₂₂), -P(=S)(Q₂₁)(Q₂₂), or a combination thereof,
-N(Q₃₁)(Q₃₂), -Si(Q₃₁)(Q₃₂)(Q₃₃), -Ge(Q₃₁)(Q₃₂)(Q₃₃), -C(=O)(Q₃₁), -S(=O)(Q₃₁), -S(=O)₂(Q₃₁), -B(Q₃₁)(Q₃₂), -P(Q₃₁)(Q₃₂), -P(=O)(Q₃₁)(Q₃₂), or -P(=S)(Q₃₁)(Q₃₂); or
a combination thereof, and
Q1 to Q₃, Q₁₁ to Q₁₃, Q₂₁ to Q₂₃, and Q₃₁ to Q₃₃ are each independently:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, or
a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, -F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof.

2. The heterocyclic compound of claim 1, wherein
the group represented by Formula 2 is a group represented by one of Formulae 2A to 2C: 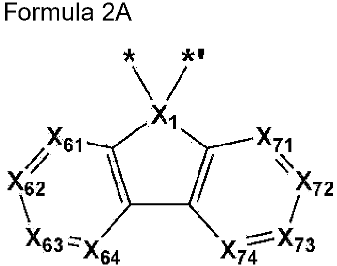 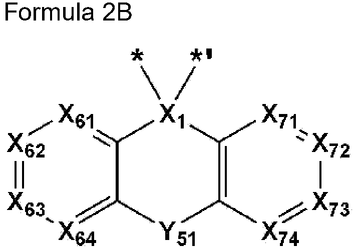 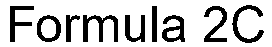 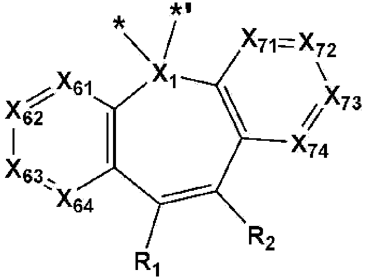 wherein, in Formulae 2A to 2C,
Y₅₁ is *-O-*', *-S-*', *-Se-*', *-N(R₁)-*', *-C(R₁)(R₂)-*', *-Si(R₁)(R₂)-*', *-Ge(R₁)(R₂)-*', *-S(=O)₂-*', or *-C(=O)-*',
X₁, R₁, and R₂ are as described in claim 1,
X₆₁ is C(R₆₁) or N, X₆₂ is C(R₆₂) or N, X₆₃ is C(R63) or N, and X₆₄ is C(R₆₄) or N,
X71 is C(R71) or N, X₇₂ is C(R72) or N, X₇₃ is C(R73) or N, and X₇₄ is C(R₇₄) or N,
R₆₁ to R₆₄ are each independently as described in connection with R₆₀,
R₇₁ to R₇₄ are each independently as described in connection with R₇₀, and
* indicates a binding site to a neighboring atom.

3. The heterocyclic compound of claims 1 or 2, wherein
Z₁ to Z₈, R₁, R₂, R₁₀, R₂₀, R₃₀, R₄₀, R₅₀, R₆₀, and R₇₀ are each independently:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (norbornanyl group), a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or a combination thereof;
a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, - Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Si(Q₁)(Q₂)(Q₃), -Ge(Q₁)(Q₂)(Q₃), -C(=O)(Q₁), -S(=O)(Q₁), - S(=O)₂(Q₁), -B(Q₁)(Q₂), -P(Q₁)(Q₂), -P(=O)(Q₁)(Q₂), or -P(=S)(Q₁)(Q₂).

4. The heterocyclic compound of any of claims 1-3, wherein
at least one of Y₁ to Y₄ is the group represented by Formula 2, or
at least one of Z₁ to Z₈, R₁, R₂, R₁₀, R₂₀, R₃₀, R₄₀, R₅₀, R₆₀, and R₇₀ is a substituted or unsubstituted C₁-C₆₀ alkyl group, a substituted or unsubstituted C₃-C₁₀ cycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, a substituted or unsubstituted monovalent non-aromatic heterocondensed polycyclic group, -Si(Q₁)(Q₂)(Q₃), or -Ge(Q₁)(Q₂)(Q₃).

5. The heterocyclic compound of any of claims 1-4, wherein
the heterocyclic compound is a heterocyclic compound represented by Formula 11 or 12: 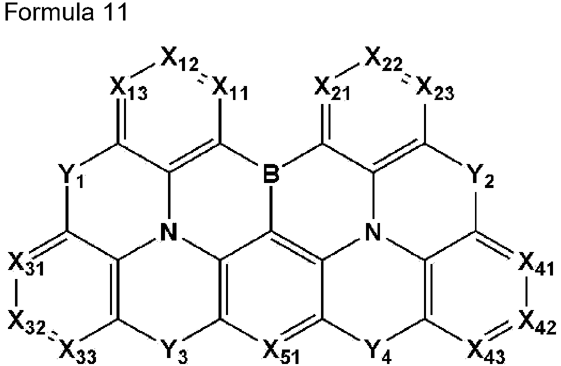 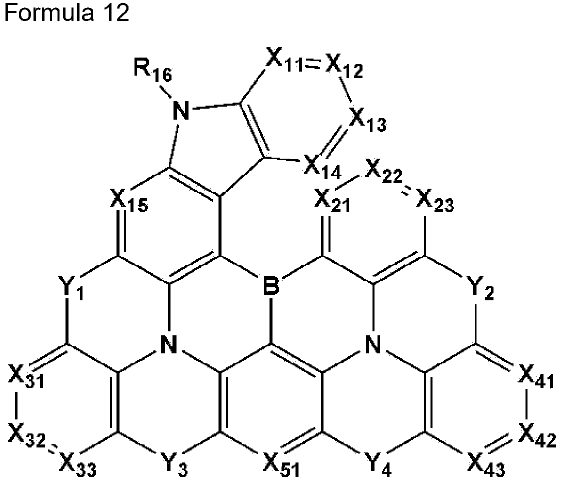 wherein, in Formulae 11 and 12,
Y₁ to Y₄ are as described in claim 1,
X₁₁ is C(R11) or N, X₁₂ is C(R12) or N, X₁₃ is C(R13) or N, X₁₄ is C(R14) or N, and X₁₅ is C(R15) or N,
X₂₁ is C(R21) or N, X₂₂ is C(R22) or N, and X₂₃ is C(R23) or N,
X₃₁ is C(R31) or N, X₃₂ is C(R32) or N, and X₃₃ is C(R33) or N,
X₄₁ is C(R41) or N, X₄₂ is C(R42) or N, and X₄₃ is C(R43) or N,
X₅₁ is C(R51) or N,
R₁₁ to R₁₆ are each independently as described in connection with R₁₀,
R₂₁ to R₂₃ are each independently as described in connection with R₂₀,
R₃₁ to R₃₃ are each independently as described in connection with R₃₀,
R₄₁ to R₄₃ are each independently as described in connection with R₄₀, and
R₅₁ is as described in connection with R₅₀.

6. The heterocyclic compound of any of claims 1-5, wherein
the heterocyclic compound is a heterocyclic compound represented by one of Formulae 21 to 29: 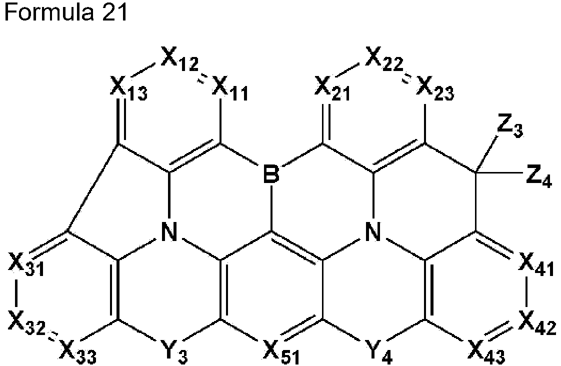 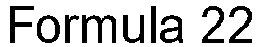 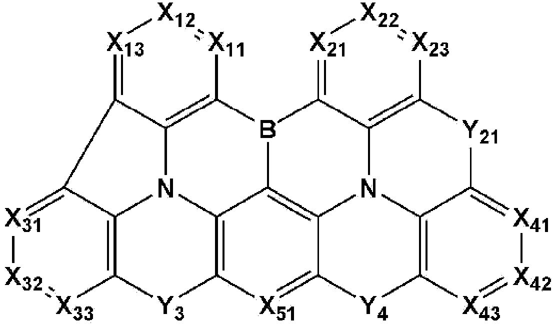 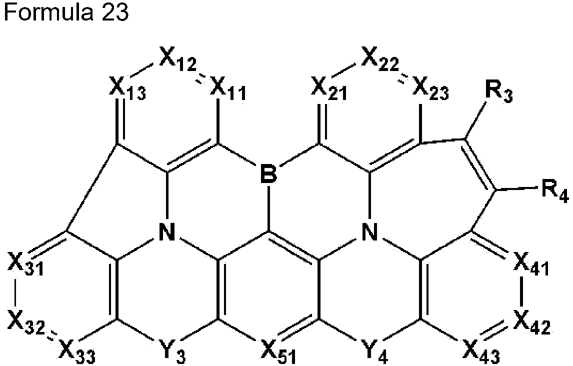 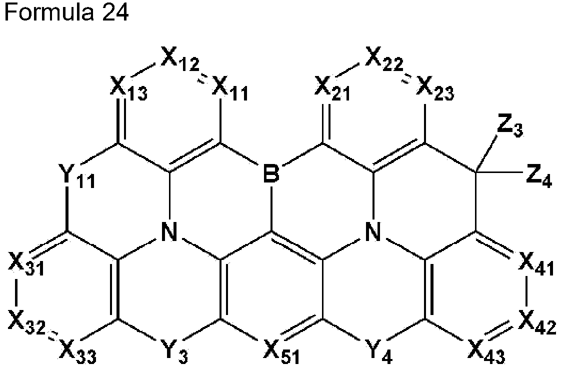 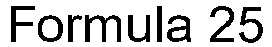 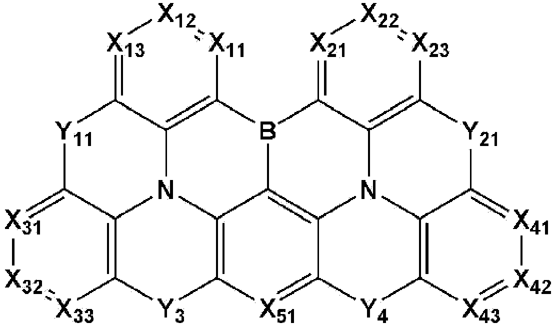 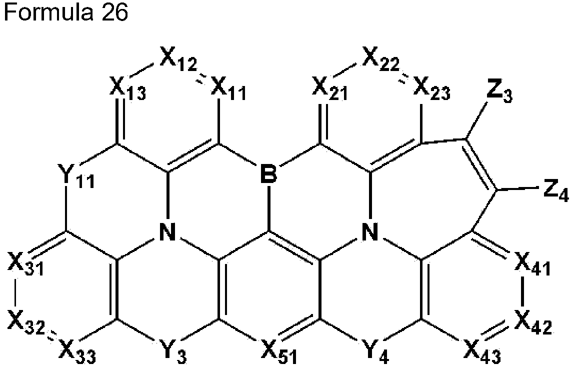 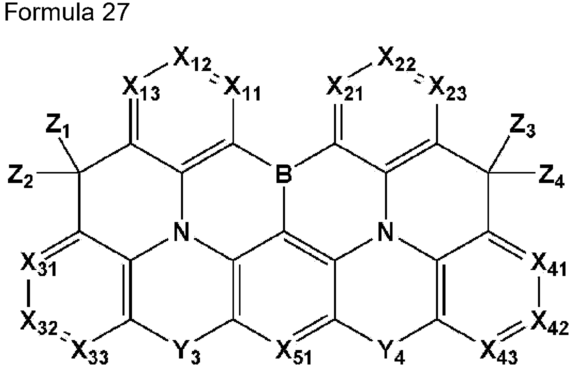 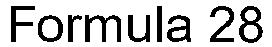 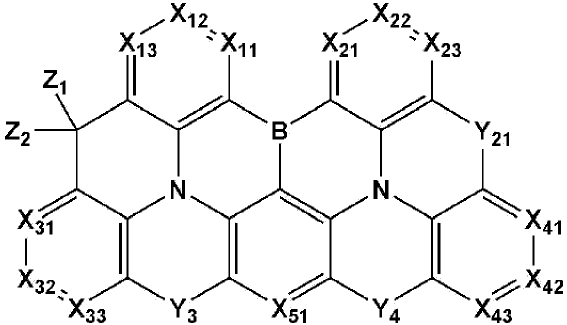 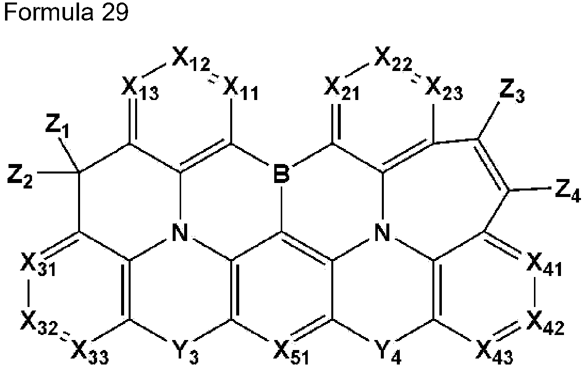 wherein, in Formulae 21 to 29,
Y₃, Y₄, and Z₁ to Z₄ are each as described in claim 1,
Y₁₁ is *-O-*', *-S-*', *-Se-*', *-N(Z₁)-*', *-Si(Z₁)(Z₂)-*', *-Ge(Z₁)(Z₂)-*', or a group represented by Formula 2,
Y₂₁ is *-O-*', *-S-*', *-Se-*', *-N(Z₃)-*', *-Si(Z₃)(Z₄)-*', *-Ge(Z₃)(Z₄)-*', or a group represented by Formula 2,
X₁₁ is C(R11) or N, X₁₂ is C(R12) or N, X₁₃ is C(R13) or N, X₁₄ is C(R14) or N, and X₁₅ is C(R15) or N,
X₂₁ is C(R21) or N, X₂₂ is C(R22) or N, and X₂₃ is C(R23) or N,
X₃₁ is C(R31) or N, X₃₂ is C(R32) or N, and X₃₃ is C(R33) or N,
X₄₁ is C(R41) or N, X₄₂ is C(R42) or N, and X₄₃ is C(R43) or N,
X₅₁ is C(R51) or N,
R₁₁ to R₁₆ are each independently as described in connection with R₁₀,
R₂₁ to R₂₃ are each independently as described in connection with R₂₀,
R₃₁ to R₃₃ are each independently as described in connection with R₃₀,
R₄₁ to R₄₃ are each independently as described in connection with R₄₀, and
R₅₁ is as described in connection with R₅₀.

7. The heterocyclic compound of any of claims 1-6, wherein the heterocyclic compound contains only one boron (B); and/or
wherein the heterocyclic compound has an asymmetric structure.

8. The heterocyclic compound of any of claims 1-7, wherein
the heterocyclic compound is one of compounds 1 to 66:

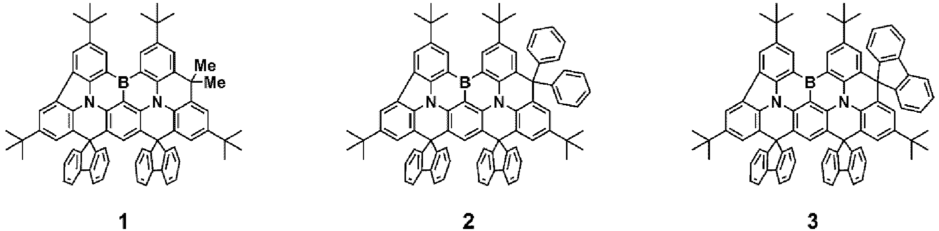

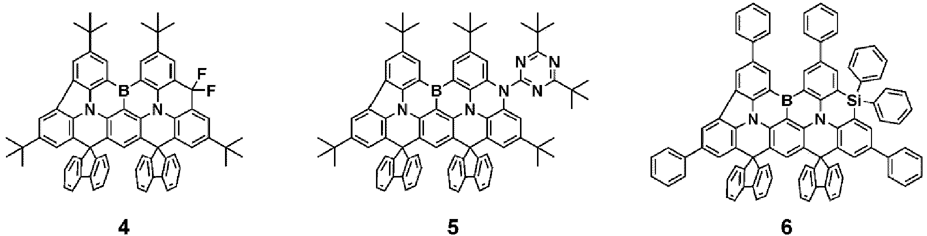

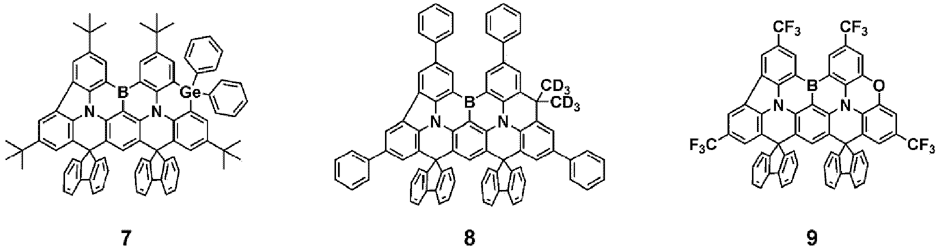

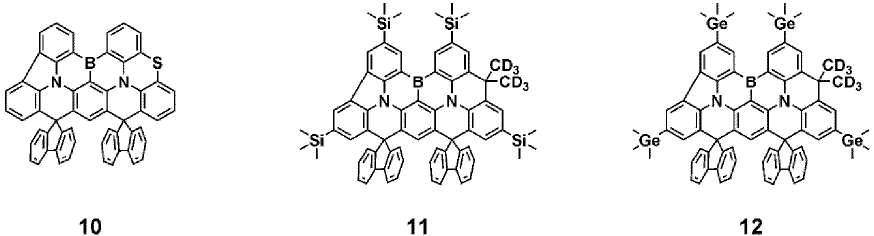

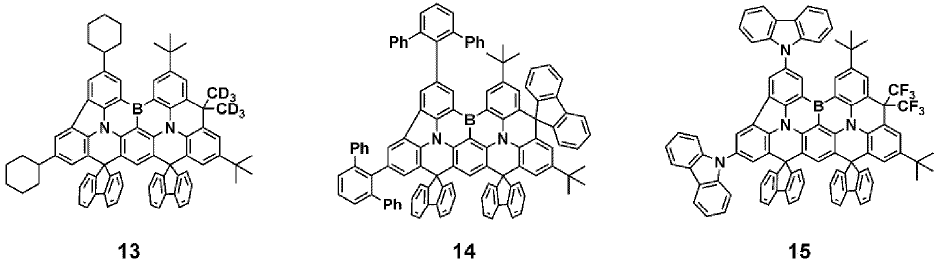

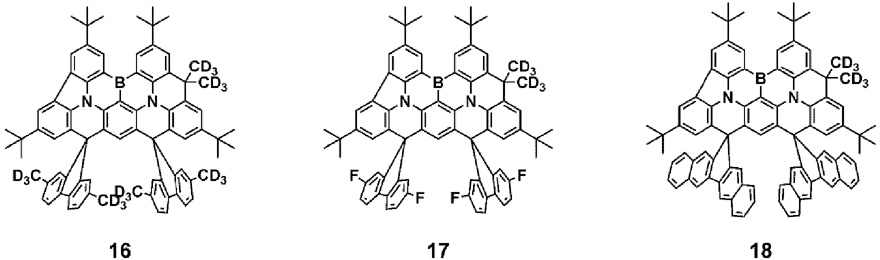

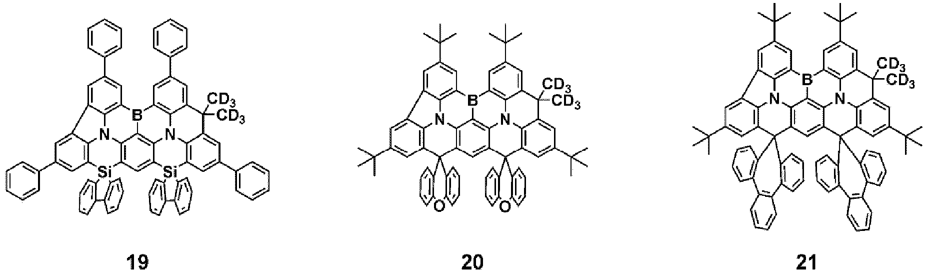

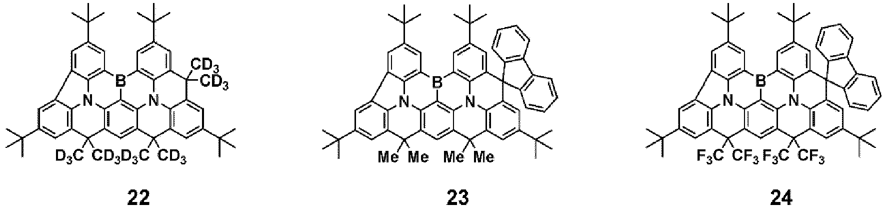

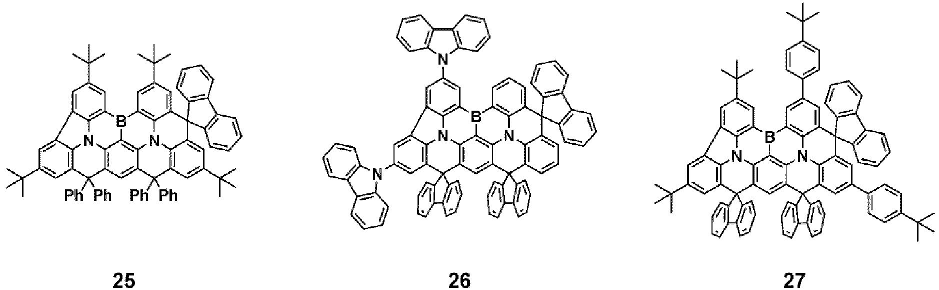

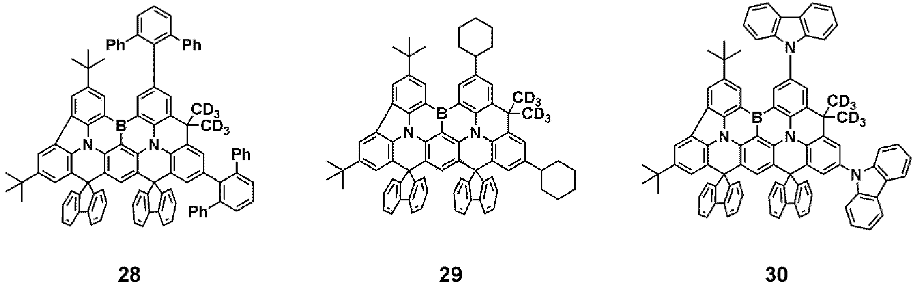

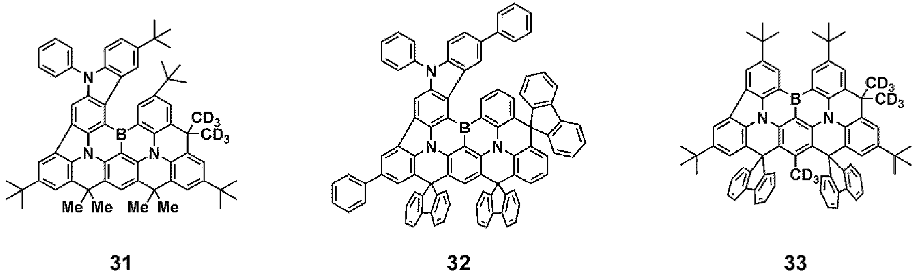

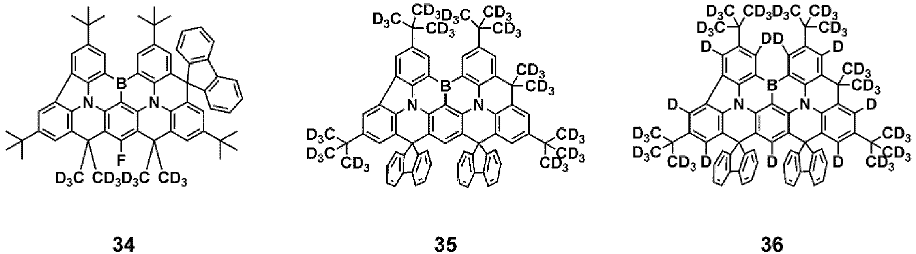

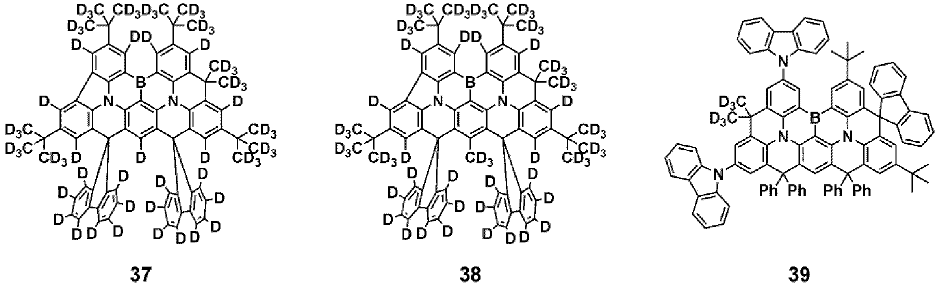

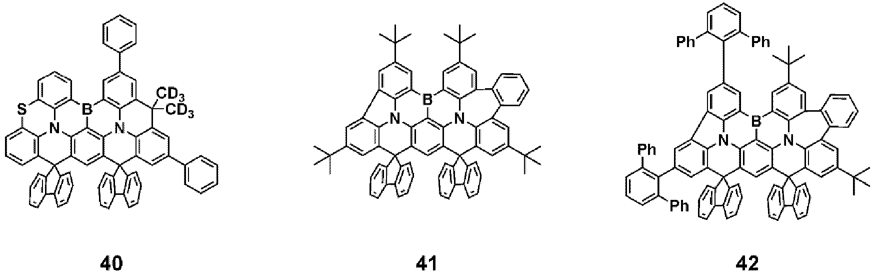

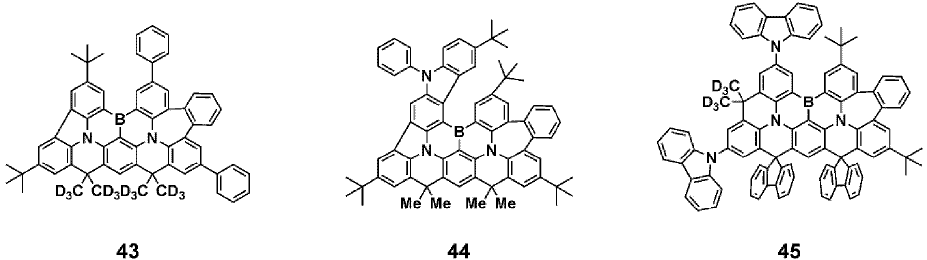

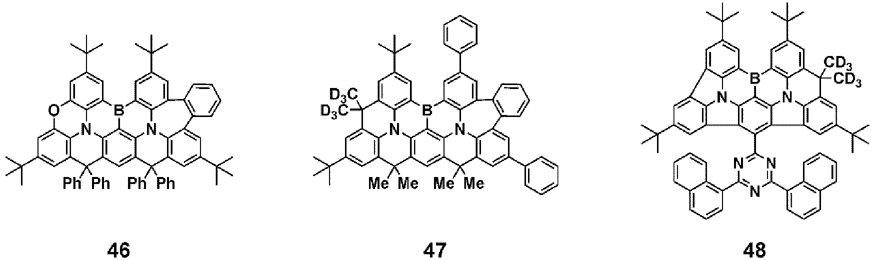

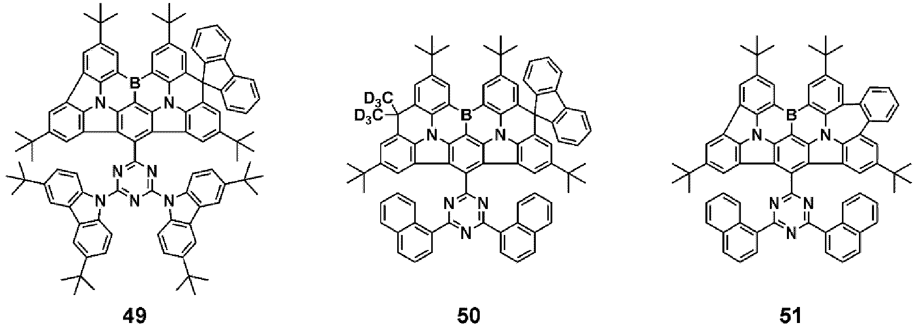

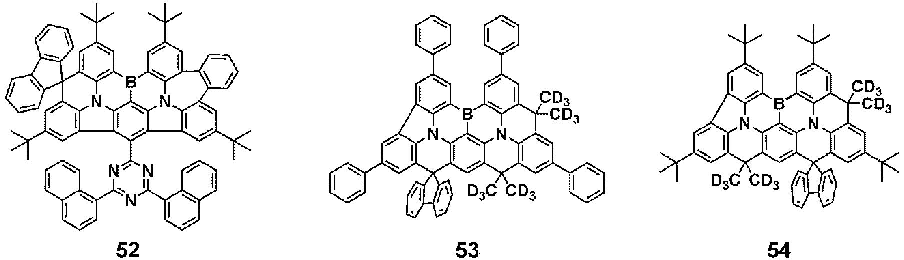

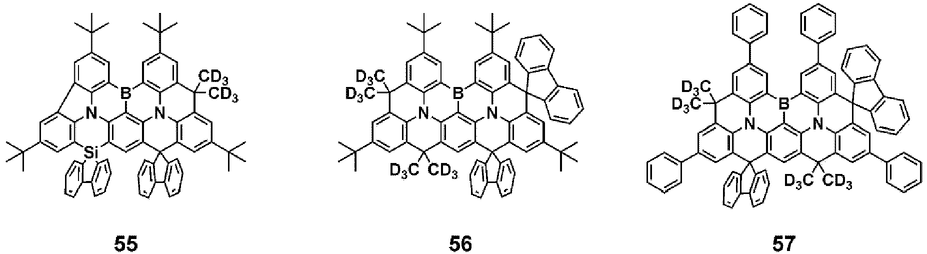

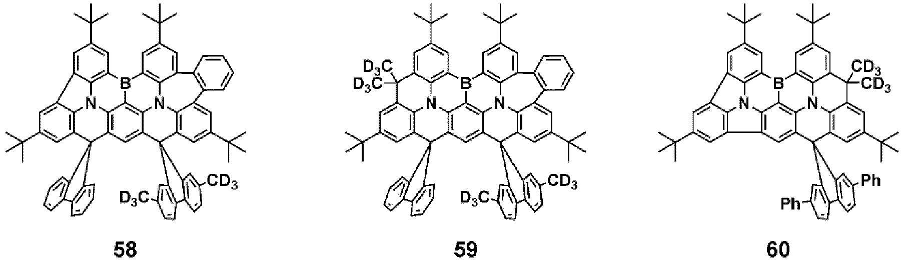

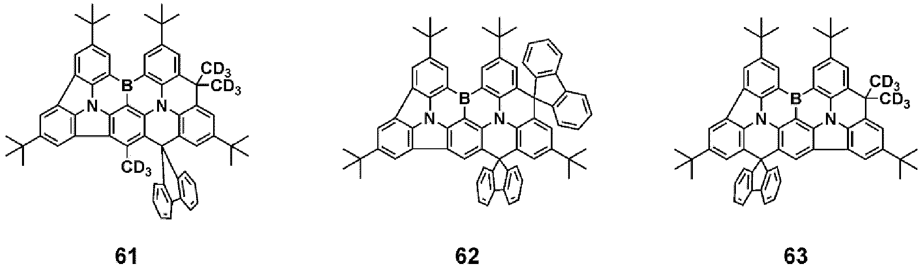

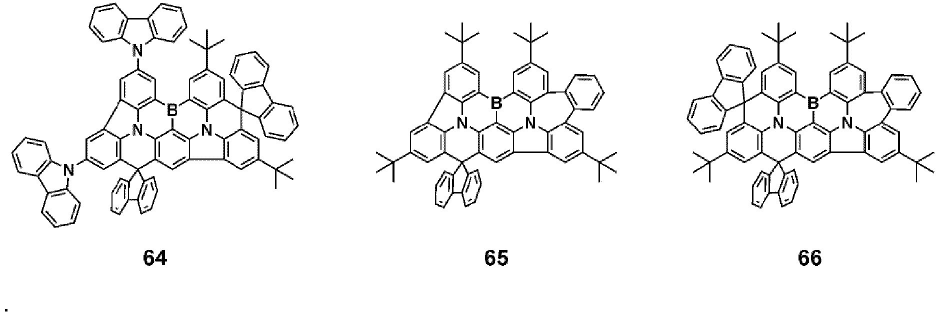

9. An organic light-emitting device, comprising:
a first electrode;
a second electrode, and
an organic layer disposed between the first electrode and the second electrode,
wherein the organic layer comprises an emission layer, and
wherein the organic layer further comprises at least one heterocyclic compound of any of claims 1-8.

10. The organic light-emitting device of claim 9, wherein the emission layer comprises the at least one heterocyclic compound;
preferably wherein the emission layer emits a green light having a maximum emission wavelength of 500 nanometers to 600 nanometers.

11. The organic light-emitting device of claim 10, wherein
the emission layer comprises a host and an emitter, and
the emitter comprises the at least one heterocyclic compound.

12. The organic light-emitting device of claim 11, wherein an amount of the host in the emission layer is greater than an amount of the at least one heterocyclic compound in the emission layer, based on weight; and/or
wherein the emission layer further comprises a sensitizer, preferably wherein the sensitizer comprises a phosphorescent dopant.

13. An electronic apparatus, comprising the organic light-emitting device of any of claims 9-12.
